(19) Europäisches Patentamt
European Patent Office
Office européen des brevets

(11) EP 3 263 355 B1

(12) **EUROPEAN PATENT SPECIFICATION**

(45) Date of publication and mention of the grant of the patent:
**25.03.2020 Bulletin 2020/13**

(21) Application number: **16755401.3**

(22) Date of filing: **22.02.2016**

(51) Int Cl.:
***B41N 1/14*** *(2006.01)* ***G03F 7/00*** *(2006.01)*
***G03F 7/004*** *(2006.01)* ***G03F 7/027*** *(2006.01)*
***G03F 7/11*** *(2006.01)* ***B41N 3/03*** *(2006.01)*
***G03F 7/09*** *(2006.01)* ***B41C 1/10*** *(2006.01)*

(86) International application number:
**PCT/JP2016/055015**

(87) International publication number:
**WO 2016/136655 (01.09.2016 Gazette 2016/35)**

(54) **PLANOGRAPHIC PRINTING PLATE PRECURSOR, PLATE-MAKING METHOD FOR PLANOGRAPHIC PRINTING PLATE, AND PRINTING METHOD**

FLACHDRUCKPLATTENVORLÄUFER, PLATTENHERSTELLUNGSVERFAHREN FÜR EINE FLACHDRUCKPLATTE UND DRUCKVERFAHREN

PRÉCURSEUR DE PLAQUE D'IMPRESSION PLANOGRAPHIQUE, PROCÉDÉ DE FABRICATION DE PLAQUE POUR PLAQUE D'IMPRESSION À PLAT ET PROCÉDÉ D'IMPRESSION

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **27.02.2015 JP 2015039327**

(43) Date of publication of application:
**03.01.2018 Bulletin 2018/01**

(73) Proprietor: **FUJIFILM Corporation**
**Tokyo 106-8620 (JP)**

(72) Inventor: **SAITO Ryo**
**Haibara-gun**
**Shizuoka 421-0396 (JP)**

(74) Representative: **Hoffmann Eitle**
**Patent- und Rechtsanwälte PartmbB**
**Arabellastraße 30**
**81925 München (DE)**

(56) References cited:
**EP-A1- 2 363 748** **EP-A2- 1 256 461**
**JP-A- H0 858 257** **JP-A- H1 152 556**
**JP-A- H1 152 556** **JP-A- H05 104 873**
**JP-A- 2001 290 267** **JP-A- 2002 311 579**
**JP-A- 2002 341 558** **JP-A- 2009 522 609**
**JP-A- 2011 161 872**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).



Printed by Jouve, 75001 PARIS (FR)

## Description

The present invention relates to a planographic printing plate precursor, a plate-making method for a planographic printing plate, and a printing method.

Currently, a planographic printing plate is obtained by a computer-to-plate (CTP) technology. That is, a planographic printing plate precursor is directly scanned, exposed, and developed using a laser or a laser diode without using a lith film, thereby obtaining a planographic printing plate.

Along with this development, objects of a planographic printing plate precursor have been changed to improvement of image-forming characteristics, printing characteristics, and physical properties corresponding to the CTP technology. From the growing interest in the global environment, environmental issues related to a waste liquid associated with wet treatments such as a development treatment have been closed up as a problem of a planographic printing plate precursor.

In regard to the above-described environmental issues, it is desired to simplify a development treatment or a plate-making treatment or not to perform a development treatment. As one of a simple plate-making method, a method referred to as "on-press development" has been suggested. In other words, the on-press development is a method of exposing a planographic printing plate precursor, mounting the planographic printing plate precursor on a printing press without performing wet development using a high alkaline developer of the related art, and then removing an unnecessary portion of an image recording layer, at an initial stage of a typical printing step.

Further, as a method of the simple development, a so-called "gum development" method of removing an unnecessary portion of an image recording layer using a finisher whose pH is close to neutral or a gum development without using a high alkaline developer (hereinafter, also simply referred to as an "alkaline developer") of the related art may be exemplified. Known planographic printing plate precursors of the related art are described in JP2011-177983A and JP2009-522609A.

JP2011-177983A describes a planographic printing plate precursor for printing newspapers which includes a support; a polymer compound containing an infrared absorbing dye, a radical polymerization initiator, a radical polymerizable compound, and a polyoxyalkylene chain in a side chain on the support; and an image recording layer that can be developed on a cylinder of a printing press using printing ink and/or dampening water and which is obtained by treating a region from an end portion of the planographic printing plate precursor to a portion inside the end portion by 1 cm with a liquid containing an organic solvent and a water-soluble resin.

JP2009-522609A describes a radiation sensitive coating film which includes at least one component (a) selected from a photoinitiator and a sensitizer and coinitiator system absorbing radiation having a wavelength of 250 to 1200 nm; and at least one radical polymerizable oligomer A in which triisocyanate (b) can be obtained by reacting at least one acrylic or methacrylic monomer (i) containing two free OH groups and at least one (meth)acryl group and at least one compound (ii) containing one OH group, at least one (meth)acryl group, and at least one poly(alkyleneoxide) chain in a molecule and which has an average molecular weight of 3500 to 9000, measured by GPC, and in which the amount of the (meth)acrylic monomer (i) is 2% to 20% by mole based on the total amount of the (meth)acryl compound containing an OH functional group.

In a case where printing is performed using a planographic printing plate, since the end portions of the printing plate are in positions other than paper at the time of printing on paper having a size smaller than the size of the printing plate such as a typical sheet-fed printing press, the end portions do not affect the print quality. However, in a case where printing is performed on paper having a size larger than the size of the printing plate, the ink adhering to the end portions is transferred to the paper and forms linear stain (hereinafter, also referred to as edge stain) and thus the commodity value of the printed matter is significantly impaired.

As such a method of preventing stain on end portions, JP2011-177983A suggests a method of treating end portions with a desensitizing solution containing a hydrophilic organic polymer compound such as gum Arabic, soy polysaccharides, and phosphoric acids so that ink is unlikely to attach the end portions.

However, according to an aspect described in JP2011-177983A, there is a problem of so-called bleeding of a substance over time, in which a compound in the desensitizing solution or a compound contained in a layer forming the planographic printing plate is transferred to the surface of the plate from the treated end portions over time and then transferred to interleaving paper or another plate so that the interleaving paper or another plate is contaminated.

An object of the present invention is to provide a planographic printing plate precursor which suppresses bleeding or transferring of a substance over time while maintaining edge stain preventing performance, a plate-making method for a planographic printing plate, and a printing method using the planographic printing plate.

The above-described problem of the present invention is solved by means described in the following item <1>, <13>, or <15>. The items <1>, <13>, and <15> and items <2> to <12> and <14> which are preferred aspects are as follows.

<1> A planographic printing plate precursor comprising a support layer and an image recording layer including an infrared absorbing agent, a tetraphenyl borate salt as a radical polymerisation initiator, and a radical polymerizable

compound which includes a urethane bond and two or more ethylenically unsaturated groups and has a weight-average molecular weight of 3000 to 10000;
the planographic printing plate precursor having any one of the following layer arrangements i to iv:

i: an arrangement (mode) in which the support layer and the image recording layer are provided in this order
ii: an arrangement in which the support layer, an undercoat, and the image recording layer are provided in this order
iii: an arrangement in which the support layer, the image recording layer, and a protective layer are provided in this order
iv: an arrangement in which the support layer, the undercoat, the image recording layer, and the protective layer are provided in this order;

the planographic printing plate precursor further comprising a hydrophilization agent layer containing a hydrophilization agent provided in a region between the layers in the layer arrangements i to iv, on a side opposite to a support layer with respect to the image recording layer in the layer arrangement i or ii, or on a side opposite to the support layer with respect to a protective layer in the layer arrangement iii or iv, from the end portion of the planographic printing plate precursor to a portion inside the end portion by 1 cm.
<2> The planographic printing plate precursor according to <1>, in which the layer arrangement including the hydrophilization agent layer is layer arrangement described in any one of the following 1 to 5.

1: an arrangement in which the support layer, the hydrophilization agent layer, the undercoat, and the image recording layer are provided in this order
2: an arrangement in which the support layer, the hydrophilization agent layer, the undercoat, the image recording layer, and the protective layer are provided in this order
3: an arrangement in which the support layer, the undercoat, the image recording layer, and the hydrophilization agent layer are provided in this order
4: an arrangement in which the support layer, the undercoat, the image recording layer, the hydrophilization agent layer, and the protective layer are provided in this order
5: a mode in which the support layer, the undercoat, the image recording layer, the protective layer, and the hydrophilization agent layer are provided in this order

<3> The planographic printing plate precursor according to <1> or <2>, in which the radical polymerizable compound contains an alkyleneoxy group in a molecule.
<4> The planographic printing plate precursor according to any one of <1> to <3>, in which the radical polymerizable compound is a condensate of a triisocyanate compound, at least one compound a containing two hydroxy groups and one or more (meth)acryloyl groups, and a compound b containing one hydroxy group, one or more (meth)acryloyl groups, and one or more poly(alkyleneoxy) groups in a molecule or a condensate of a triisocyanate compound, a compound c which contains one hydroxy group and two or more (meth)acryloyl groups in a molecule and does not contain a poly(alkyleneoxy)group in a molecule, and a compound d which contains one hydroxy group, one (meth)acryloyl group, and one or more alkyleneoxy groups in a molecule and does not contain a poly(alkyleneoxy) group in a molecule.
<5> The planographic printing plate precursor according to any one of <1> to <4>, in which the radical polymerizable compound is a condensate of a triisocyanate compound, a compound c which contains a hydroxy group and two or more (meth)acryloyl groups in a molecule and does not contain a poly(alkyleneoxy) group in a molecule, and a compound d which contains one hydroxy group, one (meth)acryloyl group, and one or more alkyleneoxy groups in a molecule and does not contain a poly(alkyleneoxy) group in a molecule.
<6> The planographic printing plate precursor according to any one of <1> to <5>, in which the hydrophilization agent is a phosphoric acid compound and/or a phosphonic acid compound.
<7> The planographic printing plate precursor according to <6>, in which the phosphoric acid compound and/or the phosphonic acid compound is a polymer compound.
<8> The planographic printing plate precursor according to <6> or <7>, further comprising: an anionic or non-ionic surfactant as the hydrophilization agent.
<9> The planographic printing plate precursor according to <8>, in which the anionic or non-anionic surfactant is a polymer compound.
<10> The planographic printing plate precursor according to any one of <1> to <9>, in which the end portion of the planographic printing plate precursor has a sagging shape in which a sagging amount X is in a range of 20 $\mu$m to 150 $\mu$m.
<11> The planographic printing plate precursor according to any one of <1> to <10>, in which the hydrophilization

agent layer is provided between any of the layers in the layer arrangements i to iv.

<12> The planographic printing plate precursor according to any one of <1> to <11>, in which the hydrophilization agent layer is provided on a side of the support layer with respect to the undercoat or on a side opposite to the support layer with respect to the image recording layer.

<13> A plate-making method for a planographic printing plate comprising: an exposing step of image-exposing the planographic printing plate precursor according to any one of <1> to <12>; and a processing step of removing an unexposed portion of the planographic printing plate precursor.

<14> The plate-making method for a planographic printing plate according to <13>, in which the processing step is performed by on-press development.

<15> A printing method comprising: printing a planographic printing plate obtained by the plate-making method according to <13> or <14> using printing paper having a larger width than that of the planographic printing plate.

According to the present invention, it is possible to provide a planographic printing plate precursor which suppresses bleeding or transferring of a substance over time while maintaining edge stain preventing performance, a plate-making method for a planographic printing plate, and a printing method using the planographic printing plate.

BRIEF DESCRIPTION OF THE DRAWINGS

Fig. 1 is a conceptual view illustrating an example of a planographic printing plate precursor which includes a hydrophilization agent layer (hereinafter, also referred to as a "hydrophilization agent layer") containing a hydrophilization layer in the vicinity of an end portion thereof, before being cut.

Fig. 2 is a conceptual view illustrating an example of a planographic printing plate precursor which includes a hydrophilization agent layer in a position other than an end portion thereof, before being cut.

Fig. 3 is a conceptual view illustrating another example of a planographic printing plate precursor which includes a hydrophilization agent layer in a position other than an end portion thereof, before being cut.

Fig. 4 is a conceptual view illustrating another example of a planographic printing plate precursor which includes a hydrophilization agent layer in a position other than an end portion thereof, before being cut.

Fig. 5 is a conceptual view illustrating another example of a planographic printing plate precursor which includes a hydrophilization agent layer in a position other than an end portion thereof, before being cut.

Fig. 6 is a conceptual view illustrating an example of a planographic printing plate precursor which includes a hydrophilization agent layer in an end portion and in a position other than the end portion thereof, before being cut.

Fig. 7 is a conceptual view illustrating another example of a planographic printing plate precursor which includes a hydrophilization agent layer in an end portion and in a position other than the end portion thereof, before being cut.

Fig. 8 is a conceptual view illustrating another example of a planographic printing plate precursor which includes a hydrophilization agent layer in an end portion and in a position other than the end portion thereof, before being cut.

Fig. 9 is a schematic view illustrating an example of the shape of a cross section of an end portion of a planographic printing plate precursor cut by a cutting device.

Fig. 10 is a conceptual view illustrating an example of a cutting unit of a slitter device.

Hereinafter, the present invention will be described below in detail.

Further, in the present specification, the description of "xx to yy" indicates a range between numerical values including xx and yy as the lower limit and the upper limit.

In the present invention, "% by mass" has the same definition as "% by weight" and "part by mass" has the same definition as "part by weight".

Further, in the present specification, "(meth)acrylate" indicates acrylate and methacrylate, "(meth)acryl" indicates acryl and methacryl, and "(meth)acryloyl indicates acryloyl and methacryloyl.

Further, in the present invention, a combination of preferred embodiments is more preferable.

Hereinafter, a planographic printing plate precursor of the present invention will be described in detail.

(Planographic printing plate precursor)

A planographic printing plate precursor includes a support; and an image recording layer formed on the support layer, in which layer arrangement described in any one of the following i to iv is provided, a hydrophilization agent layer containing a hydrophilization agent is provided in a region, between the layers in the layer arrangements i to iv below, on a side opposite to a support layer with respect to the image recording layer in the layer arrangement i or ii, or on a side opposite to the support layer with respect to a protective layer in the layer arrangement iii or iv, from the end portion of the planographic printing plate precursor to a portion inside the end portion by 1 cm, and the image recording layer includes an infrared absorbing agent and a radical polymerizable compound which includes a urethane bond and two or more ethylenically unsaturated groups and has a weight-average molecular weight of 3000 to 10000.

i: an arrangement (mode) in which the support layer and the image recording layer are provided in this order
ii: a mode in which the support layer, an undercoat, and the image recording layer are provided in this order
iii: a mode in which the support layer, the image recording layer, and a protective layer are provided in this order
iv: a mode in which the support layer, the undercoat, the image recording layer, and the protective layer are provided in this order

It is preferable that the planographic printing plate precursor of the present invention is a planographic printing plate precursor for printing newspapers

Further, the planographic printing plate precursor of the present invention is an on-press development type planographic printing plate precursor.

As a result of intensive research conducted by the present inventor, according to the planographic printing plate precursor of the present invention, it was found that bleeding or transferring of a substance over time is suppressed while maintaining edge stain preventing performance.

The detailed mechanism is not clear, but it is assumed that excellent curability of the radical polymerizable compound can be obtained and movement of the hydrophilization agent and a low-molecular weight compound contained in the layer forming the planographic printing plate in a vertical direction can be suppressed by using the radical polymerizable compound having the weight-average molecular weight of the present invention so that the above-described effects are obtained.

Further, the present inventor found that formation of an image is inhibited in a region treated with a desensitizing agent according to the embodiment described in JP JP2011-177983A, but an image can be formed even in a region, which includes a hydrophilization agent layer containing a hydrophilization agent, from an end portion to a portion inside the end portion by 1 cm and this region has excellent printing durability according to the planographic printing plate precursor of the present invention.

The detailed mechanism is not clear, but it is assumed that the compound associated with radical polymerization is efficiently cured, the cured image portion is rigid, and the movement of the compound associated with polymerization in a horizontal direction is suppressed by using the radical polymerizable compound which contains a urethane bond of the present invention and two or more ethylenically unsaturated groups and this enables image formation in the vicinity of end portions and results in improvement of printing durability.

<Support>

As the support used for the planographic printing plate precursor of the present invention, a hydrophilic aluminum support is preferable. The "hydrophilic aluminum support" means that an aluminum support having a hydrophilic surface. Among the examples of the aluminum support, an aluminum plate which is subjected to a roughening treatment using a known method and then subjected to an anodizing treatment is preferable.

Further, it is preferable that the support used for the planographic printing plate precursor of the present invention is quadrilateral.

Further, the aluminum plate can be used by performing an expanding treatment or a sealing treatment on micropores of an anodized film described in JP2001-253181A or JP2001-322365A or a surface hydrophilization treatment using alkali metal silicate described in the specifications of US2714066A, US3181461A, US3280734A, and US3902734A or polyvinylphosphonic acid described in the specifications of US3276868A, US4153461A, and US4689272A, as appropriate.

It is preferable that the surface of the aluminum support has a center line average roughness of 0.10 to 1.2 μm.

As necessary, a back coat layer containing an organic polymer compound described in JP1993-45885A (JP-H05-45885A) and an alkoxy compound of silicon described in JP1994-35174A (JP-H06-35174A) can be provided on

the rear surface of the support used for the planographic printing plate precursor of the present invention.

<Image recording layer>

The image recording layer used for the planographic printing plate precursor of the present invention is a layer on which an image, in which a hydrophobic region is formed due to infrared exposure and the hydrophobic region becomes an ink receiving unit, is formed.

The image recording layer of the present includes, as indispensable components, an infrared absorbing agent and a radical polymerizable compound (hereinafter, also referred to as a "specific radical polymerizable compound") which includes a urethane bond and two or more ethylenically unsaturated groups and has a weight-average molecular weight of 3000 to 10000.

The details of the components contained in the image recording layer of the present invention will be described below.

<Layer arrangement>

The planographic printing plate precursor of the present invention includes a hydrophilization agent layer containing a hydrophilization agent in a region, between the layers in the layer arrangements i to iv, on a side opposite to a support layer with respect to the image recording layer in the layer arrangement i or ii, or on a side opposite to the support layer with respect to a protective layer in the layer arrangement iii or iv, from the end portion of the planographic printing plate precursor to a portion inside the end portion by 1 cm.

The details of the hydrophilization agent will be described in detail.

From the viewpoint of suppressing bleeding or transferring of a substance over time, it is preferable that the hydrophilization agent layer (hereinafter, also referred to as a "hydrophilization agent layer") containing the hydrophilization agent is provided between any of the layers in the layer arrangements i to iv.

Further, from the viewpoint of the edge stain preventing performance, it is preferable that the hydrophilization agent layer is provided on a side of the support layer with respect to the undercoat or on a side opposite to the support layer with respect to the image recording layer.

It is preferable that the layer arrangement provided with the hydrophilization agent layer of the planographic printing plate precursor of the present invention is layer arrangement described in any one of the following 1 to 5.

1: a mode in which the support layer, the hydrophilization agent layer, the undercoat, and the image recording layer are provided in this order
2: a mode in which the support layer, the hydrophilization agent layer, the undercoat, the image recording layer, and the protective layer are provided in this order
3: a mode in which the support layer, the undercoat, the image recording layer, and the hydrophilization agent layer are provided in this order
4: a mode in which the support layer, the undercoat, the image recording layer, the hydrophilization agent layer, and the protective layer are provided in this order
5: a mode in which the support layer, the undercoat, the image recording layer, the protective layer, and the hydrophilization agent layer are provided in this order

Among the above-described modes, from the viewpoints of the edge stain preventing performance, suppression of bleeding or transferring of a substance over time, and image formation of the hydrophilic agent layer portion, any of the modes 1 to 3 is preferable and the mode 3 is more preferable.

The hydrophilization agent layer is provided in a region from an end portion of the planographic printing plate precursor to a portion inside the end portion by 1 cm and does not need to be provided in the entire region from an end portion of the planographic printing plate precursor to a portion inside the end portion by 1 cm. In a case where the planographic printing plate precursor is quadrilateral, it is preferable that the hydrophilization agent layer is provided in regions respectively from end portions of two facing sides of the planographic printing plate precursor to portions inside the end portions by 1 cm.

Further, it is preferable that the hydrophilization agent is not distributed in a region other than the regions respectively from end portions of two facing sides of the planographic printing plate precursor to portions inside the end portions by 1 cm.

Further, it is preferable that the hydrophilization agent layer is provided in regions respectively from end portions of two facing sides of the planographic printing plate precursor to portions inside the end portions by 0.5 cm and more preferable that the hydrophilization agent layer is provided in regions respectively from end portions of two facing sides to portions inside the end portions by 0.3 cm. The lower limit of the width of the region is not particularly limited, but the

width thereof is preferably 0.1 mm or greater.

Hereinafter, each layer in the layer arrangements will be described.

[Support layer]

The support layer of the present invention is referred to as a layer formed of the support.

[Undercoat]

It is preferable that the planographic printing plate precursor of the present invention includes an undercoat.

As a compound contained in the undercoat layer, a compound containing an adsorptive group which can be adsorbed to the surface of the support layer and a cross-linkable group used to improve the adhesiveness of the image recording layer is preferable. Further, a compound containing a hydrophilicity-imparting group such as a sulfo group is preferable as the compound contained in the undercoat. These compounds may be low-molecular weight polymers or high-molecular weight polymers. Further, these compounds may be used in combination of two or more kinds thereof as necessary.

In a case where these compounds are high-molecular weight polymers, a copolymer of a monomer having an adsorptive group, a monomer having a hydrophilic group, and a monomer having a cross-linkable group is preferable. Preferred examples of the adsorptive group which can be adsorbed to the surface of the support layer include a phenolic hydroxy group, a carboxy group, $-PO_3H_2$, $-OPO_3H_2$, $-CONHSO_2-$, $-SO_2NHSO_2-$, and $-COCH_2COCH_3$. Preferred examples of the hydrophilic group include a sulfo group.

The high-molecular weight polymer may include a cross-linking group introduced by forming salts between a polar substituent of the high-molecular weight polymer and a compound that includes a substituent having the opposite charge and an ethylenic unsaturated bond. Further, monomers other than the monomers described above, preferably hydrophilic monomers may be further copolymerized.

Specifically, a silane coupling agent having an ethylenic double bond reaction group, which can be added and polymerized, described in JP1998-282679A (JP-H10-282679A); and a phosphorous compound having an ethylenic double bond reaction group described in JP1990-304441A (JP-H02-304441A) are preferably exemplified. Preferred examples of undercoats include undercoats containing a low-molecular weight compound or a high-molecular weight compound having a cross-linkable group (preferably an ethylenically unsaturated bond group), a functional group interacting with the surface of the support layer, and a hydrophilic group described in JP2005-238816A, JP2005-125749A, JP2006-239867A, and JP2006-215263A.

More preferred examples thereof include a high-molecular weight polymer having an adsorptive group which can be adsorbed to the surface of the support, a hydrophilic group, and a cross-linkable group described in JP2005-125749A and JP2006-188038A.

The content of the unsaturated double bond in the high-molecular weight polymer for an undercoat is preferably in a range of 0.1 to 10.0 mmol and most preferably in a range of 0.2 to 5.5 mmol with respect to 1 g of the high-molecular weight polymer.

The weight-average molecular weight of the high-molecular weight polymer for an undercoat is preferably 5000 or greater and more preferably in a range of 10000 to 300000.

For the purpose of preventing stain over time, the undercoat of the present invention may contain a chelating agent, a secondary or tertiary amine, a polymerization inhibitor, an amino group, a compound that includes a functional group having polymerization inhibiting ability and a group interacting with the surface of an aluminum support, and the like (for example, 1,4-diazabicyclo[2,2,2]octane (DABCO), 2,3,5,6-tetrahydroxy-p-quinone, chloranil, sulfophthalic acid, hydroxyethyl ethylene diamine triacetic acid, dihydroxyethyl ethylene diamine diacetic acid, or hydroxyethyl imino diacetic acid) in addition to the high-molecular weight polymer for an undercoat layer described above.

The thickness of the undercoat of the planographic printing plate precursor used in the present invention is preferably in a range of 0.1 nm to 100 nm and more preferably in a range of 1 nm to 30 nm.

The thickness of each layer such as the undercoat, the image recording layer, the protective layer, or the hydrophilization agent layer of the planographic printing plate precursor used in the present invention can be measured by observing the cross section of the planographic printing plate precursor with a scanning electron microscope (SEM) by means of using each layer as it is, washing each layer with water and removing the layer using a solvent, or selectively removing layers through ablation.

[Image recording layer]

The image recording layer used in the present invention is a layer on which an image, in which a hydrophobic region is formed due to infrared exposure and the hydrophobic region becomes an ink receiving unit, is formed.

The image recording layer of the present invention contains an infrared absorbing agent and a specific radical polymerizable compound as indispensable components; and a polymerization initiator, other polymerizable compounds, and other components as optional components.

- Infrared absorbing agent -

The image recording layer used in the present invention contains an infrared absorbing agent. The infrared absorbing agent has a function of converting absorbed infrared rays into heat and/or a function of electron transfer to a polymerization initiator described below through excitation by infrared rays and/or a function of energy transfer. The infrared absorbing agent used in the present invention is a dye having a maximum absorption at a wavelength of 760 to 1200 nm.

As the infrared absorbing agent, commercially available dyes and known dyes described in the literatures such as "Dye Handbook" (edited by The Society of Synthetic Organic Chemistry, Japan, published in 1970) can be used. Specific examples thereof include an azo dye, a metal complex salt azo dye, a pyrazolone azo dye, a naphthoquinone dye, an anthraquinone dye, a phthalocyanine dye, a carbonium dye, a quinone imine dye, a methine dye, a cyanine dye, a squarylium dye, a pyrylium salt, and a metal thiolate complex.

Among the above-described dyes, a cyanine dye, a squarylium dye, a pyrylium salt, a nickel thiolate complex, and an indolenine cyanine dye are particularly preferable. Further, a cyanine dye or an indolenine cyanine dye is preferable and a cyanine dye represented by Formula (a) is exemplified as a particularly preferred example.

Formula (a)

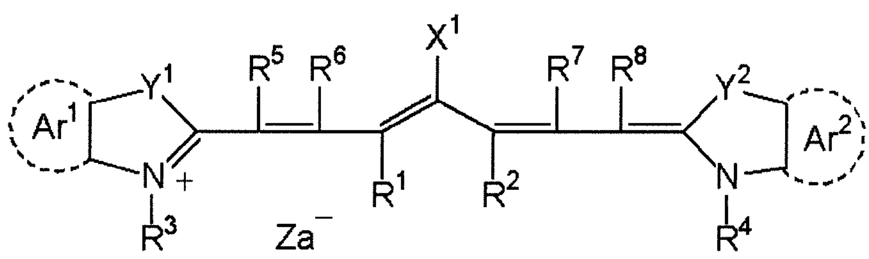

In Formula (a), $X^1$ represents a hydrogen atom, a halogen atom, $-N(R^9)(R^{10})$, $X^2$-$L^1$, or a group shown below. Here, $R^9$ and $R^{10}$ may be the same as or different from each other and represent an aryl group which may have a substituent and has 6 to 10 carbon atoms, an alkyl group having 1 to 8 carbon atoms, or a hydrogen atom. Further, $R^9$ and $R^{10}$ may be bonded to each other to form a ring. Among these, a phenyl group ($-NPh_2$) is preferable. $X^2$ represents an oxygen atom or a sulfur atom. $L^1$ represents a hydrocarbon group having 1 to 12 carbon atoms, a heteroaryl group, or a hydrocarbon group which has heteroatoms and 1 to 12 carbon atoms. Moreover, the heteroatoms here represent N, S, O, a halogen atom, and Se. In groups shown below, $Xa^-$ has the same definition as that for $Za^-$ described below and $R^a$ represents a substituent selected from a hydrogen atom, an alkyl group, an aryl group, a substituted or unsubstituted amino group, and a halogen atom.

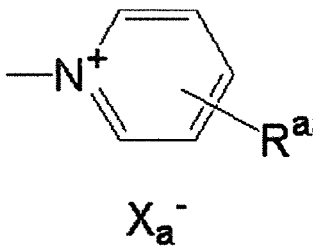

$X_a^-$

$R^1$ and $R^2$ each independently represent a hydrocarbon group having 1 to 12 carbon atoms. From the viewpoint of preservation stability of an image recording layer coating solution, it is preferable that $R^1$ and $R^2$ represent a hydrocarbon group having two or more carbon atoms. $R^1$ and $R^2$ may be bonded to each other to form a ring. Further, when a ring is formed, it is particularly preferable that a 5- or 6-membered ring is formed.

$Ar^1$ and $Ar^2$ may be the same as or different from each other and each represent an aryl group which may have a substituent. Preferred examples of the aryl group include a benzene ring and a naphthalene ring. In addition, preferred examples of a substituent include a hydrocarbon group having 12 or less carbon atoms, a halogen atom, and an alkoxy group having 12 or less carbon atoms. $Y^1$ and $Y^2$ may be the same as or different from each other and each represent

a sulfur atom or a dialkylmethylene group having 12 or less carbon atoms. $R^3$ and $R^4$ may be the same as or different from each other and each represent a hydrocarbon group having 20 or less carbon atoms which may have a substituent. Preferred examples of a substituent include an alkoxy group having 12 or less carbon atoms, a carboxy group, and a sulfo group. $R^5$, $R^6$, $R^7$, and $R^8$ may be the same as or different from each other and each represent a hydrogen atom or a hydrocarbon group having 12 or less carbon atoms. From the viewpoint of availability of a raw material, it is preferable that $R^5$, $R^6$, $R^7$, and $R^8$ represent a hydrogen atom. In addition, $Za^-$ represents a counter anion. Here, the cyanine dye represented by Formula (a) has an anionic substituent in the structure thereof, and $Za^-$ is not necessary in a case where neutralization of the charge is not necessary. From the viewpoint of preservation stability of an image recording layer coating solution, it is preferable that $Za^-$ represents a halide ion, a perchlorate ion, a tetrafluoroborate ion, a hexafluorophosphate ion, or a sulfonate ion and particularly preferable that $Za^-$ represents a perchlorate ion, a hexafluorophosphate ion, or an arylsulfonate ion.

Specific examples of the cyanine dye which can be preferably used and is represented by Formula (a) include compounds described in paragraphs 0017 to 0019 of JP2001-133969A and compounds described in paragraphs 0016 to 0021 of JP2002-023360A and paragraphs 0012 to 0037 of JP2002-040638A. Preferred examples thereof include compounds described in paragraphs 0034 to 0041 of JP2002-278057A and paragraphs 0080 to 0086 of JP2008-195018A and most preferred examples thereof include compounds described in paragraphs 0035 to 0043 of JP2007-90850A.

Further, compounds described in paragraphs 0008 and 0009 of JP1993-5005A (JP-H05-5005A) and compounds described in paragraphs 0022 to 0025 of JP2001-222101A can be preferably used.

Further, these infrared absorbing agents may be used alone or in combination of two or more kinds thereof, and infrared absorbing agents other than the infrared absorbing agents such as pigments may be used together. As the pigments, compounds described in paragraphs 0072 to 0076 of JP2008-195018A are preferable.

The content of the infrared absorbing agent in the image recording layer of the present invention is preferably in a range of 0.1 to 10.0% by mass and more preferably in a range of 0.5 to 5.0% by mass based on the total solid content of the image recording layer.

- Specific radical polymerizable compound -

The image recording layer used in the present invention contains a radical polymerizable compound which includes a urethane bond and two or more ethylenically unsaturated groups and has a weight-average molecular weight of 3000 to 10000.

When the weight-average molecular weight is 3000 or greater, bleeding or transferring of a substance over time is suppressed. When the weight-average molecular weight is 10000 or less, a planographic printing plate precursor with excellent edge stain preventing performance can be obtained. From the viewpoints of suppression of bleeding or transferring of a substance over time, edge stain preventing effects, image formation of an edge portion, and printing durability of an image, the weight-average molecular weight is more preferably in a range of 4000 to 9000 and particularly preferably in a range of 4000 to 8000. When the weight-average molecular weight is less than 3000, bleeding or transferring of a substance over time is significant and image formation of an edge portion is degraded. When the weight-average molecular weight is greater than 10000, on-press development of an edge portion or removing of stain is delayed in some cases.

In the present invention, the weight-average molecular weight (Mw) of polymer compounds such as a specific radical polymerizable compound is a weight-average molecular weight in terms of polystyrene obtained by performing measurement using gel permeation chromatography (GPC) in a case where tetrahydrofuran (THF) is used as a solvent.

It is preferable that the specific radical polymerizable compound contains an alkyleneoxy group or a poly(alkyleneoxy) group in a molecule, and an alkyleneoxy group is more preferable.

As the alkyleneoxy group, the number of carbon atoms of an alkylene group contained in the alkyleneoxy group is preferably in a range of 1 to 10. Further, in a case where the specific radical polymerizable compound is used in a planographic printing plate precursor including an image recording layer which can be developed on a cylinder of a printing press by printing ink and/or dampening water, the number of carbon atoms of the alkylene group is preferably in a range of 1 to 5 from the viewpoints of developability on the printing press, edge stain properties, and image formation of an edge portion, more preferably in a range of 1 to 3 from the viewpoint of image formation of an edge portion, and particularly preferably 2 from the viewpoint of image printing durability of an edge portion.

Further, as a structure having the alkyleneoxy group, the specific radical polymerizable compound used in the present invention contains preferably a (meth)acryloyloxyalkyl group and more preferably a (meth)acryloyloxyethyl group.

As the poly(alkyleneoxy) group, a poly(alkyleneoxy) group having 1 to 10 carbon atoms in a repeating unit is preferable, a poly(alkyleneoxy) group having 1 to 5 carbon atoms in a repeating unit is more preferable, a poly(alkyleneoxy) group having 1 to 3 carbon atoms in a repeating unit is still more preferable, and a poly(alkyleneoxy) group having 3 carbon atoms in a repeating unit is particularly preferable.

Particularly, in a case where the specific radical polymerizable compound is used for wet development using

the above-described high alkaline developer or simple development, a poly(ethyleneoxy) group or a poly(propyleneoxy) group is more preferable and a poly(propyleneoxy) group is more preferable.

The molecular weight of the poly(alkyleneoxy) group can be set as appropriate in order to adjust the molecular weight of the specific radical polymerizable compound, but is preferably in a range of 500 to 7000 and more preferably in a range of 1000 to 3000.

As the specific radical polymerizable compound used in the present invention, a compound represented by Formula S-1 is preferable.

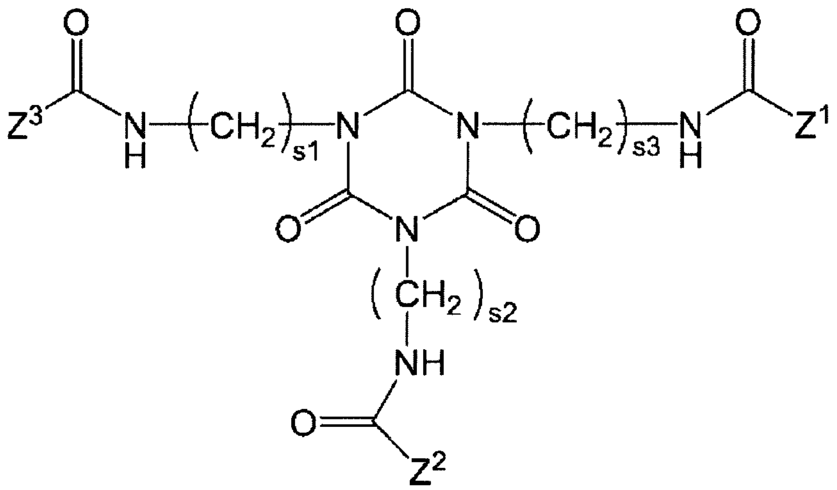

(S-1)

In Formula S-1, s1 to s3 each independently represent an integer of 1 to 10 and $Z^1$ to $Z^3$ each independently represent a monovalent group containing a (meth)acryloyl group.

In Formula S-1, it is preferable that s1 to s3 each independently represent an integer of 2 to 8 and more preferable that all of s1 to s3 represent 6.

It is preferable that $Z^1$ to $Z^3$ each independently contain a group represented by Formula S-2 or S-3.

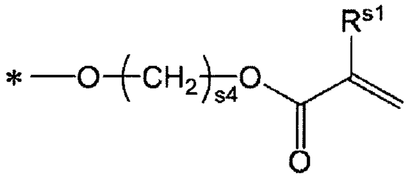

(S-2)

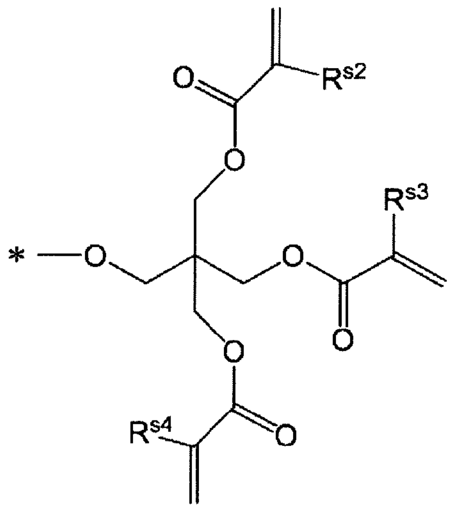

(S-3)

In Formulae S-2 and S-3, s4 represents an integer of 1 to 10, $R^{s1}$ to $R^{s4}$ each independently represents a hydrogen atom or a methyl group, and the symbol "*" represents a binding site with respect to a structure obtained by removing $Z^1$ to $Z^3$ from Formula S-1.

In Formulae S-2 and S-3, s4 represents preferably an integer of 1 to 5, more preferably an integer of 1 to 3, and still more preferably 2. It is preferable that all of $R^{s1}$ to $R^{s4}$ represent a hydrogen atom.

The molar ratio between the group represented by Formula S-2 and the group represented by formula S-3 in the compound represented by Formula S-1 is preferably in a range of 1:2 to 2:1.

Further, the total molar amount of the group represented by Formula S-2 and the group represented by Formula S-3 with respect to one mol of the compound represented by Formula S-1 is preferably in a range of 2 to 3 mol and more preferably in a range of 2.5 to 3 mol.

Further, it is preferable that the specific radical polymerizable compound is a condensate of a polyisocyanate compound and an alcohol compound containing an ethylenically unsaturated group.

A terminal isocyanate group of the condensate may be blocked by a known terminal blocking agent such as monoamine or monoalcohol.

The polyisocyanate compound is not particularly limited as long as the compound contains two or more isocyanate groups, and a triisocyanate compound is preferably exemplified.

Preferred examples of the alcohol compound containing an ethylenically unsaturated group include compounds corresponding to the following items a to e.

a: At least one compound which contains two hydroxy groups and one or more (meth)acryloyl groups
b: A compound which contains one hydroxy group, one or more (meth)acryloyl group, and one or more poly(alkyleneoxy) groups in a molecule
c: A compound which contains one hydroxy group and two or more (meth)acryloyl groups in a molecule and does not contain a poly(alkyleneoxy) group in a molecule
d: A compound which contains one hydroxy group, one (meth)acryloyl group, and one or more alkyleneoxy groups in a molecule and does not contain a poly(alkyleneoxy) group in a molecule
e: Other compounds

The compounds corresponding to the items a to e described above are respectively referred to as compounds a to e.

As the specific radical polymerizable compound, a condensate of a triisocyanate compound, the compound a, and the compound b (hereinafter, also simply referred to as a "condensate") or a condensate of a triisocyanate compound, the compound c, and the compound d is preferable and a condensate of a triisocyanate compound, the compound c, and the compound d is more preferable.

The condensate of a triisocyanate compound, the compound c, and the compound d may have a structure derived from other compounds in the structure thereof, and it is preferable that the condensate has 90% by mass or greater of a structure derived from a triisocyanate compound, the compound a, and the compound b and more preferable that the condensate has 95% by mass or greater of the structure.

As the isocyanate compound, the compound a, and the compound d used for the condensate of the triisocyanate compound, the compound a, and the compound d, each of the following compounds can be used without particular limitation, but a compound represented by Formula II or a condensate of pentaerythritol triacrylate and hydroxyethyl acrylate is preferable.

As the condensate of a triisocyanate compound, the compound a, and the compound b, a condensate of a triisocyanate compound, the compound a, the compound b, and the compound c is more preferable.

The condensate of a triisocyanate compound, the compound a, and the compound b may have a structure derived from other compounds in the structure thereof, and it is preferable that the condensate has 90% by mass or greater of a structure derived from a triisocyanate compound, the compound a, and the compound b and more preferable that the condensate has 95% by mass or greater of the structure.

From the viewpoints of curability and stability, as the (meth)acryloyl group, a (meth)acryloyloxy group is preferable and a methacryloyloxy group is preferable.

Hereinafter, the isocyanate compound and the compounds a to e will be described.

Triisocyanate compound

As the triisocyanate compound used in the present invention, a compound represented by any of Formula I, II, and III-1 to III-7 is preferable.

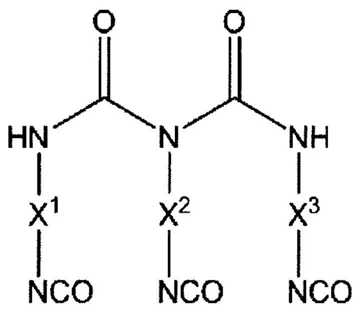

( I )

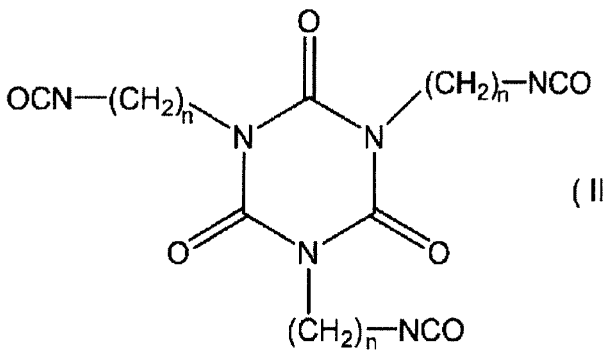

( II )

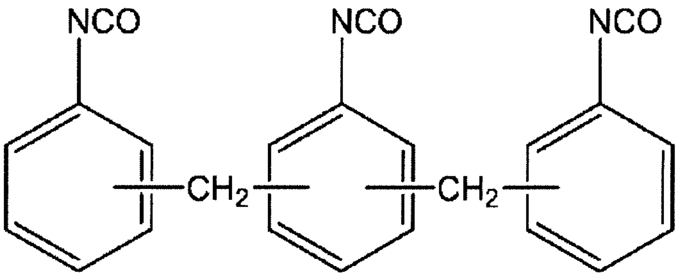

( III-1 )

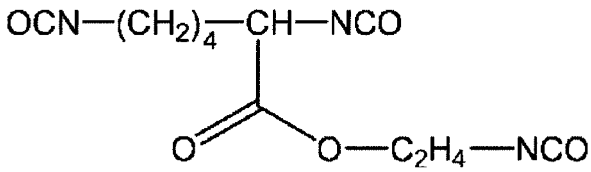

( III-2 )

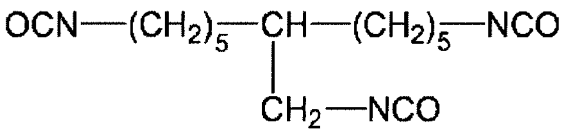

( III-3 )

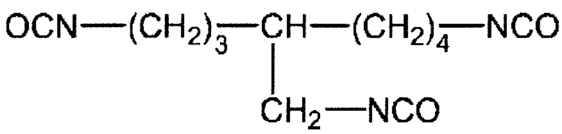

( III-4 )

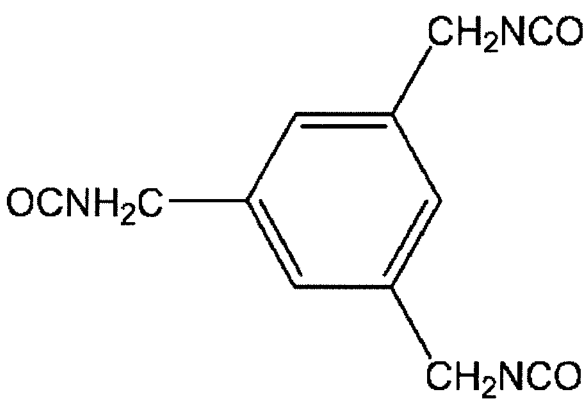

( III-5 )

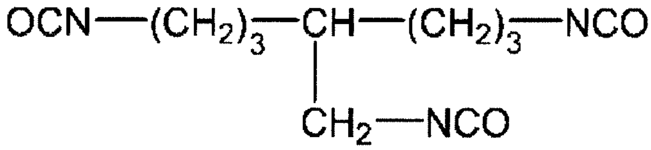

( III-6 )

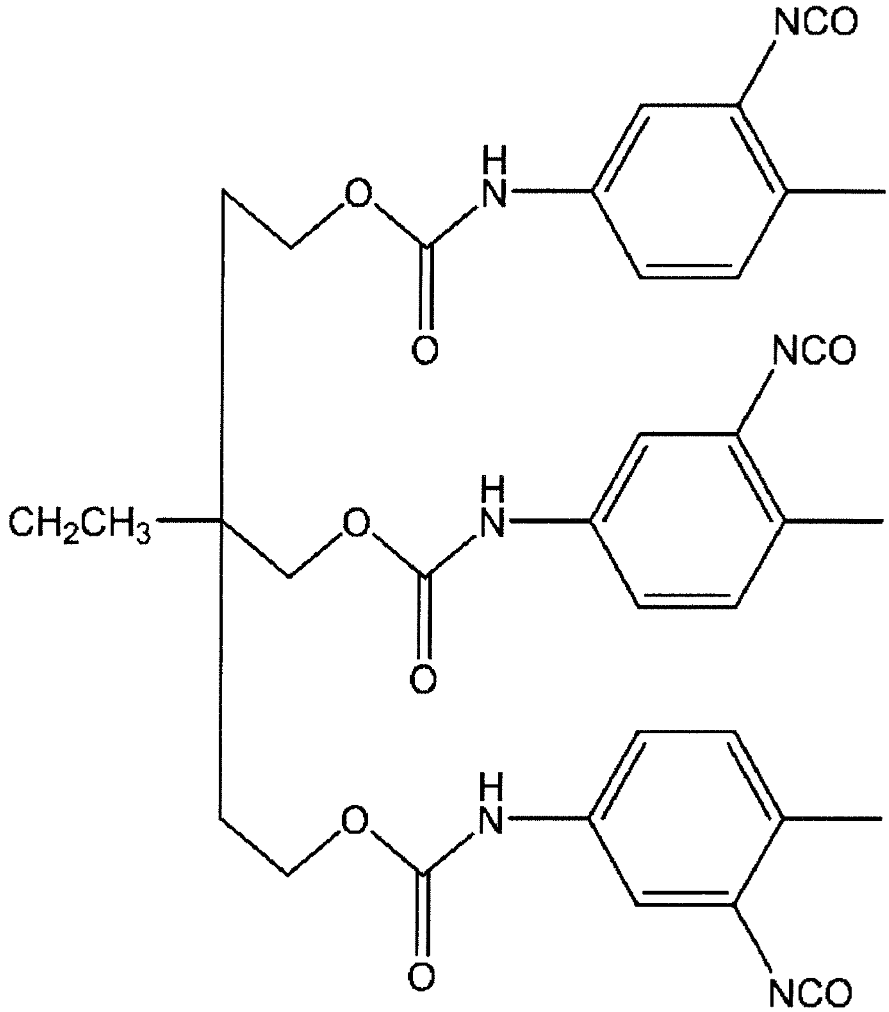

( III-7 )

In Formula I, $X^1$, $X^2$, and $X^3$ each independently represent a divalent group represented by a combination of a divalent aliphatic group or a divalent cyclic aliphatic group having 4 to 12 carbon atoms, an aromatic group having 6 to 10 carbon atoms, or an arylene group and an aliphatic group having 8 to 12 carbon atoms, and a divalent aliphatic group or a divalent cyclic aliphatic group having 4 to 12 carbon atoms is preferable. An alkylene group is preferable as the aliphatic group, a cycloalkylene group is preferable as the cyclic aliphatic group, and an arylene group is preferable as the aromatic group.

It is preferable that $X^1$, $X^2$, and $X^3$ each independently represent the same group and all of $X^1$, $X^2$, and $X^3$ represent hexamethylene.

In Formula II, n's each independently represent an integer of 1 to 10, preferably an integer of 2 to 8, and more preferably 6. Further, it is preferable that all n's represent the same integer.

Further, in Formulae I, II, and III-1 to III-7, NCO represents an isocyanate group.

The basic biuret structure of the triisocyanate compound represented by Formula I can be prepared by reacting a diisocyanate compound represented by Formula 1-1 and a suitably selected amount of water and can be typically prepared by reacting 3 mol of diisocyanate and 1 mol of water (for example, see the specification of GE Patent No. 1101394 and Houben-Weyl, Methoden der organischen Chemie (method in organic chemistry), 4th edition

(1963), Vol. 14/2, pp. 69 and the next pages). The reaction is performed preferably without a solvent.

O=C=N-X-N=C=O (I-1)

In the formula shown above, X has the same definition as that for $X^1$, $X^2$, and $X^3$ and preferable ranges thereof are the same as the preferable ranges of $X^1$, $X^2$, and $X^3$.

As the triisocyanate compound represented by Formula I, commercially available products (manufactured by Bayer AG) can be used.

The triisocyanate compound represented by Formula II can be synthesized according to a known method and commercially available products (manufactured by Bayer AG) can be used.

The triisocyanate compound represented by any of Formulae III-1 to III-7 can be synthesized according to a known method and commercially available products can be used.

Among the compounds represented by Formulae I, II, and III-1 to III-7, the compound represented by Formula II is preferable as the triisocyanate compound used in the present invention.

a: At least one compound containing two hydroxy group and one or more (meth)acryloyl groups

As the at least one compound containing two hydroxy group and one or more (meth)acryloyl groups, partial ester of polyhydric alcohol containing three or more hydroxy groups and acrylic acid or methacrylic acid is preferably used.

Examples of the compound that is preferably used as the compound a include pentaerythritol di(meth)acrylate, dipentaerythritol tetra(meth)acrylate, glycerin mono(meth)acrylate, trimethylolpropane mono(meth)acrylate, trimethyloylethane mono(meth)acrylate, trimethylolbutane mono(meth)acrylate, sorbitol tetra(meth)acrylate, and a reaction product between bisphenol A-diglycidyl ether and (meth)acrylic acid.

The compound a may be used alone or in combination of two or more kinds thereof.

The total content of the compound a used in the present invention is preferably in a range of 10% to 60% by mole and more preferably in a range of 20% to 50% by mole with respect to the total content of the triisocyanate compound.

b: A compound containing one hydroxy group, one or more (meth)acryloyl groups, and one or more poly(alkyleneoxy) groups in a molecule

As the compound containing one hydroxy group, one or more (meth)acryloyl groups, and one or more poly(alkyleneoxy) groups in a molecule, partial ester of polyhydric alcohol containing two or more hydroxy groups and acrylic acid or methacrylic acid is preferably used. It is preferable that the poly(alkyleneoxy) group is contained in polyhydric alcohol.

As the alkylene group in the poly(alkyleneoxy) group, an alkylene group having 2 to 8 carbon atoms is preferable. The alkylene group may be linear or branched and a polyethyleneoxy group or a polypropyleneoxy group is preferable as the alkylene group.

The number of repetitions of the alkyleneoxy group in the poly(alkyleneoxy) group is preferably 3 or greater and more preferably 20 or less.

Examples of the compound preferably used as the compound b include poly(ethyleneglycol) mono(meth)acrylate, poly(propyleneglycol) mono(methyacrylate), a random copolymer or a block copolymer between propylene oxide and ethylene oxide esterified by (meth)acrylic acid at one terminal, and a ethoxylated and/or propoxylated glycerin which is double-esterified by (meth)acrylic acid.

The compound b may be used alone or in combination of two or more kinds thereof.

The total content of the compound b used in the present invention is preferably in a range of 50% to 200% by mole and more preferably in a range of 80% to 150% by mole with respect to the total content of the triisocyanate compound.

c: A compound which contains one hydroxy group and two or more (meth)acryloyl groups in a molecule and does not contain a poly(alkyleneoxy) group in a molecule

The compound which contains one hydroxy group and two or more (meth)acryloyl groups in a molecule and does not contain a poly(alkyleneoxy) group in a molecule may be condensed for the condensate used in the present invention.

As the compound c, partial ester of polyhydric alcohol containing three or more hydroxy groups free from a poly(alkyleneoxy) group and acrylic acid or methacrylic acid is preferably used.

Examples of the compound that is preferably used as the compound c include pentaerythritol tri(meth)acrylate, dipentaerythritol penta(meth)acrylate, glycerin di(meth)acrylate, trimethylolpropane di(meth)acrylate, trimethyloylethane di(meth)acrylate, trimethylolbutane di(meth)acrylate, and sorbitol penta(meth)acrylate.

The compound c may be used alone or in combination of two or more kinds thereof.

The total content of the compound c used in the present invention is preferably in a range of 50% to 200% by

mole and more preferably in a range of 100% to 180% by mole with respect to the total content of the triisocyanate compound.

d: A compound which contains one hydroxy group, one (meth)acryloyl group, and one or more alkyleneoxy groups in a molecule and does not contain a poly(alkyleneoxy) group in a molecule

It is preferable that the compound d which contains one hydroxy group, one (meth)acryloyl group, and one or more alkyleneoxy groups in a molecule and does not contain a poly(alkyleneoxy) group in a molecule is condensed for the condensate used in the present invention.
As the compound d, partial ester of polyhydric alcohol containing two hydroxy groups and acrylic acid or methacrylic acid is exemplified and partial ester of acrylic acid or methacrylic acid is preferable.
As the compound d, 2-hydroxyethyl (meth)acrylate is preferably exemplified.
The total content of the compound d used in the present invention is preferably in a range of 30% to 300% by mole and more preferably in a range of 50% to 300% by mole with respect to the total content of the triisocyanate compound.

e: Other compounds

Other compounds e may be condensed for the condensate used in the present invention.
As the compound e, a compound containing a hydroxy group and an amino group may be used.
Examples of the compound e include 2-(2-hydroxyethyl)piperidine.
The compound e may be used alone or in combination of two or more kinds thereof.
The total content of the compound 3 used in the present invention is preferably in a range of 30% to 300% by mole and more preferably in a range of 50% to 300% by mole with respect to the total content of the triisocyanate compound.

- Polymerization initiator -

The image recording layer used in the present invention contains a tetraphenyl borate salt as a radical polymerization initiator.
The radical polymerization initiator generates a radical using light, heat, or energy of light and heat and initiating and promoting polymerization of a radical polymerizable compound.
A tetraphenyl borate salt is used from the viewpoints of compatibility of printing durability, tone reproducibility and temporal stability. Examples of a counter cation of the borate salt include known cations such as an alkali metal cation, an alkaline earth metal cation, an ammonium cation, a phosphonium cation, a sulfonium cation, an iodonium cation, a diazonium cation, and an azinium cation.
The content of the radical polymerization initiator is preferably in a range of 0.1% to 50% by mass, more preferably in a range of 0.5% to 30% by mass, and particularly preferably in a range of 0.8% to 20% by mass with respect to the total solid content constituting the image recording layer. When the content thereof is in the above-described range, improved sensitivity and improved stain resistance of a non-image portion at the time of printing are obtained.

<Other radical polymerizable compound>

The image recording layer used in the present invention may contain radical polymerizable compounds other than the specific radical polymerizable compound. The radical polymerizable compound is an addition polymerizable compound having at least one ethylenically unsaturated group and is selected from compounds having at least one and preferably two or more terminal ethylenically unsaturated groups. These have chemical forms such as a monomer, a dimer, a trimer, an oligomer, and a mixture of these.
Examples of the monomer include unsaturated carboxylic acid (such as acrylic acid, methacrylic acid, itaconic acid, crotonic acid, isocrotonic acid, or maleic acid), esters, and amides thereof. Among these, esters of unsaturated carboxylic acid and a polyhydric alcohol compound and amides of unsaturated carboxylic acid and a polyhydric amine compound are preferably used. Further, addition reaction products with unsaturated carboxylic acid ester having a nucleophilic substituent such as a hydroxy group, an amino group, or a mercapto group or amides and monofunctional or polyfunctional isocyanates or epoxies; and dehydration condensation reaction products with monofunctional or polyfunctional carboxylic acid are suitably used. Moreover, addition reaction products with unsaturated carboxylic acid ester having an electrophilic substituent such as an isocyanate group or an epoxy group or amides and monofunctional or polyfunctional alcohols, amines, or thiols; and substitution reaction products with unsaturated carboxylic acid ester having a leaving substituent such as a halogen group or a tosyloxy group or amides and monofunctional or polyfunctional

alcohols, amines, or thiols are also suitably used. Further, as another example, compound groups replaced by unsaturated phosphonic acid, styrene, vinyl ether, and the like can be used in place of the above-described unsaturated carboxylic acid. These are described in references of JP2006-508380A, JP2002-287344A, JP2008-256850A, JP2001-342222A, JP1997-179296A (JP-H09-179296A), JP1997-179297A (JP-H09-179297A), JP1997-179298A (JP-H09-179298A), JP2004-294935A, JP2006-243493A, JP2002-275129A, JP2003-64130A, JP2003-280187A, and JP1998-333321A (JP-H10-333321A).

Specific examples of monomers of esters of a polyhydric alcohol compound and unsaturated carboxylic acid include (meth)acrylic acid ester such as ethylene glycol di(meth)acrylate, propylene glycol di(meth)acrylate, tetramethylene glycol di(meth)acrylate, 1,3-butanediol di(meth)acrylate, neopentyl glycol di(meth)acrylate, trimethylolpropane tri(meth)acrylate, hexanediol di(meth)acrylate, tetraethylene glycol di(meth)acrylate, pentaerythritol tetra(meth)acrylate, dipentaerythritol hexa(meth)acrylate, sorbitol tri(meth)acrylate, isocyanuric acid (EO)-modified tri(meth)acrylate, or a polyester (meth)acrylate oligomer.

Specific examples of monomers of amides of a polyvalent amine compound and unsaturated carboxylic acid include methylene bis-acrylamide, methylene bis-methacrylamide, 1,6-hexamethylene bis-acrylamide, 1,6-hexamethylene bis-methacrylamide, diethylene triamine trisacrylamide, xylylene bisacrylamide, and xylylene bismethacrylamide.

- Other components -

The image recording layer of the present invention may further contain other components as necessary.

Anionic or non-ionic surfactant

It is preferable that the image recording layer used in the present invention contain at least one of an anionic surfactant or a non-ionic surfactant.

As the anionic surfactant and the non-ionic surfactant, compounds which are the same as the surfactants serving as a hydrophilization agent described below are preferably used.

Further, the image recording layer used in the present invention may contain a fluorine-based or silicon-based anionic or non-ionic surfactant.

As the surfactant, it is preferable to use the same type of surfactant as the surfactant contained in the hydrophilization agent layer and more preferable to use a compound having the same structure as the structure of the surfactant contained in the hydrophilization agent layer. That is, it is preferable that an anionic surfactant is contained in the image recording layer in a case where an anionic surfactant is used as a hydrophilization agent and also preferable that a non-ionic surfactant is contained in the image recording layer in a case where a non-ionic surfactant is used as a hydrophilization agent.

Anionic surfactants having an excellent effect of promoting on-press development are particularly preferably used, and these surfactants can be used in combination of two or more kinds thereof. For example, a combination of two or more different anionic surfactants or a combination of an anionic surfactant and a non-ionic surfactant is preferable.

Low-molecular weight hydrophilic compound

In order to improve the on-press developability without degrading the printing durability, it is preferable that the image recording layer of the present invention may contain a low-molecular weight hydrophilic compound.

Examples of the low-molecular weight hydrophilic compound include glycols such as ethylene glycol, diethylene glycol, triethylene glycol, propylene glycol, dipropylene glycol, and tripropylene glycol and ether or ester derivatives thereof; polyols such as glycerin, pentaerythritol, and tris(2-hydroxyethyl) isocyanurate; organic amines such as triethanolamine, diethanolamine, and monoethanolamine and salts thereof; organic sulfonic acids such as alkylsulfonic acid, toluenesulfonic acid, and benzenesulfonic acid and salts thereof; organic sulfamic acids such as alkyl sulfamic acid and salts thereof; organic sulfuric acids such as alkyl sulfuric acid and alkyl ether sulfuric acid and salts thereof; organic phosphonic acids such as phenyl phosphonic acid and salts thereof; organic carboxylic acids such as tartaric acid, oxalic acid, citric acid, malic acid, lactic acid, gluconic acid, and amino acids and salts thereof; and betaines.

In the present invention, among these, it is preferable that the image recording layer contains at least one selected from the group consisting of polyols, organic sulfates, organic sulfonates, and betaines.

Specific examples of the compound of organic sulfonate include alkyl sulfonate such as sodium n-butyl sulfonate, sodium n-hexyl sulfonate, sodium 2-ethylhexyl sulfonate, sodium cyclohexyl sulfonate, or sodium n-octyl sulfonate; alkyl sulfonate containing an ethylene oxide chain such as sodium 5,8,11-trioxapentadecane-1-sulfonate, sodium 5,8,11-trioxaheptadecane-1-sulfonate, sodium 13-ethyl-5,8,11-trioxaheptadecane-1-sulfonate, or sodium 5,8,11,14-tetraoxatetradecosane-1-sulfonate; aryl sulfonate such as sodium benzene sulfonate, sodium p-toluene sulfonate, sodium p-hydroxybenzene sulfonate, sodium p-styrene sulfonate, sodium isophthalic acid dimethyl-5-sulfonate, sodium 1-naphthyl

sulfonate, sodium 4-hydroxynaphthyl sulfonate, disodium 1,5-naphthalene disulfonate, trisodium 1,3,6-naphthalene trisulfonate; and compounds described in paragraphs 0026 to 0031 of JP2007-276454A and paragraphs 0020 to 0047 of JP2009-154525A. The salt may be a potassium salt or a lithium salt.

Examples of the organic sulfate include an alkyl, an alkenyl, an alkynyl, an aryl of polyethylene oxide and a sulfate of heterocyclic monoether. The number of ethylene oxide units is preferably in a range of 1 to 4. As a salt, a sodium salt, a potassium salt, or a lithium salt is preferable. Specific examples of these include compounds described in paragraphs 0034 to 0038 of JP2007-276454.

As betaines, compounds having 1 to 5 carbon atoms of hydrocarbon substituents to nitrogen atoms are preferable. Specific examples thereof include trimethyl ammonium acetate, dimethyl propyl ammonium acetate, 3-hydroxy-4-trimethyl ammonio butyrate, 4-(1-pyridinio)butyrate, 1-hydroxyethyl-1-imidazolioacetate, trimethyl ammonium methane sulfonate, dimethyl propyl ammonium methane sulfonate, 3-trimethylammonio-1-propane sulfonate, and 3-(1-pyridinio)-1-propane sulfonate.

Since the low-molecular weight hydrophilic compound has a small structure of a hydrophobic portion and almost does not have a surface active action, hydrophobicity or coated-film strength of an image portion is not degraded by dampening water permeating into an image recording layer exposed portion (image portion) and ink receptivity or printing durability of the image recording layer can be maintained satisfactorily.

The amount of the low-molecular weight hydrophilic compounds to be added to the image recording layer is preferably in a range of 0.5% to 20% by mass with respect to the total amount of the solid content in the image recording layer. The amount thereof is more preferably in a range of 1% to 15% by mass and still more preferably in a range of 2% to 10% by mass. When the amount thereof is in the above-described range, excellent on-press developability and printing durability can be obtained.

These compounds may be used alone or in combination of two or more kinds thereof.

Oil sensitizing agent

In order to improve the impressing property, it is preferable that an oil sensitizing agent such as a phosphonium compound, a nitrogen-containing low-molecular weight compound, or an ammonium group-containing polymer is used for the image recording layer used in the present invention. Particularly, in a case where a protective layer contains an inorganic layered compound, these compounds function as a surface coating agent of the inorganic layered compound and prevent a degradation in impressing property due to the inorganic layered compound during the printing.

Preferred examples of the phosphonium compound include phosphonium compounds described in JP2006-297907A and JP2007-50660A. Specific examples thereof include tetrabutyl phosphonium iodide, butyl triphenyl phosphonium bromide, tetraphenyl phosphonium bromide, 1,4-bis(triphenylphosphonio)butane=di(hexafluorophosphate), 1,7-bis(triphenylphosphonio)heptane=sulfate, and 1,9-bis(triphenylphosphonio)nonane=naphthalene-2,7-disulfonate.

Examples of the nitrogen-containing low-molecular weight compound include amine salts, quaternary ammonium salts, imidazolinium salts, benzimidazolinium salts, pyridinium salts, and quinolinium salts. Among these, quaternary ammonium salts and pyridinium salts are preferable. Specific examples thereof include tetramethyl ammonium=hexafluorophosphate, tetrabutylammonium=hexafluorophosphate, dodecyltrimethylammonium=p-toluene sulfonate, benzyltriethylammonium=hexafluorophosphate, benzyldimethyloctylammonium=hexafluorophosphate, benzyldimethyldodecylammonium=hexafluorophosphate, and compounds described in paragraphs 0021 to 0037 of JP2008-284858A and paragraphs 0030 to 0057 of JP2009-90645A.

The ammonium group-containing polymer is not particularly limited as long as the polymer includes an ammonium group in the structure thereof, but a polymer that contains, as a copolymerization component, 5% to 80% by mole of (meth)acrylate having an ammonium group in the side chain is preferable. Specific examples thereof include polymers described in paragraphs [0089] to [0105] of JP2009-208458A.

The reduced specific viscosity (unit: ml/g) of the ammonium group-containing polymer which is acquired by the following measurement method is preferably in a range of 5 to 120, more preferably in a range of 10 to 110, and particularly preferably in a range of 15 to 100. When the reduced specific viscosity is converted into the weight-average molecular weight (Mw), the value thereof is preferably in a range of 10,000 to 150,000, more preferably in a range of 17,000 to 140,000, and particularly preferably in a range of 20,000 to 130,000.

Method of measuring reduced specific viscosity

3.33 g (1 g as a solid content) of a 30 mass% polymer solution is weighed using a 20 ml of measuring flask and is diluted with N-methylpyrrolidone. This solution is allowed to stand in a constant-temperature tank at 30°C for 30 minutes and put into an Ubbelohde reduced viscosity tube (viscometer constant: 0.010 cSt/s), and then the time for the solution to fall down at 30°C is measured. Further, the measurement is performed two times using the same sample

and the average value thereof is calculated. Similarly, also in a case of the blank (only N-methylpyrrolidone), the measurement is performed and the reduced specific viscosity (ml/g) is calculated from the following equation.

$$\text{Reduced specific viscosity } (ml/g) = \frac{\dfrac{\text{Time for sample solution to fall down (sec) - time for blank to fall down (sec)}}{\text{Time for blank to fall down (sec)}}}{\dfrac{3.33\ (g) \times \dfrac{30}{100}}{20\ (ml)}}$$

Hereinafter, specific examples of the ammonium group-containing polymer will be described:

(1) A 2-(trimethylammonio)ethylmethacrylate=p-toluenesulfonate/3,6-dioxaheptylmethacrylate copolymer (molar ratio of 10/90, Mw of 45,000);
(2) A 2-(trimethylammonio)ethylmethacrylate=hexafluorophosphate/3,6-dioxaheptylmethacrylate copolymer (molar ratio of 20/80, Mw of 60,000),
(3) A 2-(ethyldimethylammonio)ethylmethacrylate=p-toluenesulfonate/hexylmethacrylate copolymer (molar ratio of 30/70, Mw of 45,000);
(4) A 2-(trimethylammonio)ethylmethacrylate=hexafluorophosphate/2-ethylhexylmethacryalte copolymer (molar ratio of 20/80, Mw of 60,000);
(5) A 2-(trimethylammonio)ethylmethacrylate=methylsulfate/hexylmethacrylate copolymer (molar ratio of 40/60, Mw of 70,000);
(6) A 2-(butyldimethylammonio)ethylmethacrylate=hexafluorophosphate/3,6-dioxaheptylmethacryla te copolymer (molar ratio of 25/75, Mw of 65,000);
(7) A 2-(butyldimethylammonio)ethylacrylate=hexafluorophosphate/3,6-dioxaheptylmethacrylate copolymer (molar ratio of 20/80, Mw of 65,000);
(8) A 2-(butyldimethylammonio)ethylmethacrylate=13-ethyl-5,8,11-trioxa-1-heptadecanesulfonate/3 ,6-dioxaheptylmethacrylate copolymer (molar ratio of 20/80, Mw of 75,000); and
(9) A 2-(butyldimethylammonio)ethylmethacrylate=hexafluorophosphate/3,6-dioxaheptylmethacryla te/2-hydroxy-3-methacryloxypropylmethacrylate copolymer (molar ratio of 15/80:5, Mw of 65,000)

The content of the oil sensitizing agent is preferably in a range of 0.01% to 30.0% by mass, more preferably in a range of 0.1% to 15.0% by mass, and still more preferably in a range of 1% to 10% by mass with respect to the total solid content of the image recording layer.

Other components

The image recording layer used in the present invention may further contain other components such as a surfactant, a colorant, a printing-out agent, a polymerization inhibitor, a higher fatty acid derivative, a plasticizer, inorganic fine particles, an inorganic layered compound, a co-sensitizer, and a chain transfer agent. Specifically, the compounds and the addition amounts described in paragraphs 0114 to 0159 of JP2008-284817A, paragraphs 0023 to 0027 of JP2006-091479A, and paragraph 0060 of US2008/0311520A can be preferably used.
Further, it is preferable that the image recording layer of the present invention contains organic fine particles. Examples of the organic fine particles include fine particles of a binder polymer of the present invention. The volume average molecular diameter of the organic fine particles is preferably in a range of 0.1 to 100 μm.
The thickness of the image recording layer of the planographic printing plate precursor used in the present invention is preferably in a range of 0.2 μm to 3 μm and more preferably in a range of 0.2 μm to 2 μm. According to the embodiment described above, an image recording layer having excellent sensitivity film characteristics is obtained.

[Protective layer]

The planographic printing plate precursor of the present invention may include a protective layer.
Such a protective layer is described in US3458311A and JP1980-49729B (JP-S55-49729B). As a polymer with low oxygen permeability which is used for a protective layer, any of a water-soluble polymer and a water-insoluble polymer is suitably selected and then used and two or more kinds thereof can be used in combination as necessary.

Specific examples thereof include polyvinyl alcohol, modified polyvinyl alcohol, polyvinyl pyrrolidone, a water-soluble cellulose derivative, and poly(meth)acrylonitrile.

As the modified polyvinyl alcohol, acid-modified polyvinyl alcohol having a carboxy group or a sulfo group is preferably used. Specifically, modified polyvinyl alcohol described in JP2005-250216A and JP2006-259137A is preferable.

In order to improve oxygen-blocking properties, it is preferable that the protective layer contains an inorganic layered compound such as natural mica or synthetic mica described in JP2005-119273A.

Further, the protective layer may contain known additives such as a plasticizer for providing flexibility, a surfactant for improving coating properties, and inorganic fine particles for controlling slipperiness of the surface. Further, the protective layer may contain the oil sensitizing agent described in the section of the image recording layer.

The thickness of the protective layer of the planographic printing plate precursor used in the present invention is preferably in a range of 10 μm to 0.01μm, more preferably in a range of 3 μm to 0.02 μm, and still more preferably in a range of 1 μm to 0.02 μm.

[Hydrophilization agent layer]

The planographic printing plate precursor of the present invention includes a hydrophilization layer.

The hydrophilization agent layer contains a hydrophilization agent as a dispensable component. Preferred examples of an optional component include a plasticizer. Further, other examples of the optional component include a preservative and an anti-foaming agent.

- Hydrophilization agent -

As the hydrophilization agent used in the present invention, a surfactant, a phosphoric acid compound, a phosphonic acid compound, and a water-soluble resin are preferably used.

Hereinafter, each of the compounds will be described.

Surfactant

As the hydrophilization agent used in the present invention, it is preferable to use a surfactant. Examples of the surfactant which can be used in the present invention include anionic surfactants, non-ionic surfactants, cationic surfactants, and amphoteric surfactants. At least one selected from the group consisting of anionic surfactants, non-ionic surfactants, cationic surfactants, and amphoteric surfactants is preferable and an anionic surfactant and/or a non-ionic surfactant selected from the group is more preferable. According to the embodiment described above, a hydrophilization agent layer having a uniform film thickness can be obtained.

In addition, a fluorine-based or silicone-based anionic or non-ionic surfactant (typically, a fluorine-based or silicone-based anionic or non-ionic surfactant) is not preferable as the anionic or non-ionic surfactant of the present invention. In a case where these surfactants are used, a hydrophilization agent layer having a uniform film thickness cannot be obtained, which is not preferable.

Examples of the anionic surfactants include fatty acid salts, abietates, hydroxy alkane sulfonates, alkane sulfonates, dialkyl sulfosuccinates, linear alkyl benzene sulfonates, branched alkyl benzene sulfonates, alkyl naphthalene sulfonates, alkyl phenoxy polyoxyethylene propyl sulfonates, polyoxyethylene aryl ether sulfuric acid ester salts, polyoxyethylene alkyl sulfophenyl ether salts, N-methyl-N-oleyl sodium taurines, N-alkyl sulfosuccinic acid monoamide disodium salts, petroleum sulfonic acid salts, sulfated castor oil, sulfated beef tallow oil, sulfuric acid ester salts of fatty acid alkyl ester, alkyl sulfuric acid ester salts, polyoxyethylene alkyl ether sulfuric acid ester salts, fatty acid monoglyceride sulfuric acid ester salts, polyoxyethylene alkyl phenyl ether sulfuric acid ester salts, polyoxyethylene styryl phenyl ether sulfuric acid ester salts, alkyl phosphoric acid ester salts, polyoxyethylene alkyl ether phosphoric acid ester salts, polyoxyethylene alkyl phenyl ether phosphoric acid ester salts, partially saponified products of a styrene-maleic anhydride copolymer, partially saponified products of an olefin-maleic anhydride copolymer, and naphthalene sulfonate formalin condensates. Among these, dialkyl sulfosuccinates, alkyl sulfonic acid ester salts, polyoxyethylene aryl ether sulfonic acid ester salts, and alkyl naphthalene sulfonates are preferable.

Specifically, at least one anionic surfactant selected from the group consisting of anionic surfactants represented by Formula (I-A) or (I-B) may be exemplified.

$$(R_1)_p - Ar_1 - (SO_3^{\ominus})_q \quad M_1^{\oplus} \qquad \text{(I-A)}$$

$$(R_2)_m \text{ —— } Ar_2 \text{ —— } Y\text{-}O(R_3O)_n\text{-}SO_3^{\ominus} \quad M_2^{\oplus} \qquad (I-B)$$

In Formula (I-A), $R^1$ represents a linear or branched alkyl group having 1 to 20 carbon atoms; p represents 0, 1, or 2; $Ar^1$ represents an aryl group having 6 to 10 carbon atoms; q represents 1, 2, or 3; and $M_1^+$ represents $N_a^+$, $K^+$, $Li^+$, or $NH_4^+$. When p represents 2, a plurality of $R^1$'s may be the same as or different from each other.

In Formula (I-B), $R^2$ represents a linear or branched alkyl group having 1 to 20 carbon atoms; m represents 0, 1, or 2; $Ar^2$ represents an aryl group having 6 to 10 carbon atoms; Y represents a single bond or an alkylene group having 1 to 10 carbon atoms; $R^3$ represents a linear or branched alkylene group having 1 to 5 carbon atoms; n represents an integer of 1 to 100; and $M_2^+$ represents $Na^+$, $K^+$, $Li^+$, or $NH_4^+$. When m represents 2, a plurality of $R^{2}$'s may be the same as or different from each other. When n represents 2 or greater, a plurality of $R^{3}$'s may be the same as or different from each other.

In the preferred embodiment of the present invention, in Formulae I-A and I-B, preferred examples of $R_1$ and $R_2$ include $CH_3$, $C_2H_5$, $C_3H_7$, and $C_4H_9$. Further, preferred examples of $R_3$ include $-CH_2-$, $-CH_2CH_2-$, $-CH_2CH_2CH_2-$, and $-CH_2CHCH_3-$. Among these, $-CH_2CH_2-$ is more preferable. Moreover, it is preferable that p and m represent 0 or 1 and particularly preferable that p represents 0. It is preferable that Y represents a single bond. Further, it is preferable that n represents an integer of 1 to 20.

Specific examples of the compound represented by Formula I-A or I-B include the following compounds. Further, among the specific examples, the numerical values on the lower right side of parentheses in an alkyleneoxy structure show the numbers of repetitions.

(1) 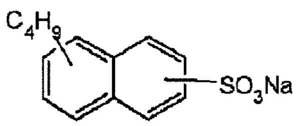

(2) 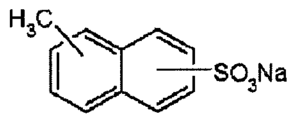

(3) 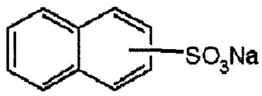

(4) 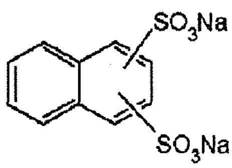

(5) 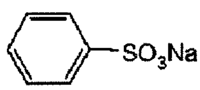

(6) 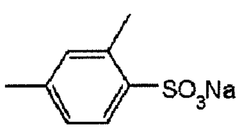

(10) 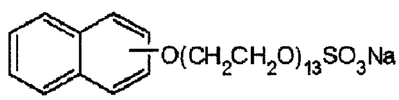

(11) 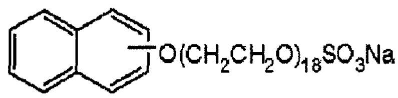

(12) 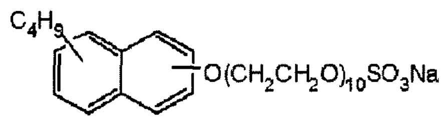

(13) 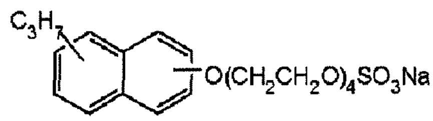

(14) 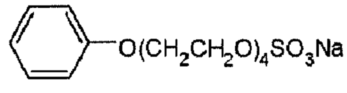

(15) 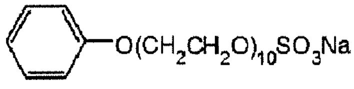

(7) 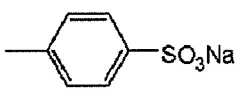 (16) 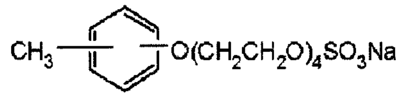

(8) 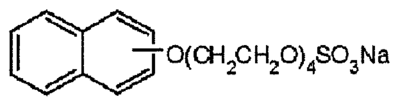 (17) 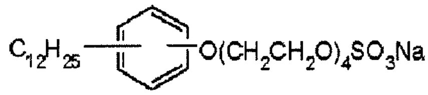

(9) 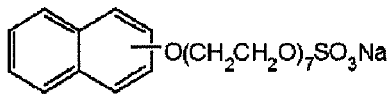

It is preferable that the anionic surfactant of the present invention is a polymer compound (anionic polymer surfactant). According to the embodiment described above, a hydrophilization agent layer having excellent planarity is obtained. The polymer compound is not particularly limited as long as the polymer compound contains at least one anionic group as a hydrophilic group.

Examples of the anionic group include a sulfonic acid group, a sulfuric acid group, and a carboxy group. Among these, a sulfonic acid group is preferable.

These anionic groups may constitute salts. The salts may be salts with inorganic cations or salts with organic cations.

Examples of the inorganic cations include a lithium cation, a sodium cation, a potassium cation, a calcium cation, and a magnesium cation. Among these, a lithium salt, a sodium cation, and a potassium cation are preferable and a sodium cation and a potassium cation are more preferable.

Examples of the organic cations include ammonium ($NH_4^+$), quaternary ammonium, quaternary pyridinium, and quaternary phosphonium. Among these, ammonium, quaternary ammonium, and quaternary pyridinium are preferable and quaternary ammonium is more preferable.

Examples of the polymer compound include a polymer of a monomer containing an anionic group in a molecule, a copolymer of a polymer of a monomer containing an anionic group in a molecule and other one or more monomers, and a polymer obtained by introducing a hydrophilic group to a polymer which does not contain an anionic group.

Examples of the monomer containing an anionic group in a molecule include a styrene derivative containing a sulfonic acid group such as acrylic acid, methacrylic acid, maleic acid, itaconic acid, styrenesulfonic acid, sodium styrene sulfonate, or α-methylstyrenesulfonic acid; olefin sulfonic acid such as maleic anhydride, vinylsulfonic acid, sodium allyl sulfonate, sodium methallyl sulfonate, sodium isoprene sulfonate, or 3-vinyloxypropanesulfonic acid; an acrylamide derivative containing a sulfonic acid group such as 2-acrylamide-2-methylpropanesulfonic acid or sodium 2-acrylamide-2-methylpropanesulfonate; a (meth)acrylate derivative such as sodium 2-sulfoethyl methacrylate; dienesulfonic acid such as butadiene sulfonic acid, and naphthalenesulfonic acid. Among these monomers, from the viewpoint of the edge stain preventing performance, a styrene derivative containing a sulfonic acid group or an acrylamide derivative containing a sulfonic acid group is preferable and sodium 4-styrene sulfonate or sodium 2-acrylamide-2-methylpropane sulfonate is more preferable.

Further, a copolymer of a monomer containing the above-described anionic group and a monomer containing a phosphoric acid ester group in a molecule described below corresponds not to an anionic surfactant but to a phosphoric acid compound and a copolymer of a monomer containing the above-described anionic group and a monomer containing a phosphonic acid ester group in a molecule described below corresponds not to an anionic surfactant but to a phosphonic acid compound.

Examples of the polymer compound include partially saponified products of a styrene-maleic anhydride copolymer, a formalin condensate (particularly, naphthalene sulfonic acid sodium salt formalin condensates) of a sulfonated aromatic compound containing a polynuclear aromatic compound, partially saponified products of an ethylene-maleic anhydride copolymer, a sodium salt of polyacrylic acid, a sodium salt of polystyrenesulfonic acid, and a sodium salt of poly 2-acrylamide-2-methylpropanesulfonic acid.

The weight average molecular weight of the polymer compound is preferably in a range of 2000 to 1000000, more preferably in a range of 3000 to 700000, and particularly preferably in a range of 5000 to 500000.

Examples of the non-ionic surfactants include polyoxyethylene alkyl ethers, polyoxyethylene aryl ethers, glycerin fatty acid partial esters, sorbitan fatty acid partial esters, pentaerythritol fatty acid partial esters, propylene glycol monofatty acid ester, sucrose fatty acid partial ester, polyoxyethylene sorbitan fatty acid partial esters, polyoxyethylene sorbitol fatty acid partial esters, polyethylene glycol fatty acid esters, polyglycerin fatty acid partial esters, polyoxyethylene glycerin

fatty acid partial esters, fatty acid diethanal amides, N,N-bis-2-hydroxyalkylamines, polyoxyethylene alkylamine, triethanolamine fatty acid esters, and trialkyl amine oxides. Among these, polyoxyethylene aryl ethers and polyoxyethylene-polyoxypropylene block copolymers are preferably used.

Other surfactants used for the hydrophilization layer according to the present invention include non-ionic surfactants, for example, polyoxyethylene alkyl ethers such as polyoxyethylene naphthyl ether, polyoxyethylene alkyl phenyl ether, polyoxyethylene lauryl ether, polyoxyxethylene cetyl ether, and polyoxyethylene stearyl ether; polyoxyethylene alkyl esters such as polyoxyethylene stearate; sorbitan alkyl esters such as sorbitan monolaurate, sorbitan monostearate, sorbitan distearate, sorbitan monooleate, sorbitan sesquioleate, and sorbitan trioleate; monoglyceride alkyl esters such as glycerol monostearate and glycerol monooleate.

Further, it is preferable that the non-ionic surfactant used in the present invention is a polymer compound. The weight average molecular weight of the polymer compound is preferably in a range of 2000 to 1000000, more preferably in a range of 3000 to 700000, and particularly preferably in a range of 5000 to 500000.

Preferred examples of the non-ionic surfactant include a surfactant represented by Formula II-A and a surfactant represented by Formula II-B.

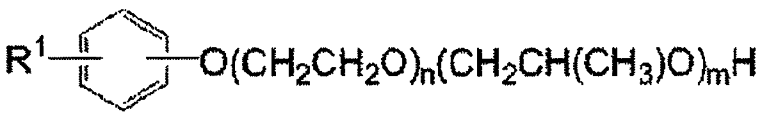

(II-A)

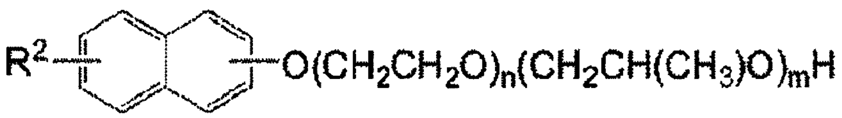

(II-B)

In Formula II-A, $R^1$ represents a hydrogen atom or an alkyl group having 1 to 100 carbon atoms, n and m each independently represent an integer of 0 to 100, and both of n and m do not represent 0 at the same time.

In Formula II-B, $R^2$ represents a hydrogen atom or an alkyl group having 1 to 100 carbon atoms, n and m each independently represent an integer of 0 to 100, and both of n and m do not represent 0 at the same time.

Examples of the compound represented by Formula II-A include polyoxyethylene phenyl ether, polyoxyethylene methyl phenyl ether, polyoxyethylene octyl phenyl ether, and polyoxyethylene nonyl phenyl ether. Examples of the compound represented by Formula II-B include polyoxyethylene naphthyl ether, polyoxyethylene methyl naphthyl ether, polyoxyethylene octyl naphthyl ether, and polyoxyethylene nonyl naphthyl ether.

In the compounds represented by Formulae II-A and II-B, the number n of repeating units of the polyoxyethylene chain is preferably in a range of 3 to 50 and more preferably in a range of 5 to 30. The number m of repeating units of the polyoxypropylene chain is preferably in a range of 0 to 10 and more preferably in a range of 0 to 5. The polyoxyethylene portion and the polyoxypropylene portion may be random copolymers or block copolymers.

The non-ionic aromatic ether surfactants represented by Formula II-A and II-B may be used alone or in combination of two or more kinds thereof.

Specific examples of the compounds represented by Formula II-A and II-B are described below. Further, an oxyethylene repeating unit and an oxypropylene repeating unit in an exemplary compound "Y-5" shown below may be in the form of any of a random bond and block connection. Further, among the specific examples, the numerical values on the lower right side of parentheses in an alkyleneoxy structure show the numbers of repetitions.

Y-1
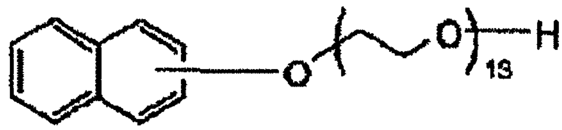

Y-2
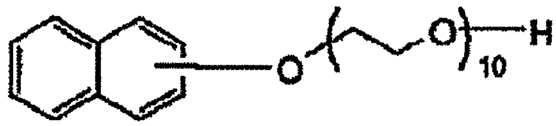

Y-3
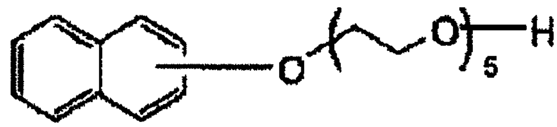

Y-4
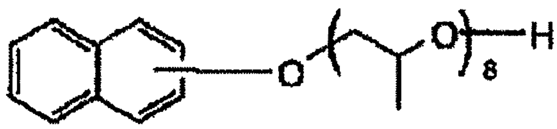

Y-5
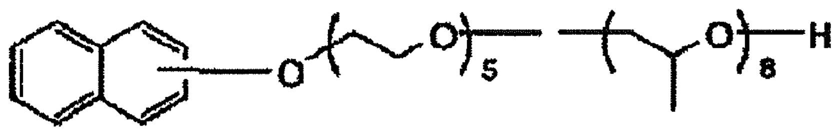

Y-6
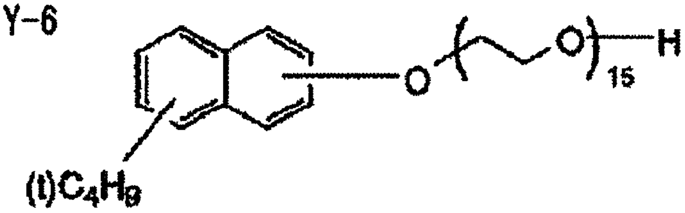

Y-7
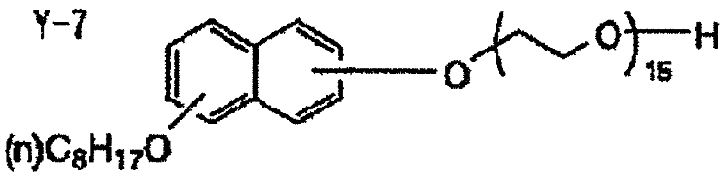

Y-8
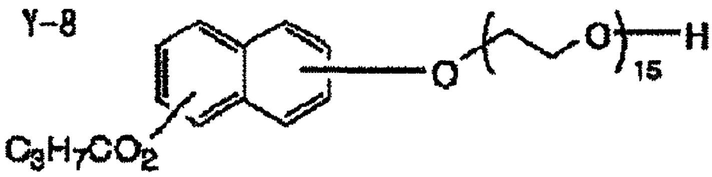

Y-9
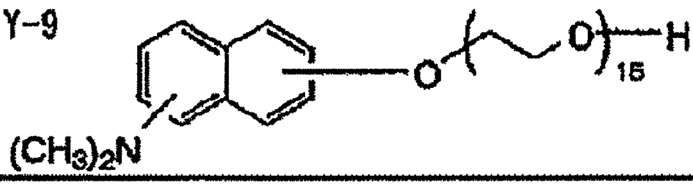

Y-10

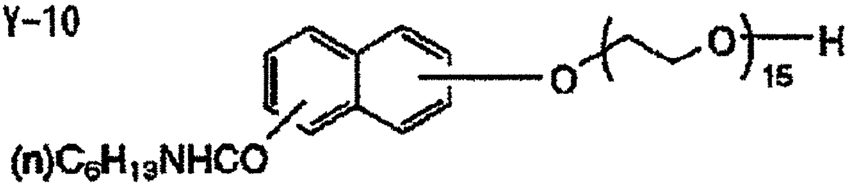

Y-11

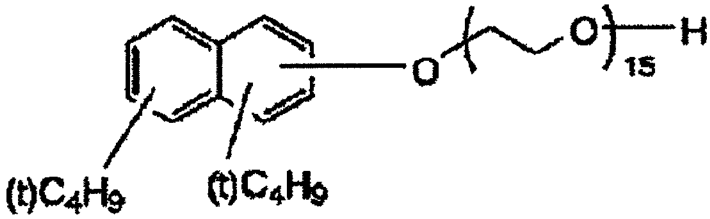

Y-12

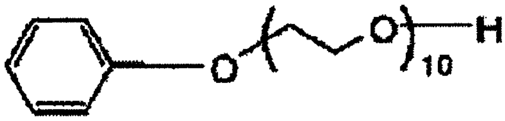

Y-13

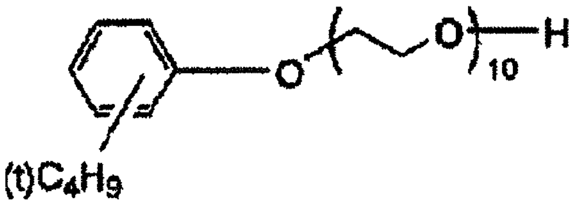

Y-14

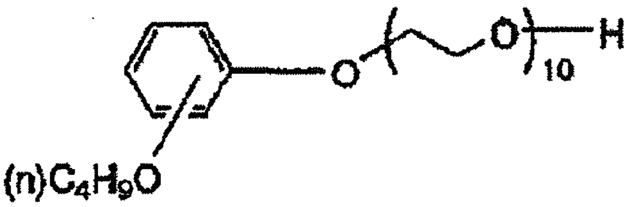

Y-15

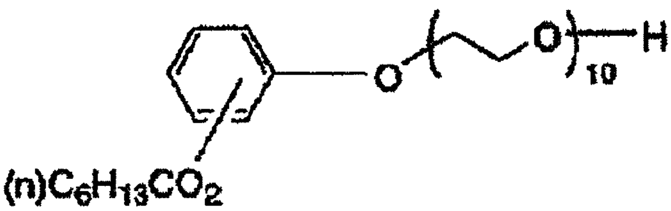

Y-16

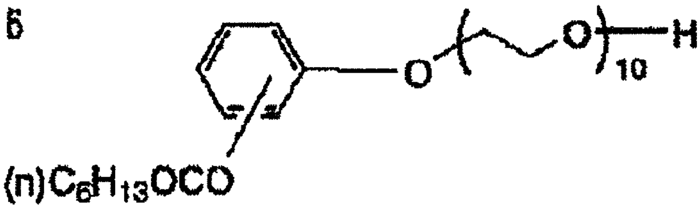

It is preferable that the hydrophilization agent of the present invention contains an amphoteric surfactant.

Examples of the amphoteric surfactant used in the present invention include carboxybetaines, aminocarboxylic acids, sulfobetaines, aminosulfuric acid esters, and imidazolines.

Further, it is preferable that the amphoteric surfactant is a polymer compound (amphoteric surfactant polymer). As the amphoteric surfactant polymer, a sulfobetaine-based polymer, a carboxybetaine-based polymer, or a phosphobetaine-based polymer is preferable and examples thereof include compounds described in JP2013-57747A and JP2012-194535A.

Among the surfactants described above, anionic surfactants having an excellent effect of promoting on-press development are particularly preferably used, and these surfactants can be used in combination of two or more kinds thereof. For example, a combination of two or more different anionic surfactants or a combination of an anionic surfactant and a non-ionic surfactant is preferable.

It is preferable to use sodium naphthalene sulfonate, sodium alkyl naphthalene sulfonate, or polyoxyethylene aryl ether and more preferable to use sodium naphthalene sulfonate or sodium t-butyl naphthalene sulfonate.

The content of the surfactant in the hydrophilization agent layer of the planographic printing plate precursor used in the present invention is preferably in a range of 10% to 90% by mass, more preferably in a range of 20% to 90% by mass, and still more preferably in a range of 30% to 90% by mass with respect to the total mass of the solid content of the hydrophilization agent layer. In a case where the content of the surfactant is in the above-described range, the on-press developability is promoted.

In addition, known cationic surfactants of the related art can be used together. Examples of the cationic surfactants include alkylamine salts, quaternary ammonium salts, polyoxyalkylamine salts, and polyethylene polyamide derivatives.

Phosphoric acid compound

As the hydrophilization agent used in the present invention, it is preferable to use a phosphoric acid compound. Examples of the phosphoric acid compound include phosphoric acid, metaphosphoric acid, monoammonium phosphate, ammonium secondary phosphate, sodium dihydrogen phosphate, sodium monohydrogen phosphate, potassium primary phosphate, potassium secondary phosphate, sodium tripolyphosphate, potassium pyrophosphate, and sodium hexametaphosphate. Among these, sodium dihydrogen phosphate, sodium monohydrogen phosphate, or sodium hexametaphosphate is preferably used.

The content of the phosphoric acid compound in the hydrophilization agent layer used in the present invention is preferably in a range of 2% to 30% by mass, more preferably in a range of 2% to 20% by mass, and still more preferably in a range of 3% to 10% by mass with respect to the total mass of the hydrophilization agent layer. When the content thereof is in the above-described range, a hydrophilization agent layer in which crystals are not deposited and which has excellent planarity can be obtained.

As the phosphoric acid compound, a phosphoric acid monoester compound or a phosphoric acid diester compound can be used.

As the phosphoric acid compound used in the present invention, it is preferable to use a polymer compound and more preferable to use a phosphoric acid monoester group. According to the above-described embodiment, a hydrophilization agent layer having excellent planarity is obtained.

Examples of the polymer compound include a polymer formed of one or more kinds of monomers having a phosphoric acid ester group in a molecule, a copolymer of one or more kinds of monomers having a phosphoric acid ester group and one or more kinds of monomers that do not have a phosphoric acid ester group, and a polymer obtained by introducing a phosphoric acid ester group into a polymer that does not have a phosphoric acid ester group.

Examples of the monomer having a phosphoric acid ester group include mono(2-methacryloyloxyethyl) acid phosphate, mono(2-methacryloyloxypolyoxyethyleneglycol) acid phosphate, mono(2-acryloyloxyethyl) acid phosphate, 3-chloro-2-acid phosphooxypropyl methacrylate, acid phosphooxy polyoxyethylene glycol monomethacrylate, acid phosphooxy polyoxypropylene glycol methacrylate, (meth)acryloyloxy ethyl acid phosphate, (meth)acryloyloxy propyl acid phosphate, (meth)acryloyloxy-2-hydroxy propyl acid phosphate, (meth)acryloyloxy-3-hydroxy propyl acid phosphate, (meth)acryloyloxy-3-chloro-2-hydroxy propyl acid phosphate, and allyl alcohol acid phosphate. Among these examples of monomers, from the viewpoint of edge stain preventing performance, mono(2-acryloyloxyethyl) acid phosphate is preferably used. Typical examples of commercially available products include LIGHT ESTER P-1M (manufactured by Kyoei Kagaku Kogyo Co., Ltd.) and PHOSMER PE (manufactured by Uni-Chemical Co., Ltd.).

As the polymer compound, both of a homopolymer and a copolymer of monomers having a phosphonic acid ester group can be also used. As the copolymer, for example, a copolymer of a monomer having a phosphonic acid ester group and a monomer having the above-described anionic group or a copolymer of a monomer having a phosphonic acid ester group and a monomer which does not have both of a phosphonic acid ester group and an anionic group can be used.

According to the preferred embodiment of the polymer compound, in a copolymer or a homopolymer, the proportion of monomer units containing a phosphoric acid ester group in a molecule is preferably in a range of 1% to 100% by mole, more preferably in a range of 5% to 100% by mole, and still more preferably in a range of 10% to 100%

by mole.

As the monomer which does not contain both of a phosphoric acid ester group and an anionic group, a monomer containing a hydrophilic group is preferable. Examples of the hydrophilic group include a hydroxy group, an alkylene oxide structure, an amino group, an ammonium group, and an amide group. Among these, a hydroxy group, an alkylene oxide structure, or an amide group is preferable, an alkylene oxide structure which has 1 to 20 alkylene oxide units having 2 or 3 carbon atoms is more preferable, and a polyethylene oxide structure having 2 to 10 ethylene oxide units is still more preferable. Examples thereof include 2-hydroxy ethyl acrylate, ethoxy diethylene glycol acrylate, methoxy triethylene glycol acrylate, poly(oxyethylene) methacrylate, N-isopropylacrylamide, and acrylamide.

Further, it is preferable to use a copolymer of a monomer containing a phosphoric acid ester group and a monomer containing an anionic group in a molecule, as the phosphoric acid compound. According to the above-described embodiment, a hydrophilization agent layer which has excellent planarity and excellent edge stain preventing performance is obtained.

The proportion of monomer units containing a phosphoric acid ester group in a molecule, in the copolymer of a monomer containing a phosphoric acid ester group and a monomer containing an anionic group in a molecule, is preferably in a range of 2% to 99% by mole, more preferably in a range of 2% to 80% by mole, still more preferably in a range of 5% to 70% by mole, and particularly preferably in a range of 5% to 50% by mole with respect to the total amount of the monomer units.

The weight-average molecular weight of the polymer compound is preferably in a range of 5000 to 1000000, more preferably in a range of 7000 to 700000, and particularly preferably in a range of 10000 to 500000.

Phosphonic acid compound

It is preferable to use a phosphonic acid compound as the hydrophilization agent used in the present invention. Examples of the phosphonic acid compound include ethylphosphonic acid, propylphosphonic acid, i-propylphosphonic acid, butylphosphonic acid, hexylphosphonic acid, octylphosphonic acid, dodecylphosphonic acid, octadecylphosphonic acid, 2-hydroxyethylphosphonic acid and sodium salts or potassium salts of these, alkyl phosphonic acid monoalkyl ester such as methylphosphonic acid methyl, ethylphosphonic acid methyl, or 2-hydroxyethyl phosphonic acid methyl and sodium salts or potassium salts of these, alkylene diphosphonic acid such as methylene diphosphonic acid or ethylene diphosphonic acid and sodium salts or potassium salts of these, and polyvinyl phosphonic acid.

Among these, it is preferable to use polyvinylphosphonic acid.

The content of the phosphonic acid compound in the hydrophilization agent layer used in the present invention is preferably in a range of 2% to 30% by mass, more preferably in a range of 2% to 20% by mass, and still more preferably in a range of 3% to 10% by mass with respect to the total mass of the hydrophilization agent layer. When the content thereof is in the above-described range, a hydrophilization agent layer in which crystals are not deposited and which has excellent planarity can be obtained.

As the phosphonic acid compound used in the present invention, a polymer compound is preferable. According to the above-described embodiment, a hydrophilization agent layer having a uniform film thickness is obtained.

Preferred examples of the polymer compound as a phosphonic acid compound include, in addition to polyvinyl phosphonic acid, a polymer formed of one or more monomers having a phosphonic acid group or a phosphonic acid monoester group in a molecule, and a copolymer of one or more monomers having a phosphonic acid group or a phosphonic acid monoester group and one or more monomers which do not have a phosphonic acid group and a phosphonic acid monoester group.

Examples of the monomer having a phosphonic acid group include vinylphosphonic acid, ethyl phosphonic acid monovinyl ester, acryloyl aminomethyl phosphonic acid, and 3-methacryloyloxy propylphosphonic acid.

As the polymer compound, both of a homopolymer and a copolymer of monomers having a phosphonic acid ester group are also used. As the copolymer, for example, a copolymer of a monomer having a phosphonic acid ester group and a monomer having an anionic group or a copolymer of a monomer having a phosphonic acid ester group and a monomer which does not have both of a phosphonic acid ester group and an anionic group can be used.

A monomer having a hydrophilic group is preferable as the monomer which does not contain both of a phosphonic acid ester group and an anionic group. Examples of the hydrophilic group include a hydroxy group, an alkylene oxide structure, an amino group, an ammonium group, and an amide group. Among these, a hydroxy group, an alkylene oxide structure, or an amide group is preferable, an alkylene oxide structure which has 1 to 20 alkylene oxide units having 2 or 3 carbon atoms is more preferable, and a polyethylene oxide structure having 2 to 10 ethylene oxide units is still more preferable. Examples thereof include 2-hydroxy ethyl acrylate, ethoxy diethylene glycol acrylate, methoxy triethylene glycol acrylate, poly(oxyethylene) methacrylate, N-isopropylacrylamide, and acrylamide.

Further, a copolymer of a monomer having a phosphonic acid ester group in a molecule and a monomer having an anionic group in a molecule can be used as the phosphonic acid compound. According to the above-described embodiment, a planographic printing plate precursor which has a uniform hydrophilization agent layer and excellent

edge stain preventing performance is obtained, which is preferable.

The proportion of monomer units containing a phosphonic acid ester group in a molecule, in the copolymer of a monomer containing a phosphonic acid ester group and a monomer containing an anionic group in a molecule, is preferably in a range of 2% to 99% by mole, more preferably in a range of 2% to 80% by mole, still more preferably in a range of 5% to 70% by mole, and particularly preferably in a range of 10% to 50% by mole with respect to the total amount of the monomer units.

The weight-average molecular weight of the polymer compound is preferably in a range of 5000 to 1000000, more preferably in a range of 7000 to 700000, and particularly preferably in a range of 10000 to 500000.

Water-soluble resin

It is preferable that the hydrophilization agent used in the present invention contains a water-soluble resin. Examples of the water-soluble resin include water-soluble resins classified as polysaccharides, polyvinyl alcohol, polyvinyl pyrrolidone, polyacrylamide, and a copolymer of these, a vinyl methyl ether-maleic anhydride copolymer, a vinyl acetic acid-maleic anhydride copolymer, and a styrene-maleic anhydride copolymer.

Examples of the polysaccharides include starch derivatives (such as dextrin, enzymatically decomposed dextrin, hydroxypropylated starch, carboxymethylated starch, phosphoric acid esterified starch, polyoxyalkylene grafted starch, and cyclodextrin); celluloses (such as carboxymethyl cellulose, carboxyethyl cellulose, methyl cellulose, hydroxypropyl cellulose, and methylpropyl cellulose); carrageenan, alginic acid, guar gum, locust bean gum, xanthan gum, gum Arabic, and soybean polysaccharides.

Among these, starch derivatives such as dextrin and polyoxyalkylene grafted starch, gum Arabic, carboxymethyl cellulose, and soybean polysaccharides are preferably used.

These water-soluble resins can be used in combination of two or more kinds thereof, and the content of the water-soluble resin is preferably in a range of 2% to 30% by mass, more preferably in a range of 2% to 20% by mass, and still more preferably in a range of 3 to 10% by mass with respect to the total mass of the hydrophilization agent layer. When the content thereof is in the above-described range, a hydrophilization agent layer having a uniform film thickness can be obtained.

The hydrophilization agent used in the present invention may be contained alone in the hydrophilization agent layer, but it is preferable to use and contain a combination of two or more hydrophilization agents, more preferable to use and contain a combination of one to four hydrophilization agents, still more preferable to use and contain a combination of one to three hydrophilization agents, and particularly preferable to use and contain a combination of two hydrophilization agent.

In a case where a plurality of hydrophilization agents are combined and contained, it is preferable that the hydrophilization agent layer contains a combination of a surfactant and a phosphoric acid compound or a phosphonic acid compound and more preferable that the hydrophilization agent layer contains a combination of an anionic surfactant and a phosphoric acid compound or a phosphonic acid compound.

Further, in a case where the hydrophilization agent is contained alone, it is preferable to contain a copolymer of a monomer having a phosphoric acid ester group or a phosphonic acid ester group in a molecule and a monomer having an anionic group in a molecule, more preferable to contain a copolymer of a monomer having a phosphoric acid ester group in a molecule and a monomer having an anionic group in a molecule, and still more preferable to contain a copolymer of a monomer having a phosphoric acid ester group in a molecule and a monomer having a sulfonic acid group in a molecule.

- Plasticizer -

The hydrophilization agent layer used in the present invention may contain a plasticizer. Examples of the plasticizer include plasticizers having a freezing point of 15°C or lower, for example, phthalic acid diesters such as dibutyl phthalate, diheptyl phthalate, di-n-octyl phthalate, di(2-ethylhexyl) phthalate, dinonyl phthalate, didecyl phthalate, dilauryl phthalate, and butyl benzyl phthalate; aliphatic dibasic acid esters such as dioctyl adipate, butyl glycol adipate, dioctyl azelate, dibutyl sebacate, di(2-ethylhexyl) sebacate, and dioctyl sebacate; epoxidized triglycerides such as epoxidized soybean oil; phosphoric acid esters such as tricresyl phosphate, trioctyl phosphate, and trischloroethyl phosphate; and benzoic acid esters such as benzyl benzoate.

The plasticizer may be used alone or in combination of two or more kinds thereof. The content of plasticizer is preferably in a range of 0% to 10% by mass and more preferably in a range of 0% to 5% by mass with respect to the total mass of the hydrophilization agent layer.

- Other additives -

The hydrophilization agent layer included in the planographic printing plate precursor used in the present invention may contain inorganic salts such as nitrate and sulfate, a preservative, and an anti-foaming agent in addition to the above-described components. Examples of the inorganic salts include magnesium nitrate, sodium nitrate, potassium nitrate, ammonium nitrate, sodium sulfate, potassium sulfate, ammonium sulfate, sodium hydrogen sulfate, and nickel sulfate.
Examples of the preservative include phenol or a derivative thereof, formalin, an imidazole derivative, sodium dehydroacetate, a 4-isothiazolin-3-one derivative, benzoisothiazolin-3-one, a benzotriazole derivative, an amidine guinidine derivative, derivatives of quaternary ammonium salts, pyridine, quinoline, and guanidine, diazine, a triazole derivative, oxazole, an oxazine derivative, and nitro bromo alcohol-based 2-bromo-2-nitropropane-1,3-diol, 1,1-dibromo-1-nitro-2-ethanol, and 1,1-dibromo-1-nitro-2-propanol.
Examples of the anti-foaming agent include a typical silicon-based self-emulsification type compound, an emulsification type compound, and a surfactant non-ionic compound having an HLB of 5 or less.
The thickness of the hydrophilization agent layer used in the present invention is preferably in a range of 0.01 μm to 2 μm, more preferably in a range of 0.02 μm to 1.5 μm, and particularly preferably in a range of 0.05 μm to 1.5 μm.
When the thickness thereof is 0.01 μm or greater, the effect of preventing edge stain is easily obtained. When the thickness thereof is 2 μm or less, bleeding of a hydrophilization agent over time or transferring of a hydrophilization agent to a plate or interleaving paper is satisfactorily suppressed.

[Interleaving paper]

It is preferable that the planographic printing plate precursor of the present invention includes interleaving paper on a side opposite to the support layer with respect to the protective layer in a case where the planographic printing plate precursor includes the protective layer or on a side opposite to the support layer with respect to the image recording layer in a case where the planographic printing plate precursor does not include the protective layer.
The material of the interleaving layer according to the present invention is not particularly limited, and examples thereof include paper, non-woven fabric, a plastic sheet, a film, and a laminated sheet or a film provided with a resin layer on one surface or both surfaces of paper.

[Sagging shape]

Fig. 9 illustrates an example of a cross-sectional shape of an end portion of the planographic printing plate precursor which has been cut by a cutting device. A distance X of a portion bend downward from the extension line of the image recording layer surface in the vertical direction is referred to as a "sagging amount X" and a distance Y thereof in the horizontal direction is referred to as a "sagging width Y". Since the edge stain in the planographic printing plate precursor occurs due to the reason that a printing ink component driven to an end portion from a non-image portion is transferred to a blanket, it is preferable to increase the sagging amount X of an end portion in order to avoid contact between the end portion and the blanket.
The sagging amount X is preferably in a range of 20 μm to 150 μm and more preferably in a range of 50 μm to 100 μm. In a case where the sagging amount X is in the above-described range, it is possible to suppress transferring of ink due to the contact between the end portion and the blanket and to improve on-press developability.
The sagging width Y is preferably in a range of 50 μm to 300 μm and more preferably in a range of 70 μm to 250 μm. In a case where the sagging width Y is in the above-described range, occurrence of cracks in the end portion is suppressed and occurrence of stain is suppressed.
Further, preferable ranges of the sagging amount X and the sagging width Y are not related to the edge shape of the rear surface of the substrate.

(Method of producing planographic printing plate precursor)

According to a method of producing the planographic printing plate precursor of the present invention, an image recording layer forming step a of forming an image recording layer on a support layer and a coating step b of coating a part of a region of the image recording layer formed by the step a with a coating solution containing a hydrophilization agent are performed in order of the step a and the step b or in order of the step b and the step a.
It is preferable that the method of producing the planographic printing plate precursor of the present invention includes an undercoating step d of forming an undercoat, a protective layer forming step e of forming a protective layer on the image recording layer, a step f of laminating interleaving paper on the support layer on the image recording layer side, and/or a drying step, in addition to the steps a and b.

In addition, a support which has been cut to have a size of the precursor in advance may be used as a support layer and the support layer may be cut after all steps are completed.

In a case where the support layer is cut, among the step a, the step b, the step d, the step e, the step f, and/or the drying step, it is preferable to perform a cutting step of cutting the support as the step c such that the region coated with the coating solution is in a range from end portions of the planographic printing plate to portions after the cutting from the end portions by 1 cm after all steps to be performed are completed.

According to the above-described embodiment, contamination caused by the hydrophilization agent going around the rear surface is suppressed, which is preferable.

Hereinafter, each step will be described in detail.

<Image recording layer forming step>

The method of producing the planographic printing plate precursor of the present invention includes the image recording layer forming step a of forming the image recording layer on the support layer.

Specifically, the image recording layer of the present invention is formed by dispersing or dissolving each component contained in the above-described image recording layer in a known solvent described below to prepare an image recording layer coating solution, coating the support layer with the image recording layer coating solution according to a known method such as bar coater coating, and drying the support layer.

[Solvent]

As the solvent used for preparing the image recording layer coating solution, known solvents can be used and examples thereof include ethylene glycol monoalkyl ethers, ethylene glycol dialkyl ethers, ethylene glycol monoalkyl ether acetates, propylene glycol monoalkyl ethers, propylene glycol dialkyl ethers, propylene glycol monoalkyl ether acetates, diethylene glycol dialkyl ethers, diethylene glycol monoalkyl ether acetates, dipropylene glycol monoalkyl ethers, dipropylene glycol dialkyl ethers, dipropylene glycol monoalkyl ether acetates, esters, ketones, amides, and lactones. Further, solvents described in paragraphs 0174 to 0178 of JP2011-221494A are also exemplified. The solvent is not particularly limited and known solvents can be used. Preferred specific examples of the solvent include methanol, ethanol, 1-propanol, 2-propanol, 1-butanol, 1-methoxy-2-propanol, ethylene glycol, diethylene glycol, and 1,3-propanediol.

<Coating step>

The method of producing of the planographic printing plate precursor of the present invention includes the coating step b of coating a part of a region of the image recording layer formed by the step a with a coating solution containing a hydrophilization agent (hereinafter, also referred to as a "hydrophilic coating solution").

Hereinafter, the region coated with the hydrophilic coating solution is also referred to as the "coated region".

The hydrophilic coating solution used in the present invention is prepared by dissolving each component contained in the above-described hydrophilization agent layer in water.

Examples of the coating method of the hydrophilic coating solution include known methods such as a die coating method, a dip coating method, an air knife coating method, a curtain coating method, a roller coating method, a wire bar coating method, a gravure coating method, a slide coating method, an inkjet method, a dispenser method, and a spray method. From the viewpoint that a part of the support layer needs to be coated with the coating solution, an inkjet method or a dispenser method is preferable.

The coating amount of the hydrophilic coating solution used in the present invention is preferably in a range of 0.1 to 2.0 $g/m^2$ and more preferably in a range of 0.2 to 1.0 $g/m^2$. When the coating amount thereof is in the above-described range, a planographic printing plate precursor with excellent edge stain preventing performance can be obtained.

In a case where a planographic printing plate precursor is produced using the support which has been cut in advance without performing the step c after the step b, it is preferable that regions from end portions of two facing sides of the support layer to portions inside the end portions by 1 cm are coated with the hydrophilic coating solution.

In a case where the step c is performed after the step b, the hydrophilic coating solution may be applied from end portions of the support layer or may be applied to positions other than the end portions of the support layer, and these coated positions may be combined.

Further, in a case where the hydrophilic coating solution is applied from the end portions of the support layer or in a case where the hydrophilic coating solution is applied to positions other than the end portions of the support layer, it is preferable that the hydrophilic coating solution is applied in the form of a strip having a certain width.

The coating width thereof is preferably in a range of 1 to 50 mm. It is preferable that the coating region having

a coating width is cut and the coating region is present from the cut end portion to a portion inside the end portion by 1 cm. In the cutting of the step c, one site on the coating region coated with the hydrophilic coating solution may be cut or two sites on the same coating region coated with the hydrophilic coating solution may be cut.

Further, it is preferable that coating regions are two facing sides of the planographic printing plate precursor after the cutting.

Figs. 1 to 8 respectively illustrate the planographic printing plate precursor, before the cutting, which is coated with the hydrophilic coating solution. The shaded portions indicate coating areas coated with the hydrophilic coating solution and the dashed line portions indicate cutting positions.

Fig. 1 illustrates a mode in which the hydrophilic coating solution is applied from the end portions of the support layer.

Figs. 2 to 5 respectively illustrate a mode in which a position separated from an end portion of the support layer is coated with the hydrophilic coating solution. Further, Fig. 5 illustrates a mode in which two sites on the same coating region coated with the hydrophilic coating solution are cut.

Figs. 6 to 8 illustrate a mode in which the hydrophilic coating solution is applied by combining a mode in which the hydrophilic coating solution is applied from an end portion of the support layer and a mode in which the hydrophilic coating solution is applied to a position in the vicinity of the center of the support layer. Fig. 8 illustrates a mode in which two sites on the same coating region coated with the hydrophilic coating solution are cut. Fig. 8 illustrates a mode in which the shaded portions (coating regions) are coated with the hydrophilic coating solution in the form of a strip while the support layer is conveyed in a direction indicated by an arrow and dashed line portions after the application are cut. The cutting positions are set to positions where all widths $A_1$ to $A_{28}$ of the coating regions coated with the hydrophilic coating solution are within 1 cm. According to the above-described modes, a planographic printing plate precursor in which an image recording layer is present on a quadrilateral hydrophilic aluminum support layer, a hydrophilization agent is distributed on the surface of the support layer on the image recording layer side in the regions from two facing end portions of the support layer to portions inside the end portions by 1 cm, and the hydrophilization agent is not attached to the rear surface of the support layer can be obtained.

<Cutting step>

The method of producing the planographic printing plate precursor of the present invention may include a cutting step of cutting the support such that the region coated with the coating solution is in a range from an end portion of the cut planographic printing plate to a portion from the end portion by 1 cm.

The cutting conditions for the planographic printing plate precursor of the present invention are not particularly limited and known cutting methods can be used, and methods described in described in JP1996-58257A (JP-H08-58257A), JP1997-211843A (JP-H09-211843A), JP1998-100556A (JP-H10-100556A), and JP1999-52579A (JP-H11-52579A).

As the cutting position, the cutting is made such that the coating region coated with the coating solution is in a range from an end portion of the planographic printing plate precursor to a position inside the end portion by 1 cm, preferably by 0.5 cm, and more preferably by 0.3 cm. When the coating region is in a range from the end portion of the planographic printing plate precursor to a position inside the end portion by 1 cm, a region on which an image can be formed is not affected. The lower limit of the width of the coating region is not particularly limited, but is preferably 0.1 mm or greater.

Further, in the cutting step in the method of producing the planographic printing plate precursor of the present invention, it is preferable that the cutting is made such that the end portion has the above-described sagging shape. According to the above-described embodiment, the effects of the present invention can be exhibited.

[Cutting method for allowing end portion to have sagging shape]

The shape illustrated in Fig. 9 is prepared by adjusting a gap between an upper cutting blade and a lower cutting blade of a slitter device, the amount of biting, and the blade tip angle.

Fig. 10 is a conceptual view illustrating a cutting portion of a slitter device. A pair of upper and lower cutting blades 10 and 20 are horizontally disposed in the slitter device. The cutting blades 10 and 20 are respectively formed of a round blade on a circular plate and upper cutting blades 10a and 10b are supported by a rotary shaft 11 and lower cutting blades 20a and 20b are supported by a rotary shaft 21 respectively on the same axis. The upper cutting blades 10a and 10b and the lower cutting blades 20a and 20b rotate in opposite directions. A planographic printing plate precursor 30 passes through the space between the upper cutting blades 10a and 10b and the space between the lower cutting blades 20a and 20b and then cut to have a predetermined width. More specifically, an end portion with the shape illustrated in Fig. 9 can be formed by adjusting the gap between the upper cutting blade 10a and the lower cutting blade 20a of the slitter device of Fig. 10 and the gap between the upper cutting blade 10b and the lower cutting blade 20b of

the cutting portion.

<Other steps>

[Undercoating step]

It is preferable that the method of producing the planographic printing plate precursor of the present invention further includes an undercoating step d of forming an undercoat on the support layer before the step a. Since the undercoat is formed on the image recording layer so that close contact between the support layer and the image recording layer in an exposed portion is strengthened and the image recording layer is easily peeled off from the support layer in an unexposed portion, the developability can be improved without damaging the printing durability. Further, in a case of infrared laser exposure, the undercoat functions as a heat insulating layer and thus heat generated due to exposure is diffused into the support layer. Therefore, a decrease in sensitivity is prevented.

The undercoat of the present invention is formed by dispersing or dissolving each component contained in the above-described undercoat to prepare a coating solution, coating the support layer with the coating solution according to a known method such as bar coater coating, and drying the support layer.

[Protective layer forming step]

It is preferable that the method of producing the planographic printing plate precursor of the present invention includes the protective layer forming step e of forming a protective layer on the image recording layer after the steps a and b and before the step c in a case where the step c is performed. The protective layer is formed on the image recording layer and has a function of suppressing a reaction of inhibiting image formation through oxygen blocking, a function of preventing generation of damage to the image recording layer, and a function of preventing ablation at the time of high illuminance laser exposure.

The protective layer of the present invention is formed by dispersing or dissolving each component contained in the above-described protective layer to prepare a coating solution, coating the support layer with the coating solution according to a known method such as bar coater coating, and drying the support layer.

[Drying step]

It is preferable that the planographic printing plate precursor of the present invention includes a drying step after application of the coating solution for forming each layer such as the undercoat, the image recording layer, or the protective layer.

The drying step may be performed multiple times whenever application of the coating solution for forming each layer and application of the hydrophilic coating solution are completed or may be collectively performed after the application of the coating solution for forming the plurality of layers and the application of the hydrophilic coating solution are completed.

In the method of producing the planographic printing plate precursor of the present invention, the drying step may be performed immediately after the hydrophilic coating solution or performed after the application of the hydrophilic coating solution and after the application of the coating solution for forming other layers.

The drying step can be performed using an oven or by blowing dry air.

The drying temperature is preferably in a range of 60°C to 250°C and more preferably in a range of 80°C to 160°C.

<Order of steps>

According to the method of producing the planographic printing plate precursor of the present invention, the step a and the step b are performed in order of the step a and the step b or in order of the step b and the step a.

Further, the step d is performed before the step a in a case where the method of producing the planographic printing plate precursor of the present invention includes the step d, and the step e is performed after the step a and the step b in a case where the method of producing the planographic printing plate precursor of the present invention includes the step e.

Further, the step c is performed after all other steps in a case where the method of producing the planographic printing plate precursor of the present invention includes the step c.

Further, in a case where the method of producing the planographic printing plate precursor of the present invention includes the step all steps of a to e, the steps are performed in order of the step b, the step d, the step a and the step e or in order of the step d, the step b, the step a, and the step e, preferably in order of the step d, the step a, the step b, and the step e, and more preferably in order of the step b, the step d, the step a, and the step e or in order

of the step d, the step b, the step a, and the step e, and then the step c.

Further, in a case where the method of producing the planographic printing plate precursor of the present invention does not include the step e and includes the steps a to e, it is preferable that the steps are performed in order of the step b, the step d, and the step a, in order of the step d, the step b, and the step a, or in order of the step d, the step a, and the step b, and then the step c.

Further, in each of the layer forming steps, the step b can be performed after the application of the coating solution for forming each layer and before the drying step.

In addition, in the method of producing the planographic printing plate precursor of the present invention, the following modes (1) to (5) are preferable and the modes (2) to (5) are more preferable.

(1) A mode of performing application of the hydrophilic coating solution before application to the undercoat.

(2) A mode of performing application of the hydrophilic coating solution after application to the undercoat without being dried.

(3) A mode of performing application the hydrophilic coating solution after application to the undercoat and drying the undercoat.

(4) A mode of performing application of the hydrophilic coating solution after application up to the image recording layer without being dried.

(5) A mode of performing application of the hydrophilic coating solution after application up to the image recording layer and drying the image recording layer.

In a case of the modes (4) and (5), a protective layer is not formed.

The modes (1), (2), and (3) are preferable from the viewpoint of excellent edge stain preventing effects and the modes (2) and (3) are more preferable.

The modes (1), (4), and (5) are preferable from the viewpoint that a step of applying the hydrophilic coating solution can be easily incorporated in an existing device that performs steps of forming each layer such as an undercoat, an image recording layer, or optionally a protective layer at once.

The modes (4) and (5) are preferable from the viewpoint that the edge stain preventing performance is excellent and the bleeding and the transferring of a substance over time are suppressed.

(Plate-making method for planographic printing plate)

A plate-making method for a planographic printing plate of the present invention includes an exposing step of image-exposing the planographic printing plate precursor of the present invention and a processing step of removing an unexposed portion of the planographic printing plate precursor.

It is preferable that the processing step is performed through on-press development.

Further, it is preferable that the plate-making method for a planographic printing plate of the present invention is a plate-making method for a planographic printing plate for printing newspapers.

A laser is preferable as a light source used for image exposure in the present invention. The laser used in the present invention is not particularly limited, but a solid-state laser or a semiconductor laser that radiates infrared rays having a wavelength of 760 to 1200 nm are preferable.

In the infrared laser, the output of the infrared laser is preferably 100 mW or greater, the exposure time per one pixel is preferably less than 20 microseconds, and the irradiation energy quantity is preferably in a range of 10 to 300 $mJ/cm^2$. In regard to a laser, for the purpose of reducing the exposure time, it is preferable to use a multi-beam laser device.

<Processing step>

The development after the exposure in the plate-making method for a planographic printing plate of the present invention can be performed using a treatment liquid, but it is preferable that the development is performed using an on-press development method. As the treatment liquid, an alkaline developer or a gum developer is preferably used. As the gum developer, the "rubber solution" described in paragraphs 0016 to 0028 of JP2007-538279A can be used. The on-press development method includes a printing step of performing printing by supplying an oil-based ink and an aqueous component and an unexposed portion of the planographic printing plate precursor is removed in the middle of the printing step without performing the step of image-exposing the planographic printing plate precursor and the development treatment on the planographic printing plate precursor after the exposure. The image exposure may be performed on a printing press after the planographic printing plate precursor is mounted on the printing press or may be separately performed using a plate setter or the like. In a case where the exposure is performed using a plate setter, the exposed planographic printing plate precursor is mounted on the printing press without performing the development

treatment step. Thereafter, an initial stage of on-press development treatment is performed during the printing, that is, the image recording layer in the unexposed region is removed by supplying an oil-based ink and an aqueous component and performing the printing using the printing press, and then the surface of the hydrophilic support is exposed, thereby forming a non-image portion. As the oil-based ink and the aqueous component, typical printing ink for planographic printing and dampening water are preferably used.

In a case where the development is performed using the on-press development method, the exposed planographic printing plate precursor is mounted on a plate cylinder of the printing press. Further, in a case where a printing press provided with a laser exposure device is used, the image exposure is performed after the planographic printing plate precursor is mounted on the plate cylinder of the printing press.

In a case where dampening water and printing ink are supplied to the image-exposed planographic printing plate precursor and then the printing is performed, a printing ink receiving portion having a lipophilic surface is formed by the image recording layer exposed in the exposed portion of the image recording layer. Meanwhile, in an unexposed portion, a non-cured image recording layer is dissolved or dispersed by supplied dampening water and/or printing ink and then removed, a hydrophilic surface is exposed to the portion. As the result, dampening water is exposed and adheres to the hydrophilic surface, the printing ink is impressed on the image recording layer of the exposed region, and then the printing is started.

Here, either of dampening water or printing ink may be initially supplied to the surface of the planographic printing plate precursor, but it is preferable that printing ink is initially supplied from the viewpoint of preventing contamination due to the image recording layer component from which dampening water has been removed.

In this manner, it is preferable that on-press development is performed on the planographic printing plate precursor of the present invention on an offset printing press for multiple sheets of printing.

[Dampening water]

It is preferable that the dampening water used in the present invention contains the following compounds.

(1) Water-soluble resin
(2) Auxiliary agent ((2-1) organic solvents and/or (2-2) surfactants) for improving wettability
(3) pH adjusting agent
(4) Other compounds ((i) a preservative, (ii) a chelating agent, (iii) a colorant, (iv) a rust inhibitor, (v) an anti-foaming agent, (vi) a masking agent, and the like)

It is preferable that the dampening water used in the present invention contains at least one of a water-soluble resin (1) at a content of 0.001% to 1% by mass of with respect to the total amount of the dampening water, an organic solvent (2-1) at a content (i) of 0.01% to 1.0% by mass with respect to the total amount of the dampening water, or a surfactant (2-2) at a content (ii) of 0.001% to 0.1% by mass with respect to the total amount of the dampening water, in the concentration after adjustment.

Further, the pH of the dampening water is preferably in a range of 7 to 11.

(1) Water-soluble resin

It is preferable that the dampening water used in the present invention contains a water-soluble resin. Examples of the water-soluble resin used for the dampening water of the present invention include natural products and modified products thereof such as gum Arabic, starch derivatives (such as dextrin, enzymatically decomposed dextrin, hydroxypropylated starch, carboxymethylated starch, phosphoric acid starch, and octenyl succinated starch), alginate, and fiber derivatives (such as carboxymethyl cellulose, carboxyethyl cellulose, methyl cellulose, and hydroxypropyl cellulose), polyethylene glycol and a copolymer thereof, polyvinyl alcohol and a derivative thereof, polyacrylamide and a copolymer thereof, polyacrylic acid and a copolymer thereof, a vinyl methyl ether-maleic anhydride copolymer, a vinyl acetate-maleic anhydride copolymer, a synthetic product of polystyrene sulfonic acid and a copolymer, and polyvinylpyrrolidone. Among these, carboxy methyl cellulose and hydroxy ethyl cellulose are particularly preferable. The content of the water-soluble polymer compound is appropriately in a range of 0.001% to 1% by mass and more preferably in a range of 0.005% to 0.2% by mass with respect to the amount of dampening water.

(2-1) Organic solvent

It is preferable that the dampening water used in the present invention contains an organic solvent in order to improve wettability. Examples thereof include ethylene glycol monomethyl ether, diethylene glycol monomethyl ether, triethylene glycol monomethyl ether, tetraethylene glycol monomethyl ether, ethylene glycol monoethyl ether, diethylene

glycol monoethyl ether, triethylene glycol monoethyl ether, tetraethylene glycol monoethyl ether, ethylene glycol monopropyl ether, diethylene glycol monopropyl ether, triethylene glycol monopropyl ether, tetraethylene glycol monopropyl ether, ethylene glycol monoisopropyl ether, diethylene glycol monoisopropyl ether, triethylene glycol monoisopropyl ether, tetraethylene glycol monoisopropyl ether, ethylene glycol monobutyl ether, diethylene glycol monobutyl ether, triethylene glycol monobutyl ether, tetraethylene glycol monobutyl ether, ethylene glycol monoisobutyl ether, diethylene glycol monoisobutyl ether, triethylene glycol monoisobutyl ether, tetraethylene glycol monoisobutyl ether, ethylene glycol monotertiary butyl ether, diethylene glycol monotertiary butyl ether, triethylene glycol monotertiary butyl ether, tetraethylene glycol monotertiary butyl ether, propylene glycol monomethyl ether, dipropylene glycol monomethyl ether, tripropylene glycol monomethyl ether, propylene glycol monoethyl ether, dipropylene glycol monoethyl ether, tripropylene glycol monoethyl ether, tetrapropylene glycol monoethyl ether, propylene glycol monopropyl ether, dipropylene glycol monopropyl ether, tripropylene glycol monopropyl ether, propylene glycol monoisopropyl ether, dipropylene glycol monoisopropyl ether, tripropylene glycol monoisopropyl ether, dipropylene glycol monobutyl ether, tripropylene glycol monobutyl ether, propylene glycol monoisobutyl ether, dipropylene glycol monoisobutyl ether, tripropylene glycol monoisobutyl ether, propylene glycol monotertiary butyl ether, dipropylene glycol monotertiary butyl ether, tripropylene glycol monotertiary butyl ether, polypropylene glycol having a molecular weight of 200 to 1000 and monomethyl ether of these, monoethyl ether, monopropyl ether, monoisopropyl ether and monobutyl ether, propylene glycol, dipropylene glycol, tripropylene glycol, tetrapropylene glycol and pentapropylene glycol, ethylene glycol, diethylene glycol, triethylene glycol, butylene glycol, hexylene glycol, 2-ethyl-1,3,-hexanediol, 3-methoxy-3-methyl-1-butanol, 1-butoxy-2-propanol, glycerin, diglycerin, polyglycerin, trimethylolpropane, and a 2-pyrrolidone derivative in which the 1-position is substituted with an alkyl group having 1 to 8 carbon atoms. Among these, ethylene glycol monotertiary butyl ether, 3-methoxy-3-methyl-1-butanol, and 1-butoxy-2-propanol are preferable. These solvents may be used alone or in combination of two or more kinds thereof. It is preferable that these solvents are used at a content of 0.01% to 1.0% by mass based on the total mass of the dampening water.

(2-2) Surfactants

It is preferable that the dampening water used in the present invention contains a surfactant in order to improve the wettability. Among the surfactants, examples of the anionic surfactants include fatty acid salts, abietates, hydroxy alkane sulfonates, alkane sulfonates, dialkyl sulfosuccinates, linear alkyl benzene sulfonates, branched alkyl benzene sulfonates, alkyl naphthalene sulfonates, alkyl phenoxy polyoxyethylene propyl sulfonates, polyoxyethylene alkyl sulfophenyl ether salts, N-methyl-N-oleyl sodium taurines, N-alkyl sulfosuccinic acid monoamide disodium salts, petroleum sulfonic acid salts, sulfated castor oil, sulfated beef tallow oil, sulfuric acid ester salts of fatty acid alkyl ester, alkyl sulfuric acid ester salts, polyoxyethylene alkyl ether sulfuric acid ester salts, fatty acid monoglyceride sulfuric acid ester salts, polyoxyethylene alkyl phenyl ether sulfuric acid ester salts, polyoxyethylene styryl phenyl ether sulfuric acid ester salts, alkyl phosphoric acid ester salts, polyoxyethylene alkyl ether phosphoric acid ester salts, polyoxyethylene alkyl phenyl ether phosphoric acid ester salts, partially saponified products of a styrene-maleic anhydride copolymer, partially saponified products of an olefin-maleic anhydride copolymer, and naphthalene sulfonate formalin condensates. Among these, dialkyl sulfossucinates, alkyl sulfuric acid ester salts, and alkyl naphthalene sulfonates are particularly preferably used.

Examples of the non-ionic surfactants include polyoxyethylene alkyl ethers, polyoxyethylene alkyl phenyl ethers, polyoxyethylene polystyryl phenyl ethers, polyoxyethylene polyoxypropylene alkyl ethers, glycerin fatty acid partial esters, sorbitan fatty acid partial esters, pentaerythritol fatty acid partial esters, propylene glycol mono-fatty acid esters, sucrose fatty acid partial esters, polyoxyethylene sorbitan fatty acid partial esters, polyoxyethylene sorbitol fatty acid partial esters, polyethylene glycol fatty acid esters, polyglycerin fatty acid partial esters, polyoxyethylated castor oil, polyoxyethylene glycerin fatty acid partial esters, fatty acid diethanal amides, N,N-bis-2-hydroxyalkylamines, polyoxyethylene alkylamine, triethanolamine fatty acid esters, polyoxyethylene-polyoxypropylene block copolymers, and trialkyl amine oxides. Among these, fluorinated surfactants, silicone-based surfactants can be used. In a case where a surfactant is used, the content thereof is preferably in a range of 0.001% to 0.1% by mass and more preferably in a range of 0.002% to 0.05% by mass in consideration of foaming. Further, the surfactants can be used in combination of two or more kinds thereof.

(3) pH adjusting agent

The pH adjusting agent (3) used for the dampening water of the present invention can be used in an alkaline region having a pH of 7 to 10 which contains an alkali metal hydroxide, phosphoric acid, alkali metal salt, alkali metal carbonate salt, and silicate.

Further, at least one selected from a water-soluble organic acid, a water-soluble inorganic acid, or salts of these can be used. These compounds are effective for pH adjustment or pH buffering of the dampening water, moderate etching of the support layer in the planographic printing plate, and antiseptic food. Preferred examples of the organic

acid include citric acid, ascorbic acid, malic acid, tartaric acid, lactic acid, acetic acid, gluconic acid, hydroxyacetic acid, oxalic acid, malonic acid, levulinic acid, sulfanilic acid, p-toluenesulfonic acid, phytic acid, and organic phosphonic acid. Examples of the inorganic acid include phosphoric acid, nitric acid, sulfuric acid, and polyphosphoric acid. Further, alkali metal salts of these organic acids and/or inorganic acids, alkaline earth metal salt, or ammonium salt, and organic amine salt are preferably used. These organic acid, inorganic acid, and these salts may be used alone or in combination of two or more kinds thereof.

(Printing method)

In a case where printing is performed using the planographic printing plate obtained by the plate-making method for a planographic printing plate of the present invention, the printing target is not particularly limited, but it is preferable to performing printing using printing paper having a larger width than the width of the planographic printing plate and more preferable that the printing paper is printing paper for newspapers.

Further, it is preferable that the planographic printing plate of the present invention is printed on the paper surface by being wound around a rotating cylindrical plate cylinder of the printing press, attaching ink onto an image portion in the presence of dampening water, and transferring the image portion to a rubber blanket.

Examples

Hereinafter, the present invention will be described in detail with reference to examples. The materials, the used amounts, the ratios, the contents of treatments, and the treatment procedures described in the following examples can be changed as appropriate within the range not departing from the scope of the present invention. Therefore, the range of the present invention is not limited to the specific examples described below. Further, "part" and "%" are on a mass basis unless otherwise noted.

(Preparation of planographic printing plate precursor (1))

<Preparation of support>

In order to remove rolling oil on a surface of an aluminum plate (Material JIS A 1050) having a thickness of 0.3 mm, a degreasing treatment was performed using a 10 mass% sodium aluminate aqueous solution at 50°C for 30 seconds, the aluminum surface was grains using three bundle nylon brushes having a diameter of 0.3 mm and a pumice water suspension (specific gravity of 1.1 g/cm$^3$) having a median diameter of 25 $\mu$m and then sufficiently washed with water. This aluminum plate was immersed in a 25 mass% sodium hydroxide aqueous solution at 45°C for 9 seconds, etched, washed with water, and further immersed in a 20 mass% nitric acid aqueous solution at 60°C for 20 seconds, and then washed with water. The etching amount of the grained surface at this time was approximately 3 g/m$^2$.

Next, an electrochemical roughening treatment was continuously performed using an AC voltage of 60 Hz. As the electrolyte at the time, a 1 mass% nitric acid aqueous solution (including 0.5% by mass of aluminum ions) was used at a liquid temperature of 50°C. Using a trapezoidal rectangular waveform having a time TP, until the current value reached a peak from zero, of 0.8 msec and the duty ratio of 1:1 as an AC power source waveform, the electrochemical surface-roughening treatment was performed using a carbon electrode as a counter electrode. As an auxiliary anode, ferrite was used. The current density was 30 A/dm$^2$ as the peak current value, and 5% of the current flowing from the power source was separated to an auxiliary anode. The electric quantity in the nitric acid electrolysis was 175 C/dm$^2$ when the aluminum plate was an anode.

Thereafter, washing with water by spraying was performed.

Next, an electrochemical roughening treatment was performed according to the same method as the method for nitric acid electrolysis under the condition of an electric quantity of 50 C/dm2 when an aluminum plate is an anode in a 0.5 mass% hydrochloric acid aqueous solution (including 0.5% by mass of aluminum ions) and an electrolyte at a liquid temperature of 50°C. Subsequently, washing with water by spraying was performed.

Next, 2.5 g/m$^2$ of a DC anodized film was provided on this plate at a current density of 15 A/dm$^2$ using a 15 mass% nitric acid aqueous solution (including 0.5% by mass of aluminum ions), washed with water, and then dried, thereby preparing a support (1).

Thereafter, in order to ensure hydrophilicity of the non-image portion, a silicate treatment was performed on the support (1) at 60°C for 10 seconds using a 2.5 mass% No. 3 sodium silicate aqueous solution, and then the support was washed with water, thereby obtaining a support (2). The adhesion amount of Si was 10 mg/m$^2$. The center line average roughness (Ra) of the support (2) which was measured using a needle having a diameter of 2 $\mu$m was 0.51 $\mu$m.

<Layer forming step>

[Formation of undercoat]

Next, the support (2) was coated with a coating solution (1) for an undercoat with the following composition such that the drying coating amount thereof was set to 20 mg/$m^2$, thereby preparing a support having an undercoat.

[Coating solution (1) for undercoat]

• Compound (1) for an undercoat with the following structure: 0.18 parts

In the following structures, the numerical values of 21, 48, 20, and 11 on the lower right side of the parentheses in the constitutional units show the molar ratios of the constitutional units and the numerical values on the lower right side of parentheses in the alkyleneoxy structure show the numbers of repetitions.

- Hydroxyethyl iminodiacetic acid: 0.10 parts
- Methanol: 55.24 parts
- Water: 6.15 parts

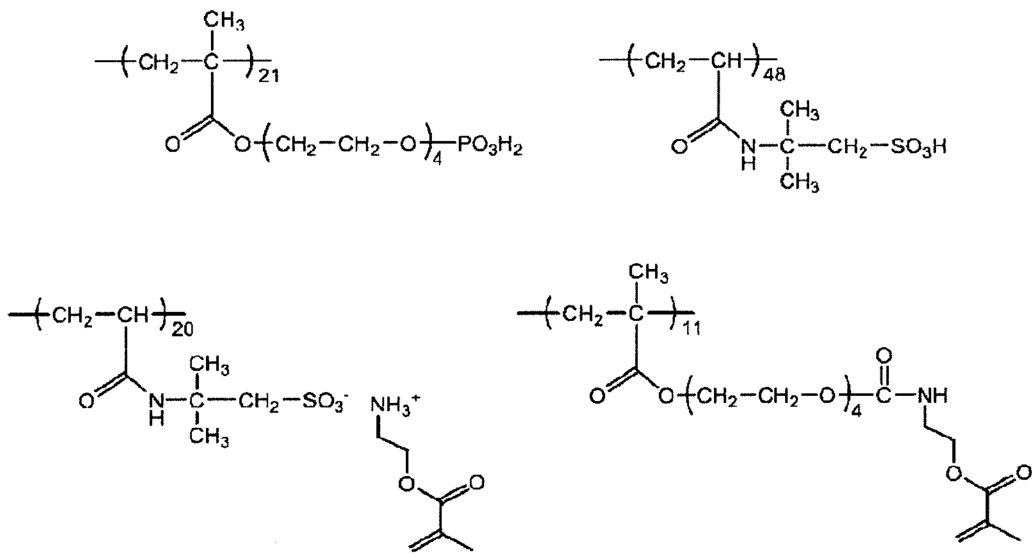

Compound (1) for undercoat Mw: 100,000

[Preparation of polymerizable compound]

An isocyanate compound, an alcohol compound, a dibutyltin dilaurate catalyst, and a stabilizer 2,6-di-tert-butyl-4-methyl phenol listed in Table 1 were dissolved in methyl ethyl ketone at 40°C such that the final concentration of non-volatile components was set to approximately 30% by mass, and an alcohol compound was added thereto such that the temperature thereof did not exceed 42°C. After the solution was stirred for 2 hours, the temperature thereof was increased to 60°C, and the solution was further stirred for 2 hours. The reaction was monitored by IR spectroscopy and the isocyanate compound still remaining at the end of the reaction was quenched with an appropriate amount of methanol. The weight average molecular weight of the polymerizable compound obtained by the reaction was confirmed by GPC.

Further, the columns of "molar ratio" listed in Table 1 show molar amounts of each alcohol compound in a case where the molar amount of the isocyanate compound was set to 1.

[Table 1]

| Polymerizable compound | Isocyanate compound | Alcohol compound | Molar ratio | Weight-average molecular weight |
|---|---|---|---|---|
| 1 | DESMODUR N3300 | GDMA | 1.64 | 3,200 |
| | | GMMA | 0.314 | |
| | | PPGMA | 1.31 | |
| 2 | DESMODUR N3300 | HEMA | 1 | 5,000 |
| | | HEPi | 0.5 | |
| 3 | DESMODUR N3300 | GDMA | 1.64 | 4,000 |
| | | GMMA | 0.314 | |
| | | PPGMA | 131 | |
| 4 | DESMODUR N3300 | GDMA | 1.64 | 7,500 |
| | | GMMA | 0.314 | |
| | | PPGMA | 1.31 | |
| 5 | DESMODUR N3300 | GDMA | 1.64 | 8,800 |
| | | GMMA | 0.314 | |
| | | PPGMA | 1.31 | |
| 6 | DESMODUR N3300 | GDMA | 1.64 | 5,500 |
| | | GMMA | 0.314 | |
| | | PPGMA | 1.31 | |
| 7 | HMDI | HEMA | 1 | 5,000 |
| | | HEPi | 0.5 | |
| 8 | DESMODUR N3300 | GDMA | 1.64 | 9,500 |
| | | GMMA | 0.314 | |
| | | PPGMA | 1.31 | |
| 9 | DESMODUR N3300 | GDMA | 1.64 | 12,000 |
| | | GMMA | 0.314 | |
| | | PPGMA | 1.31 | |
| 10 | DESMODUR N3300 | GDMA | 1.64 | 2,500 |
| | | GMMA | 0.314 | |
| | | PPGMA | 1.31 | |
| 11 | DESMODUR N3300 | GDMA | 1.64 | 1,000 |
| | | GMMA | 0.314 | |
| | | PPGMA | 1.31 | |
| 12 | DESMODUR N3300 | HEMA | 1 | 7,500 |
| | | HEPi | 0.5 | |
| 13 | DESMODUR N3300 | HEMA | 1 | 3,300 |
| | | HEPi | 0.5 | |
| 14 | DESMODUR N3300 | HEMA | 1 | 8,500 |
| | | HEPi | 0.5 | |

The details of the compounds listed in Table 1 are described below.

Desmodur (trademark) N3300, trifunctional isocyanate compound (all n's in Formula II represent 6) represented by Formula II, manufactured by Bayer AG

HMDI: hexamethylene diisocyanate, manufactured by Tokyo Chemical Industry Co., Ltd.
GMMA: glycerin monomethacrylate, manufactured by NOF CORPORATION
GDMA: glycerin-1,3-dimethacrylate, manufactured by Shin-Nakamura Chemical Co., Ltd.
HEMA: (2-hydroxyethyl)methacrylate, manufactured by Tokyo Chemical Industry Co., Ltd.
PPGMA: polypropylene glycol methacrylate, weight-average molecular weight of 405, manufactured by Sartomer Japan Inc.
HEPi: 2-(2-hydroxyethyl)-piperidine, manufactured by Tokyo Chemical Industry Co., Ltd.
HEA: (2-hydroxyethyl)acrylate, manufactured by Tokyo Chemical Industry Co., Ltd.
PETA: pentaerythritol triacrylate, manufactured by Shin-Nakamura Chemical Co., Ltd.

<Preparation of planographic printing plate precursor 1>

An image recording layer coating solution (1) prepared such that the composition listed in Table 2 had a concentration of solid contents of 5.6% by mass was prepared on the undercoat formed in the above-described manner with respect to a solvent containing 40% by mass of n-propanol, 25% by mass of 1-methoxy-2-propanol, and 25% by mass of methyl ethyl ketone, and 5% by mass of water, bar-coated, and then dried in an oven at 70°C for 60 seconds, thereby preparing a planographic printing plate precursor 1 having a drying coating amount of 0.6 g/$m^2$.

[Table 2]

| Compound | Used amount (parts by mass) |
|---|---|
| Polymer 1 | 32 |
| Infrared absorbing agent (2) | 4 |
| Irgacure250 | 2.5 |
| Polymerizable compound 1 | 28 |
| Polymerization initiator (2) | 4.6 |
| SR-399 | 12 |
| Mercapto-3-triazole | 1.2 |
| Byk336 | 2.2 |
| Klucel M | 4 |
| ELVACITE 4026 | 5 |
| Sipomer PAM-100 | 1.5 |
| Anionic surfactant (1) | 3 |

The details of the compounds listed in Table 2 are described below.

Polymer 1: compound described below, synthetic product
Infrared absorbing agent (2): compound having the following structure, synthetic product
Irgacure 250: manufactured by BASF Corporation
Polymerizable compound 1: synthetic product described above
Polymerization initiator (2): compound having the following structure, synthetic product, and Ph represents a phenyl group in the structure
SR-399: dipentaerythritol pentaacrylate, manufactured by Sartomer Japan Inc.
Mercapto-3-triazole: manufactured by Tokyo Chemical Industry Co., Ltd.
Byk336: manufactured by BYK Chemie GmbH
Klucel M: manufactured by Hercules, Inc.
ELVACITE 4026: manufactured by Ineos Acrylics Ltd.
Sipomer PAM-100: manufactured by Rhodia Nicca, Ltd.

Anionic surfactant (1): compound having the following structure, synthetic product

(Preparation of polymer 1)

Nitrogen gas was introduced into a four-necked flask equipped with a stirrer, a thermometer, a dropping funnel, a nitrogen introduction pipe, and a reflex condenser, deoxygenation was performed, 10 g of polyethylene glycol methyl ether methacrylate (PEGMA, average repeating unit of ethylene glycol: 50), 200 g of distilled water, and 200 g of n-propanol were added thereto, and then the mixture was heated until the internal temperature thereof was set to 70°C. Next, a mixture of 10 g of styrene (St), 80 g of acrylonitrile (AN), and 0.8 g of 2,2'-azobisisobutyronitrile prepared in advance was added dropwise for 1 hour. After dropwise addition was finished, the reaction was allowed to be continued for 5 hours, 0.4 g of 2,2'-azobisisobutyronitrile was added thereto, and the mixture was heated until the internal temperature was set to 80°C. Subsequently, 0.5 g of 2,2'-azobisisobutyronitrile was added for 5 hours. The total degree of polymerization at the stage of the continued reaction for 20 hours was 98% or greater, and a polymer 1 having PEGMA, St, and AN at a mass ratio of 10/10/80 was obtained. The polymer 1 had a spherical shape and the particle size distribution of the polymer 1 had a maximum value at a particle diameter of 140 nm.

Here, the particle size distribution was acquired by imaging an electron micrograph of the polymer 1, measuring the total number of 5,000 particle diameters of fine particles on the photograph, dividing the interval from the maximum value of the obtained measured value of the particle diameter to 0 into the logarithmic scale of 50, and plotting the appearance frequency of each particle diameter. Further, the particle diameter of a spherical particle having the same particle area as the particle area on the photograph was set to the particle diameter, as non-spherical particles.

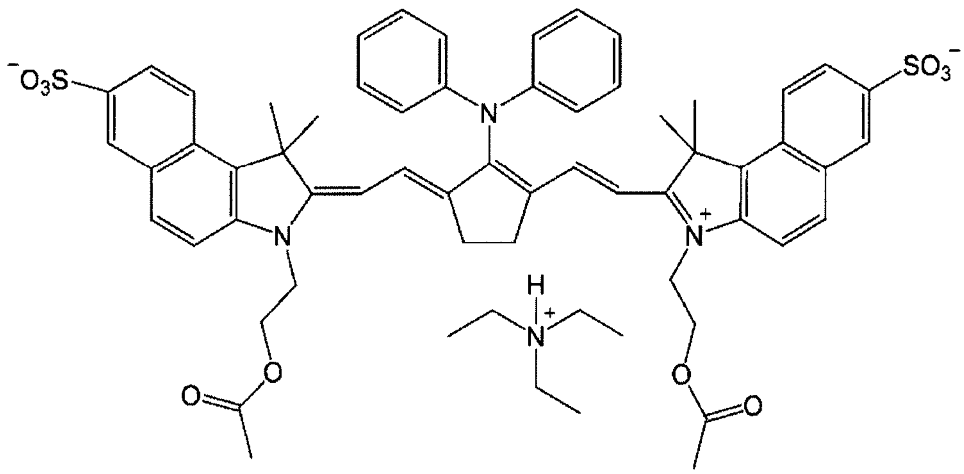

Infrared absorbing agent (2)

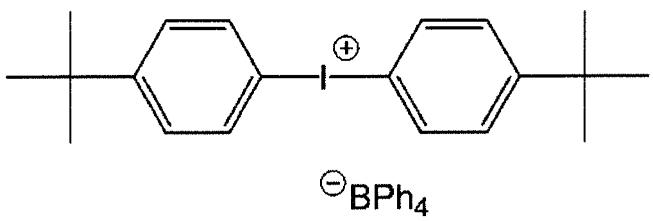

Polymerization initiator (2)

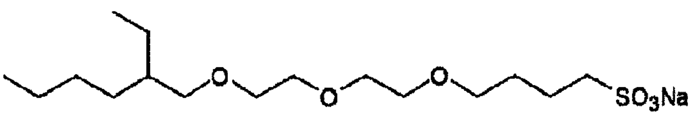

Anionic surfactant (1)

(Preparation of planographic printing plates 2 to 13 and 16 to 18)

Planographic printing plate precursors 2 to 13 and 16 to 18 were prepared in the same manner as that for the planographic printing plate precursor 1 except that the polymerizable compound 1 was changed to polymerizable compounds listed in Table 4, on the undercoat formed in the above-described manner.

(Preparation of planographic printing plate precursor 14)

The image recording layer prepared in the same manner as that for the planographic printing plate precursor 2 was bar-coated with a protective layer coating solution (1) having the following composition, dried in an oven at 120°C for 60 seconds, and a protective layer having a drying coating amount of 0.15 g/m$^2$ was formed, thereby obtaining a planographic printing plate precursor 14.

[Protective layer coating solution (1)]

- Inorganic layered compound dispersion liquid (1) (obtained in the manner described below): 1.5 parts
- Hydrophilic polymer (1) (solid content) [the following structure, Mw: 30000]: 0.55 parts

In the following structures, the numerical values of 70 and 30 on the lower right side of the parentheses in the constitutional units show the molar ratios of the constitutional units.

- Polyvinyl alcohol (CKS50, manufactured by Nippon Synthetic Chemical Industry Co., Ltd., sulfonic acid-modified, saponification degree: 99% by mole or greater, degree of polymerization: 300), 6 mass% aqueous solution: 0.10 parts
  Polyvinyl alcohol (PVA-405, manufactured by KURARAY CO., LTD., saponification degree: 81.5% by mole, degree of polymerization: 500), 6 mass% aqueous solution: 0.03 parts
- Surfactant (EMALEX 710, manufactured by Nihon Emulsion Co., Ltd.), 1 mass% aqueous solution: 0.86 parts
- Ion exchange water: 6.0 parts

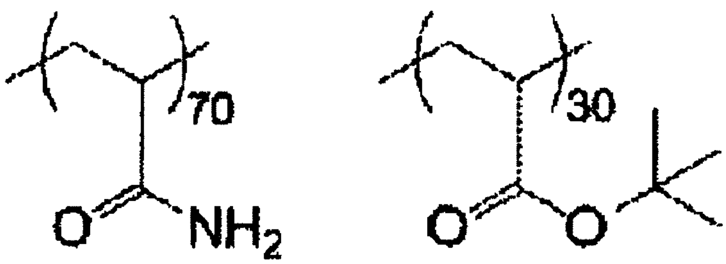

Hydrophilic polymer (1)

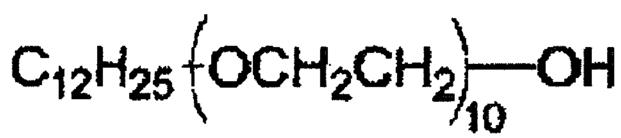

EMALEX 710

<Preparation of inorganic layered compound dispersion liquid (1)>

6.4 parts of synthetic mica Somasif ME-100 (manufactured by CO-OP CHEMICAL CO., LTD.) was added to 193.6 parts of ion exchange water and dispersed such that the volume average particle diameter (laser scattering method) was set to 3 μm using a homogenizer. The aspect ratio of the obtained dispersed particles was 100 or greater.

(Preparation of planographic printing plate precursor 15)

A planographic printing plate precursor 15 was prepared in the same manner as that for the planographic printing plate precursor 14 except that the undercoat was not provided.

<Coating step>

[Preparation of hydrophilic coating solution]

Compounds listed in Table 3 were dissolved in pure water containing 0.1% by mass of dialkyl sulfosuccinate (RAPISOL A-80, manufactured by NOF Corporation,), thereby preparing hydrophilic coating solutions 1 to 17.

[Table 3]

| Hydrophilic coating solution | Hydrophilization agent 1 (surfactant) | | Hydrophilization agent 2 (phosphoric acid compound or phosphonic acid compound) | | Hydrophilization agent 3 (water-soluble resin) | |
|---|---|---|---|---|---|---|
| | Type | Content (% by mass) | Type | Content (% by mass) | Type | Content (% by mass) |
| 1 | NEW CALL B-13 | 7.5 | Sodium dihydrogen phosphate | 1.5 | - | |
| 2 | Sodium 1-naphthalene sulfonate | 7.5 | Sodium dihydrogen phosphate | 1.5 | - | |
| 3 | PELEX NBL | 7.5 | Sodium hexamethacrylate | 1 | - | |
| 4 | Sodium 1-naphthalene sulfonate | 3.5 | Sodium dihydrogen phosphate | 0.7 | - | |
| 5 | Sodium 1-naphthalene sulfonate | 1.5 | Sodium dihydrogen phosphate | 1.5 | - | |
| 6 | Sodium 1-naphthalene sulfonate | 0.75 | - | | - | |
| 7 | Sodium 1-naphthalene sulfonate | 3.5 | - | | Dextrin | 0.7 |
| 8 | Sodium 1-naphthalene sulfonate | 1.5 | Sodium dihydrogen phosphate | 1.5 | Dextrin | 1.5 |
| 9 | Sodium polyacrylate | 1.5 | Sodium dihydrogen phosphate | 0.1 | - | |
| 10 | Sodium 1-naphthalene sulfonate | 7.5 | Polyvinylphosphonic acid | 1.5 | - | |
| 11 | - | | Sodium dihydrogen phosphate | 1.5 | - | |
| 12 | - | | Polyvinylphosphonic acid | 1.5 | - | |
| 13 | - | | Polyphosmer | 0.7 | - | |

(continued)

| Hydrophilic coating solution | Hydrophilization agent 1 (surfactant) | | Hydrophilization agent 2 (phosphoric acid compound or phosphonic acid compound) | | Hydrophilization agent 3 (water-soluble resin) | |
|---|---|---|---|---|---|---|
| | Type | Content (% by mass) | Type | Content (% by mass) | Type | Content (% by mass) |
| 14 | Poly(sodium 4-styrenesulfonate) | 3.5 | Polyphosmer | 0.7 | - | |
| 15 | - | | Polymer A | 0.7 | - | |
| 16 | Sodium 1-naphthalene sulfonate | 0.1 | Polymer A | 0.7 | - | |
| 17 | - | | Polymer A | 0.7 | - | |
| | | | Sodium dihydrogen phosphate | 0.1 | - | |

Further, the details of the compounds described under the product names listed in Table 3 are described below.

NEW CALL B-13: non-ionic surfactant, polyoxyethylene aryl ether, manufactured by Nippon Nyukazai Co., Ltd.

Sodium 1-naphthalene sulfonate: manufactured by Tokyo Chemical Industry Co., Ltd.

Poly(sodium 4-styrenesulfonate): manufactured by JUNSEI CHEMICAL CO., LTD.

Sodium dihydrogen phosphate: manufactured by Wako Pure Chemical Industries, Ltd.

Sodium hexamethacrylate: manufactured by Wako Pure Chemical Industries, Ltd.

Sodium polyacrylate: manufactured by Wako Pure Chemical Industries, Ltd.

Dextrin: manufactured by Wako Pure Chemical Industries, Ltd.

Polyvinyl phosphonic acid: vinyl phosphonic acid-acrylamide copolymer (molar ratio: 10/90), manufactured by Sigma-Aldrich Co., LLC

Polyphosmer: compound represented by Formula P1

In Formula P1, the numerical value of 100 on the lower right side of the parentheses in the constitutional units shows the molar ratios of the constitutional units.
Polymer A: compound represented by Formula P2

In Formula P2, the numerical values of 10 and 90 on the lower right side of the parentheses in the constitutional units shows the molar ratios of the constitutional units.

Further, the numerical values of the contents on the right side of the compound names show the contents (% by mass) of active components of compounds in the hydrophilic coating solution.

Further, the columns with "-" in Table 3 mean that the compounds are not contained.

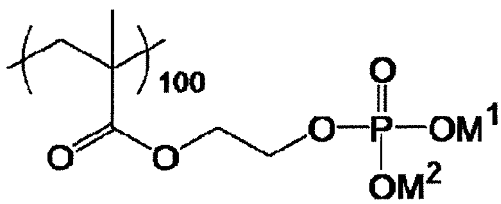

(P1)

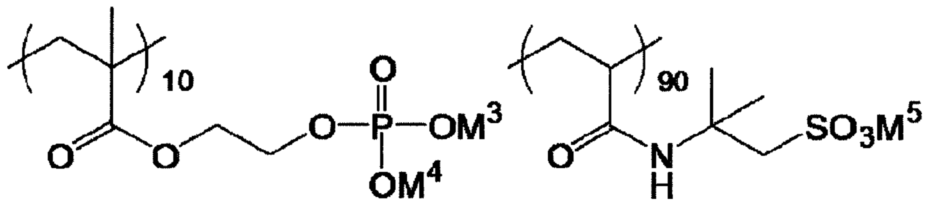

(P2)

In Formula P1, $M^1$ and $M^2$ each independently represent a hydrogen atom or a sodium atom.
In Formula P2, $M^3$, $M^4$, and $M^5$ each independently represent a hydrogen atom or a sodium atom.
Further, in Formulae P1 and P2, the numerical values on the right side of the parentheses show the content ratios (% by mole) of respective monomer units with respect to all monomer units of the polymer.

(Examples 1 to 43 and Comparative Example 1 to 5)

<Timing for application of hydrophilic coating solution>

The planographic printing plate precursors listed in Table 4 were respectively coated with the prepared hydrophilic coating solutions listed in Table 4 at the timings of the following (1) to (7).
In the examples in which "none" was written in the columns of the hydrophilic coating solution in Table 4, the application of the hydrophilic coating solution was not performed.

(1) An uncoated plate before being coated with an undercoat was coated with a hydrophilic coating solution and dried at 85°C for 30 seconds. The coating amount thereof was 0.5 g/$m^2$. Thereafter, the plate was coated with an image recording layer.
(2) After the plate was coated with the image coating layer (coated with a protective layer in a case where a protective layer was formed), the plate was coated with the hydrophilic coating solution without being dried, and then dried at 150°C for 1 minute. The coating amount of the hydrophilic coating solution was 1.7 g/$m^2$.
(3) After the plate was coated with the image recording layer, dried at 70°C for 1 minute, and coated with the hydrophilic coating solution. Thereafter, the plate was dried at 120°C for 1 minute. The coating amount of the hydrophilic coating solution was 1.7 g/$m^2$.
(4) After the plate was coated with the undercoat, the plate was coated with the hydrophilic coating solution without being dried, and then dried at 80°C for 30 seconds. The coating amount of the hydrophilic coating solution was 0.35 g/$m^2$.
(5) After the plate was coated with the undercoat, the plate was coated with the hydrophilic coating solution without being dried, and then dried at 150°C for 20 seconds. The coating amount of the hydrophilic coating solution was 0.10 g/$m^2$.
(6) After the plate was coated with the undercoat, dried at 80°C for 30 seconds, and coated with the hydrophilic coating solution. Thereafter, the plate was dried at 80°C for 30 seconds. The coating amount of the hydrophilic coating solution was 0.35 g/$m^2$.
(7) After the plate was coated with the image coating layer (coated with a protective layer in a case where a protective layer was formed), the following cutting step was performed, and the plate was coated with the hydrophilic coating solution. Thereafter, the plate was dried at room temperature for 1 hour. The coating amount of the hydrophilic coating solution was 1.1 g/$m^2$.

Further, in each of the examples and the comparative examples, the columns of the treatment timing in Table 4 show which timing of the above-described (1) to (7) the coating was performed.

<Method of applying hydrophilic coating solution>

2NL04 (manufactured by HEISHIN Ltd.) was used as a coating device.

In the examples in which the coating was performed at the coating timing of (1), the conveying speed was adjusted at a clearance of 0.3 mm and at a feed amount of 5 cc/min and then the coating was performed such that the coating amount of the solid content was set to 0.5 g/$m^2$.
In the examples or comparative examples in which the coating was performed at any of the coating timings of (2) to (6), the conveying speed was adjusted at a clearance of 0.3 mm and at a feed amount of 5 cc/min and then the coating was performed such that the coating amount of the solid content was set to 0.5 g/$m^2$.

Regions having a width of 5 mm were coated in positions from both facing ends of the support layer by 3 cm before being cut.

In the examples or comparative examples in which the coating was performed at the coating timing of (7), the conveying speed was adjusted at a clearance of 0.3 mm and at a feed amount of 5 cc/min and then the coating was performed such that the coating amount of the solid content was set to a predetermined value.

Regions having a width of 1 cm were coated in positions from both facing ends of the cut support layer.

<Cutting process>

The planographic printing plate precursor was cut to have a shape of an end portion with a desired sagging amount listed in Table 4 by adjusting a gap between an upper cutting blade and a lower cutting blade, the amount of biting, and the blade tip angle using a rotary blade as illustrated in Fig. 10. The sagging width was set to 150 $\mu$m.

In the examples or comparative examples in which the coating was performed at any of the coating timings of (1) to (6), the central position of a coating region was set to a cutting position under the above-described cutting conditions and two places of the planographic printing plate precursor were cut.

In the examples or comparative examples in which the coating was performed at the coating timing of (7), the cutting was performed under the above-described cutting conditions such that the size of the planographic printing plate precursor was set to a predetermined value.

(Evaluation of planographic printing plate)

<Evaluation of edge stain preventing performance>

The planographic printing plate precursor prepared in the above-described manner was exposed in Luxel PLATESETTER T-6000III (manufactured by Fujifilm Corporation) equipped with an infrared semiconductor laser under conditions of external surface drum rotation speed of 1,000 rpm, a laser output of 70%, and a resolution of 2,400 dpi (dots per inch, number of dots per 1 inch, 1 inch is 2.54 cm). The exposed image had a solid image and a 50% halftone dot chart.

(Evaluation of planographic printing plate)

<Evaluation of edge stain preventing performance>

The planographic printing plate precursor exposed in the above-described manner was mounted on an offset rotary printing press and then printing was performed at a speed of 100,000 sheets/hour using SOIBI KKST-S (red) (manufactured by Dai Nippon Printing Co., Ltd.) as printing ink for newspaper and TOYO ALKY (manufactured by TOYO INK CO., LTD.) as dampening water. Thereafter, the 1000-th printed matter was sampled, and linear stain on the edge portion was evaluated based on the following standard. The results are listed in Table 4.

5: Stain was not observed at all
4: An intermediate level between 5 and 3
3: An acceptable level, a slight amount of stain was observed
2: An intermediate level between 3 and 1
1: An unacceptable level, stain was clearly observed

<Evaluation of image formation on edge portion>

The planographic printing plate precursor prepared in the above-described manner was exposed in Luxel PLATESETTER T-6000III (manufactured by Fujifilm Corporation) equipped with an infrared semiconductor laser under conditions of external surface drum rotation speed of 1,000 rpm, a laser output of 70%, and a resolution of 2,400 dpi. The chart image including the solid image, the 50% halftone dot image, and the non-image portion was exposed so that the exposed image was formed over the end portion.

Further, the edge portion indicates a region in the vicinity of the end portion, which was coated with the hydrophilic coating solution.

The planographic printing plate precursor exposed in the above-described manner was mounted on an offset rotary printing press and then printing was performed at a speed of 100,000 sheets/hour using SOIBI KKST-S (red) (manufactured by Dai Nippon Printing Co., Ltd.) as printing ink for newspaper and TOYO ALKY (manufactured by TOYO INK CO., LTD.) as dampening water. Thereafter, the 1000-th printed matter was sampled, and linear stain on the edge

portion was evaluated based on the following standard. The results are listed in Table 4.

3: The image was printed from the end portion to a portion inside the end portion by 1 mm in the edge portion.
2: The image was printed from the end portion to a portion inside the end portion by 2 mm in the edge portion.
1: The image was printed from the end portion to a portion inside the end portion by 3 mm in the edge portion.

<Image printing durability of edge portion>

In the above-described evaluation, the printing was continued after 1000 sheets were printed, and the 5000-th printed matter, the 10000-th printed matter, the 20000-th printed matter, and the 30000-th printed matters were sampled and the printing durability of an image was evaluated based on the following standard. The results are listed in Table 4.

5: The images in portions closest to the edge portions were printed without change from 1000 parts to 30000 parts.
4: The images in portions closest to the edge portions were printed without change from 1000 parts to 20000 parts.
3: The images in portions closest to the edge portions were printed without change from 1000 parts to 10000 parts.
2: The images in portions closest to the edge portions were printed without change from 1000 parts to 5000 parts.
1: The images in portions closest to the edge portions were faded from 1000 parts to 5000 parts.

<Edge stain preventing performance with forced aging>

The planographic printing plate precursor prepared in the above-described manner was stored at a temperature of 60° and at a humidity of 70% for 2 days, and then evaluation was performed in the same manner as the evaluation of the edge stain preventing performance. The results are listed in Table 4.

<Peeling of film of edge portion with forced aging under load, peeling properties of interleaving paper>

Interleaving paper was laminated on the planographic printing plate precursor prepared in the above-described manner one by one, and a load of 15 N was applied to the precursor in a state in which 200 sheets of interleaving paper were laminated thereon. Next, after the precursor was stored at a temperature of 40° and at a humidity of 70% for 2 days, the interleaving paper was peeled. The evaluation was performed based on the following standard. The results are listed in Table 4.

When the present evaluation of this item was excellent, this indicates that the bleeding or transferring of a substance over time was suppressed.

5: The interleaving paper was peeled off and substances were not transferred to the interleaving paper.
4: The interleaving paper was peeled off and there was almost no substance transferred to the interleaving paper.
3: An acceptable level, the interleaving paper was peeled off, the portion on the plate to which the hydrophilic coating solution was applied was normal, and the components from the image recording layer were slightly attached to the interleaving paper.
2: The interleaving paper was peeled off, but fine film omission was observed from the plate and the components from the image recording layer were attached to the interleaving paper.
1: The interleaving paper adhered to the portion to which the hydrophilic coating solution was applied, peeling of the image recording layer was observed from the portion on the plate to which the hydrophilic coating solution was applied, and the components from the image recording layer were attached to the interleaving paper.

[Table 4]

(continued)

| | Planographic printing plate precursor | Polymer compound | Hydrophilic coating solution | Timing for treatment | Sagging amount μm | Edge stain preventing performance | Image formation on edge portion | Image printing durability of edge portion | Edge stain preventing performance with forced aging | Peeling of film of edge portion with forced aging under load, peeling properties of interleaving paper |
|---|---|---|---|---|---|---|---|---|---|---|

(continued)

| | | Planographic printing plate precursor | Polymer compound | Hydrophilic coating solution | Timing for treatment | Sagging amount μm | Edge stain preventing performance | Image formation on edge portion | Image printing durability of edge portion | Edge stain preventing performance with forced aging | Peeling of film of edge portion with forced aging under load, peeling properties of interleaving paper |
|---|---|---|---|---|---|---|---|---|---|---|---|
| Example | 1 | 1 | 1 | 8 | (2) | 50 | 5 | 3 | 3 | 5 | 3 |
| | | | | | | | | | | | |
| | | Planographic printing plate precursor | Polymer compound | Hydrophilic coating solution | Timing for treatment | Sagging amount μm | Edge stain preventing performance | Image formation on edge portion | Image printing durability of edge portion | Edge stain preventing performance with forced aging | Peeling of film of edge portion with forced aging under load, peeling properties of interleaving paper |
| | 2 | 2 | 2 | 8 | (2) | 50 | 5 | 3 | 5 | 5 | 5 |
| | | | | | | | | | | | |
| | | Planographic printing plate precursor | Polymer compound | Hydrophilic coating solution | Timing for treatment | Sagging amount μm | Edge stain preventing performance | Image formation on edge portion | Image printing durability of edge portion | Edge stain preventing performance with forced aging | Peeling of film of edge portion with forced aging under load, peeling properties of interleaving paper |
| | 3 | 3 | 3 | 8 | (2) | 50 | 5 | 3 | 4 | 5 | 4 |
| | 4 | 4 | 4 | 8 | (2) | 50 | 5 | 3 | 5 | 4 | 5 |
| | 5 | 5 | 5 | 8 | (2) | 50 | 5 | 3 | 5 | 3 | 5 |
| | 6 | 6 | 6 | 8 | (2) | 50 | 5 | 3 | 5 | 5 | 5 |
| | 7 | 7 | 7 | 8 | (2) | 50 | 5 | 3 | 3 | 5 | 5 |
| | 8 | 8 | 8 | 8 | (2) | 50 | 3 | 3 | 5 | 2 | 5 |
| | 9 | 12 | UN-9000PEP | 8 | (2) | 50 | 5 | 3 | 3 | 3 | 3 |
| | 10 | 2 | 2 | 1 | (2) | 50 | 5 | 3 | 3 | 4 | 3 |
| | 11 | 2 | 2 | 2 | (2) | 50 | 5 | 3 | 3 | 4 | 3 |
| | 12 | 2 | 2 | 3 | (2) | 50 | 5 | 3 | 3 | 4 | 3 |
| | 13 | 2 | 2 | 4 | (2) | 50 | 3 | 3 | 4 | 3 | 4 |
| | 14 | 2 | 2 | 5 | (2) | 50 | 5 | 3 | 5 | 4 | 4 |
| | 15 | 2 | 2 | 6 | (2) | 50 | 3 | 3 | 5 | 3 | 4 |

(continued)

| | | Planographic printing plate precursor | Polymer compound | Hydrophilic coating solution | Timing for treatment | Sagging amount µm | Edge stain preventing performance | Image formation on edge portion | Image printing durability of edge portion | Edge stain preventing performance with forced aging | Peeling of film of edge portion with forced aging under load, peeling properties of interleaving paper |
|---|---|---|---|---|---|---|---|---|---|---|---|
| Comparative example | 1 | 9 | 9 | 8 | (2) | 50 | 2 | 3 | 5 | 1 | 5 |
| | | | | | | | | | | | |
| | | Planographic printing plate precursor | Polymer compound | Hydrophilic coating solution | Timing for treatment | Sagging amount µm | Edge stain preventing performance | Image formation on edge portion | Image printing durability of edge portion | Edge stain preventing performance with forced aging | Peeling of film of edge portion with forced aging under load, peeling properties of interleaving paper |
| | 2 | 10 | 10 | 8 | (2) | 50 | 5 | 3 | 2 | 5 | 2 |
| | 3 | 11 | 11 | 8 | (2) | 50 | 5 | 1 | 1 | 5 | 1 |
| | 4 | 13 | A-9300 | 8 | (2) | 50 | 5 | 1 | 1 | 3 | 1 |
| | 5 | 2 | 2 | None | - | 50 | 1 | 3 | 5 | 1 | 5 |

In Example 36, burr (adhesions of the support materials generated during the cutting or the materials contained in a layer forming the planographic printing plate) occurred in the edge portion at the time of cutting and thus contamination was observed from the printed matter corresponding to the portion with burr, but this was not practically problematic.

Further, the details of the compounds described under the product names of Table 4 are as follows.

UV-9000PEP: polycarbonate urethane-based acrylate oligomer, manufactured by Nagami Chemical Industrial Co., Ltd. (weight average molecular weight of 5000, bifunctional acrylate oligomer)

A-9300: tris(acryloyloxyethyl)isocyanurate, NK ESTER A-9300, manufactured by Shin Nakamura Chemical Co., Ltd.) Explanation of References

1: support
10: cutting blade
10a: upper cutting blade
10b: upper cutting blade
11: rotary shaft
20: cutting blade
20a: lower cutting blade
20b: lower cutting blade
21: rotary shaft

30: support
$A_1$ to $A_{28}$: width of coating region after cutting
X: sagging amount
Y: sagging width

## Claims

**1.** A planographic printing plate precursor comprising a support layer and an image recording layer including an infrared absorbing agent, a tetraphenyl borate salt as a radical polymerisation initiator, and a radical polymerizable compound which includes a urethane bond and two or more ethylenically unsaturated groups and has a weight-average molecular weight of 3000 to 10000;

the planographic printing plate precursor having any one of the following layer arrangements i to iv:

i: an arrangement in which the support layer and the image recording layer are provided in this order
ii: an arrangement in which the support layer, an undercoat, and the image recording layer are provided in this order
iii: an arrangement in which the support layer, the image recording layer, and a protective layer are provided in this order
iv: an arrangement in which the support layer, the undercoat, the image recording layer, and the protective layer are provided in this order;

the planographic printing plate precursor further comprising a hydrophilization agent layer containing a hydrophilization agent provided in a region between the layers in the layer arrangements i to iv, on a side opposite to a support layer with respect to the image recording layer in the layer arrangement i or ii, or on a side opposite to the support layer with respect to a protective layer in the layer arrangement iii or iv, from the end portion of the planographic printing plate precursor to a portion inside the end portion by 1 cm.

**2.** The planographic printing plate precursor according to claim 1,
wherein the layer arrangement including the hydrophilization agent layer is layer arrangement described in any one of the following 1 to 5.

1: an arrangement in which the support layer, the hydrophilization agent layer, the undercoat, and the image recording layer are provided in this order
2: an arrangement in which the support layer, the hydrophilization agent layer, the undercoat, the image recording layer, and the protective layer are provided in this order
3: an arrangement in which the support layer, the undercoat, the image recording layer, and the hydrophilization agent layer are provided in this order
4: an arrangement in which the support layer, the undercoat, the image recording layer, the hydrophilization agent layer, and the protective layer are provided in this order 5 an arrangement in which the support layer, the undercoat, the image recording layer, the protective layer, and the hydrophilization agent layer are provided in this order

**3.** The planographic printing plate precursor according to claim 1 or 2,
wherein the radical polymerizable compound contains an alkyleneoxy group in a molecule.

**4.** The planographic printing plate precursor according to any one of claims 1 to 3,
wherein the radical polymerizable compound is a condensate of a triisocyanate compound, at least one compound a containing two hydroxy groups and one or more (meth)acryloyl groups, and a compound b containing one hydroxy group, one or more (meth)acryloyl groups, and one or more poly(alkyleneoxy) groups in a molecule or a condensate of a triisocyanate compound, a compound c which contains one hydroxy group and two or more (meth)acryloyl groups in a molecule and does not contain a poly(alkyleneoxy)group in a molecule, and a compound d which contains one hydroxy group, one (meth)acryloyl group, and one or more alkyleneoxy groups in a molecule and does not contain a poly(alkyleneoxy) group in a molecule.

**5.** The planographic printing plate precursor according to any one of claims 1 to 4,
wherein the radical polymerizable compound is a condensate of a triisocyanate compound, a compound c which

contains a hydroxy group and two or more (meth)acryloyl groups in a molecule and does not contain a poly(alkyleneoxy) group in a molecule, and a compound d which contains one hydroxy group, one (meth)acryloyl group, and one or more alkyleneoxy groups in a molecule and does not contain a poly(alkyleneoxy) group in a molecule.

**6.** The planographic printing plate precursor according to any one of claims 1 to 5, wherein the hydrophilization agent is a phosphoric acid compound and/or a phosphonic acid compound.

**7.** The planographic printing plate precursor according to claim 6, wherein the phosphoric acid compound and/or the phosphonic acid compound is a polymer compound.

**8.** The planographic printing plate precursor according to claim 6 or 7, further comprising: an anionic or non-ionic surfactant as the hydrophilization agent.

**9.** The planographic printing plate precursor according to claim 8, wherein the anionic or non-anionic surfactant is a polymer compound.

**10.** The planographic printing plate precursor according to any one of claims 1 to 9, wherein the end portion of the planographic printing plate precursor has a sagging shape in which a sagging amount X is in a range of 20 $\mu$m to 150 $\mu$m.

**11.** The planographic printing plate precursor according to any one of claims 1 to 10, wherein the hydrophilization agent layer is provided between any of the layers in the layer arrangements i to iv.

**12.** The planographic printing plate precursor according to any one of claims 1 to 11, wherein the hydrophilization agent layer is provided on a side of the support layer with respect to the undercoat or on a side opposite to the support layer with respect to the image recording layer.

**13.** A plate-making method for a planographic printing plate comprising:

an exposing step of image-exposing the planographic printing plate precursor according to any one of claims 1 to 12; and
a processing step of removing an unexposed portion of the planographic printing plate precursor.

**14.** The plate-making method for a planographic printing plate according to claim 13, wherein the processing step is performed by on-press development.

**15.** A printing method comprising: printing a planographic printing plate obtained by the plate-making method according to claim 13 or 14 using printing paper having a larger width than that of the planographic printing plate.

**Patentansprüche**

**1.** Flachdruckplattenvorläufer, umfassend eine Trägerschicht und eine Bildaufzeichnungsschicht, die einen Infrarotabsorber, ein Tetraphenylboratsalz als einen radikalischen Polymerisationsinitiator und eine radikalisch polymerisierbare Verbindung umfasst, die eine Urethanbindung und zwei oder mehr ethylenisch ungesättigte Gruppen enthält und ein gewichtsgemitteltes Molekulargewicht von 3.000 bis 10.000 aufweist;
worin der Flachdruckplattenvorläufer irgendeine der folgenden Schichtanordnungen i bis iv aufweist:

i: eine Anordnung, worin die Trägerschicht und die Bildaufzeichnungsschicht in dieser Reihenfolge vorgesehen sind,
ii: eine Anordnung, worin die Trägerschicht, eine Grundierung und die Bildaufzeichnungsschicht in dieser Reihenfolge vorgesehen sind,
iii: eine Anordnung, worin die Trägerschicht, die Bildaufzeichnungsschicht und eine Schutzschicht in dieser Reihenfolge vorgesehen sind,
iv: eine Anordnung, in der die Trägerschicht, die Grundierung, die Bildaufzeichnungsschicht und die Schutzschicht in dieser Reihenfolge angeordnet sind;

worin der Flachdruckplattenvorläufer ferner eine Hydrophilisierungsmittelschicht umfasst, die ein Hydrophilisierungsmittel enthält, welche in einem Bereich zwischen den Schichten in den Schichtanordnungen i bis iv auf einer Seite gegenüberliegend zu einer Trägerschicht in Bezug auf die Bildaufzeichnungsschicht in der Schichtanordnung i oder ii, oder auf einer Seite gegenüberliegend zu der Trägerschicht in Bezug auf eine Schutzschicht in der Schichtanordnung iii oder iv, vom Endbereich des Flachdruckplattenvorläufers bis zu einem Bereich innerhalb des Endbereichs um 1 cm, vorgesehen ist.

**2.** Flachdruckplattenvorläufer gemäß Anspruch 1, worin die Schichtanordnung, die die Hydrophilisierungsmittelschicht umfasst, eine in irgendeinem der folgenden 1 bis 5 beschriebene Schichtanordnung ist:

1: eine Anordnung, worin die Trägerschicht, die Hydrophilisierungsmittelschicht, die Grundierung und die Bildaufzeichnungsschicht in dieser Reihenfolge vorgesehen sind,
2: eine Anordnung, worin die Trägerschicht, die Hydrophilisierungsmittelschicht, die Grundierung, die Bildaufzeichnungsschicht und die Schutzschicht in dieser Reihenfolge vorgesehen sind,
3: eine Anordnung, worin die Trägerschicht, die Grundierung, die Bildaufzeichnungsschicht und die Hydrophilisierungsmittelschicht in dieser Reihenfolge vorgesehen sind,
4: eine Anordnung, worin die Trägerschicht, die Grundierung, die Bildaufzeichnungsschicht, die Hydrophilisierungsmittelschicht und die Schutzschicht in dieser Reihenfolge vorgesehen sind,
5: eine Anordnung, worin die Trägerschicht, die Grundierung, die Bildaufzeichnungsschicht, die Schutzschicht und die Hydrophilisierungsmittelschicht in dieser Reihenfolge vorgesehen sind.

**3.** Flachdruckplattenvorläufer gemäß Anspruch 1 oder 2, worin die radikalisch polymerisierbare Verbindung eine Alkylenoxygruppe in einem Molekül aufweist.

**4.** Flachdruckplattenvorläufer gemäß irgendeinem der Ansprüche 1 bis 3, worin die radikalisch polymerisierbare Verbindung ein Kondensat einer Triisocyanatverbindung, zumindest einer Verbindung a, die zwei Hydroxygruppen und ein oder mehr (Meth)acryloylgruppen enthält, und einer Verbindung b, die eine Hydroxygruppe, eine oder mehr (Meth)acryloylgruppen und eine oder mehr Poly(alkylenoxy)gruppen in einem Molekül aufweist, oder ein Kondensat einer Triisocyanatverbindung, einer Verbindung c, die eine Hydroxygruppe und zwei oder mehr (Meth)acryloylgruppen in einem Molekül aufweist und keine Poly(alkylenoxy)gruppe in einem Molekül aufweist, und einer Verbindung d, die eine Hydroxygruppe, eine (Meth)acryloxygruppe und eine oder mehr Alkylenoxygruppen in einem Molekül aufweist und keine Poly(alkylenoxy)gruppe in einem Molekül aufweist, ist.

**5.** Flachdruckplattenvorläufer gemäß irgendeinem der Ansprüche 1 bis 4, worin die radikalisch polymerisierbare Verbindung ein Kondensat einer Triisocyanatverbindung, einer Verbindung c, die eine Hydroxygruppe und zwei oder mehr (Meth)acryloylgruppen in einem Molekül aufweist und keine Poly(alkylenoxy)gruppe in einem Molekül aufweist, und einer Verbindung d, die eine Hydroxygruppe, eine (Meth)acryloylgruppe und eine oder mehr Alkylenoxygruppen in einem Molekül aufweist und keine Poly(alkylenoxy)gruppe in einem Molekül aufweist, ist.

**6.** Flachdruckplattenvorläufer gemäß irgendeinem der Ansprüche 1 bis 5, worin das Hydrophilisierungsmittel eine Phosphorsäureverbindung und/oder eine Phosphonsäureverbindung ist.

**7.** Flachdruckplattenvorläufer gemäß Anspruch 6, worin die Phosphorsäureverbindung und/oder die Phosphonsäureverbindung eine Polymerverbindung ist.

**8.** Flachdruckplattenvorläufer gemäß Anspruch 6 oder 7, ferner umfassend: ein anionisches oder nicht-ionisches Tensid als Hydrophilisierungsmittel.

**9.** Flachdruckplattenvorläufer gemäß Anspruch 8, worin das anionische oder nicht-ionische Tensid eine Polymerverbindung ist.

**10.** Flachdruckplattenvorläufer gemäß irgendeinem der Ansprüche 1 bis 9, worin der Endbereich des Flachdruckplattenvorläufers eine Senkungsform aufweist, worin die Senkungsmenge X im Bereich von 20 $\mu$m bis 150 $\mu$m liegt.

**11.** Flachdruckplattenvorläufer gemäß irgendeinem der Ansprüche 1 bis 10, worin die Hydrophilisierungsmittelschicht zwischen irgendeiner der Schichten in den Schichtanordnungen i bis iv angeordnet ist.

**12.** Flachdruckplattenvorläufer gemäß irgendeinem der Ansprüche 1 bis 11, worin die Hydrophilisierungsmittelschicht

auf einer Seite der Trägerschicht in Bezug auf die Grundierung oder auf einer Seite gegenüberliegend zu der Trägerschicht im Hinblick auf die Bildaufzeichnungsschicht vorgesehen ist.

**13.** Plattenherstellungsverfahre für eine Flachdruckplatte, umfassend:

einen Belichtungsschritt zur bildweisen Belichtung des Flachdruckplattenvorläufers gemäß irgendeinem der Ansprüche 1 bis 12; und
einen Verarbeitungsschritt, in dem ein unbelichteter Bereich des Flachdruckplattenvorläufers entfernt wird.

**14.** Plattenherstellungsverfahren für eine Flachdruckplatte gemäß Anspruch 13, worin der Verarbeitungsschritt durch Entwicklung auf der Presse durchgeführt wird.

**15.** Druckverfahren, umfassend:
Drucken mit einer Flachdruckplatte, erhalten durch das Plattenherstellungsverfahren gemäß Anspruch 13 oder 14, unter Verwendung von Druckpapier mit einer größeren Bereite als diejenige der Flachdruckplatte.

**Revendications**

**1.** Précurseur de plaque d'impression planographique comprenant une couche de support et une couche d'enregistrement d'image comportant un agent absorbant les infrarouges, un sel de borate de tétraphényle comme initiateur de polymérisation radicalaire et un composé radicalaire polymérisable qui comporte une liaison uréthane et deux groupements éthyléniquement insaturés ou plus et présente un poids moléculaire moyen en poids de 3 000 à 10 000 ;
le précurseur de plaque d'impression planographique ayant l'un quelconque des agencements de couches i à iv suivants :

i : un agencement dans lequel la couche de support et la couche d'enregistrement d'image sont disposées dans cet ordre,
ii : un agencement dans lequel la couche de support, une sous-couche et la couche d'enregistrement d'image sont disposées dans cet ordre,
iii : un agencement dans lequel la couche de support, la couche d'enregistrement d'image et une couche protectrice sont disposées dans cet ordre,
iv : un agencement dans lequel la couche de support, la sous-couche, la couche d'enregistrement d'image et la couche protectrice sont disposées dans cet ordre ;

le précurseur de plaque d'impression planographique comprenant en outre une couche d'agent d'hydrophilisation contenant un agent d'hydrophilisation disposée dans une région entre les couches dans les agencements de couche i à iv, sur un côté opposé à une couche de support par rapport à la couche d'enregistrement d'image dans l'agencement de couches i ou ii ou sur un côté opposé à la couche de support par rapport à une couche protectrice dans l'agencement de couches iii ou iv, de la partie d'extrémité du précurseur de plaque d'impression planographique à une partie à l'intérieur de la partie d'extrémité de 1 cm.

**2.** Précurseur de plaque d'impression planographique selon la revendication 1,
dans lequel l'agencement de couches comportant la couche d'agent d'hydrophilisation est un agencement de couches décrit dans l'un quelconque des points 1 à 5 suivants :

1 : un agencement dans lequel la couche de support, la couche d'agent d'hydrophilisation, la sous-couche et la couche d'enregistrement d'image sont disposées dans cet ordre,
2 : un agencement dans lequel la couche de support, la couche d'agent d'hydrophilisation, la sous-couche, la couche d'enregistrement d'image et la couche protectrice sont disposées dans cet ordre,
3 : un agencement dans lequel la couche de support, la sous-couche, la couche d'enregistrement d'image et la couche d'agent d'hydrophilisation sont disposées dans cet ordre,
4 : un agencement dans lequel la couche de support, la sous-couche, la couche d'enregistrement d'image, la couche d'agent d'hydrophilisation et la couche protectrice sont disposées dans cet ordre, et
5 : un agencement dans lequel la couche de support, la sous-couche, la couche d'enregistrement d'image, la couche protectrice et la couche d'agent d'hydrophilisation sont disposées dans cet ordre.

**3.** Précurseur de plaque d'impression planographique selon la revendication 1 ou 2,

dans lequel le composé radicalaire polymérisable contient un groupement alkylèneoxy dans une molécule.

**4.** Précurseur de plaque d'impression planographique selon l'une quelconque des revendications 1 à 3,
dans lequel le composé radicalaire polymérisable est un condensat d'un composé de triisocyanate, d'au moins un composé a contenant deux groupements hydroxy et un ou plusieurs groupements (méth)acryloyle et d'un composé b contenant un groupement hydroxy, un ou plusieurs groupements (méth)acryloyle et un ou plusieurs groupements poly(alkylèneoxy) dans une molécule ou un condensat d'un composé de triisocyanate, d'un composé c qui contient un groupement hydroxy et deux groupements (méth)acryloyle ou plus dans une molécule et ne contient pas un groupement poly(alkylèneoxy) dans une molécule et d'un composé d qui contient un groupement hydroxy, un groupement (méth)acryloyle et un ou plusieurs groupements alkylèneoxy dans une molécule et ne contient pas un groupement poly(alkylèneoxy) dans une molécule.

**5.** Précurseur de plaque d'impression planographique selon l'une quelconque des revendications 1 à 4,
dans lequel le composé radicalaire polymérisable est un condensé d'un composé de triisocyanate, d'un composé c qui contient un groupement hydroxy et deux groupements (méth)acryloyle ou plus dans une molécule et ne contient pas un groupement poly(alkylèneoxy) dans une molécule et d'un composé d qui contient un groupement hydroxy, un groupement (méth)acryloyle et un ou plusieurs groupements alkylèneoxy et ne contient pas un groupement poly(alkylèneoxy) dans une molécule.

**6.** Précurseur de plaque d'impression planographique selon l'une quelconque des revendications 1 à 5,
dans lequel l'agent d'hydrophilisation est un composé d'acide phosphorique et/ou un composé d'acide phosphonique.

**7.** Précurseur de plaque d'impression planographique selon la revendication 6,
dans lequel le composé d'acide phosphorique et/ou le composé d'acide phosphonique est/sont un/des composé(s) polymère(s).

**8.** Précurseur de plaque d'impression planographique selon la revendication 6 ou 7, comprenant en outre :
un agent tensioactif anionique ou non ionique comme agent d'hydrophilisation.

**9.** Précurseur de plaque d'impression planographique selon la revendication 8,
dans lequel l'agent tensioactif anionique ou non ionique est un composé polymère.

**10.** Précurseur de plaque d'impression planographique selon l'une quelconque des revendications 1 à 9,
dans lequel la partie d'extrémité du précurseur de plaque d'impression planographique a une forme infléchie dans laquelle une quantité de fléchissement X se situe dans une plage de 20 μm à 150 μm.

**11.** Précurseur de plaque d'impression planographique selon l'une quelconque des revendications 1 à 10,
dans lequel la couche d'agent d'hydrophilisation est disposée entre l'une quelconque des couches de l'agencement de couches i à iv.

**12.** Précurseur de plaque d'impression planographique selon l'une quelconque des revendications 1 à 11,
dans lequel la couche d'agent d'hydrophilisation est disposée sur un côté de la couche de support par rapport à la sous-couche ou sur un côté opposé à la couche de support par rapport à la couche d'enregistrement d'image.

**13.** Procédé de production d'une plaque d'impression planographique comprenant :

une étape d'exposition consistant à exposer selon une image le précurseur de plaque d'impression planographique selon l'une quelconque des revendications 1 à 12 ; et
une étape de traitement consistant à retirer une partie non exposée du précurseur de plaque d'impression planographique.

**14.** Procédé de production d'une plaque d'impression planographique selon la revendication 13,
dans lequel l'étape de traitement est effectuée par développement sur presse.

**15.** Procédé d'impression comprenant :
l'impression d'une plaque d'impression planographique obtenue par le procédé de production de plaque selon la revendication 13 ou 14 en utilisant un papier d'impression de largeur plus grande que celle de la plaque d'impression

planographique.

FIG. 1

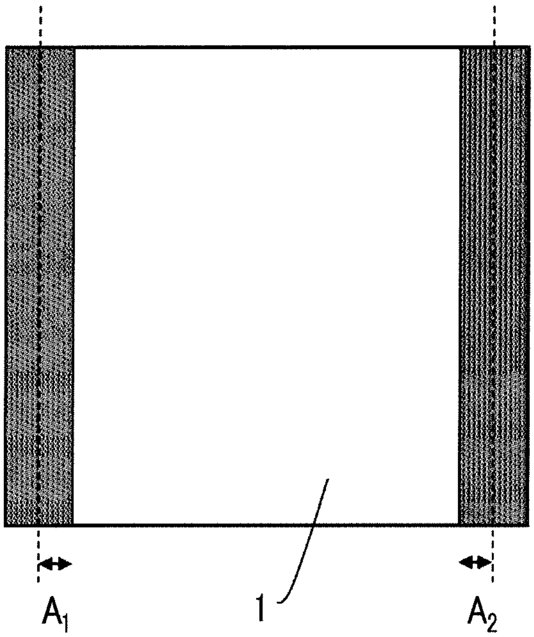


FIG. 2

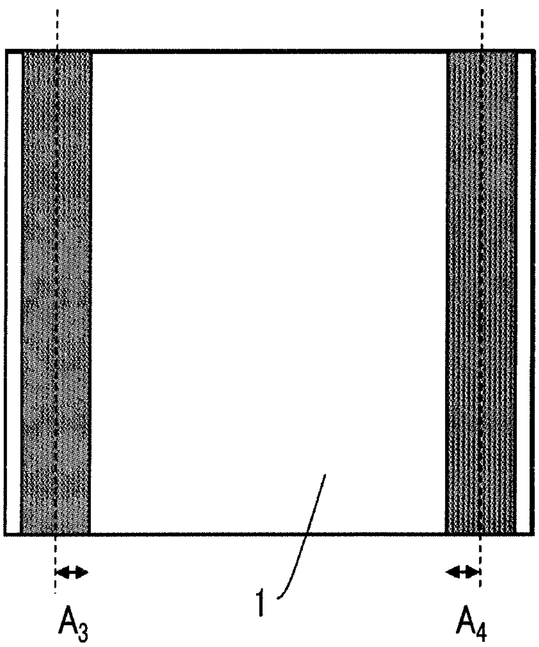

FIG. 3

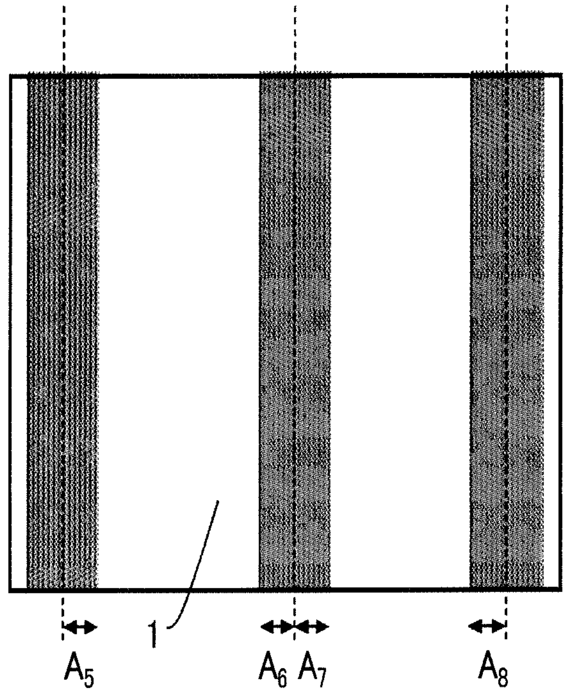


FIG. 4

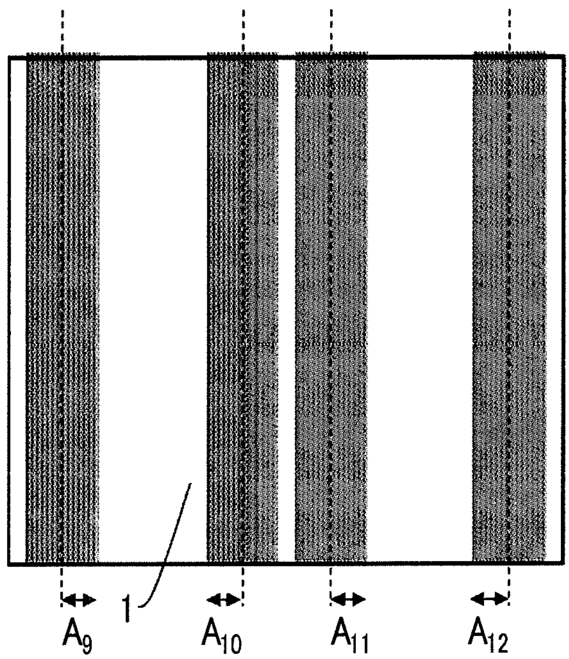

FIG. 5

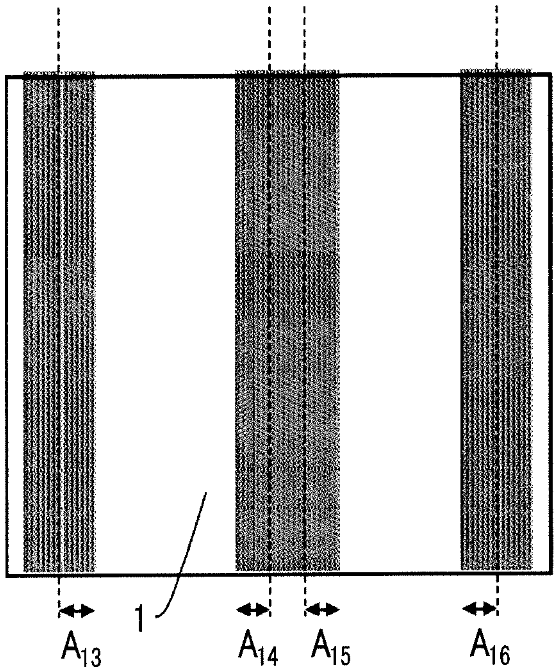


FIG. 6

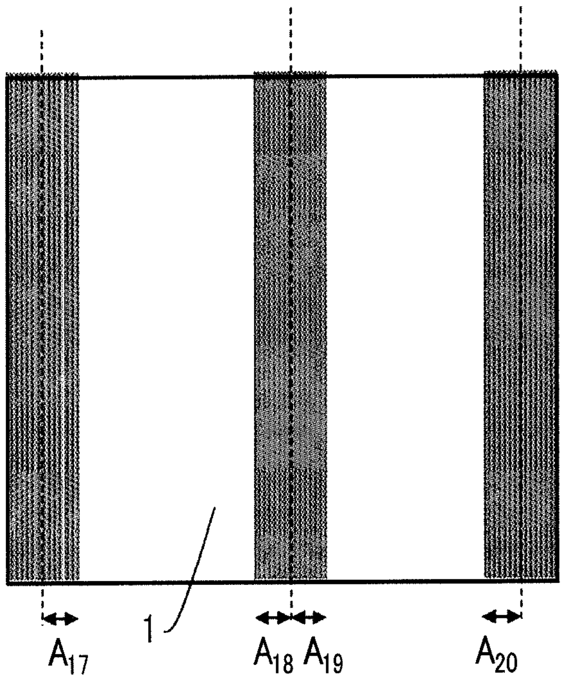

FIG. 7

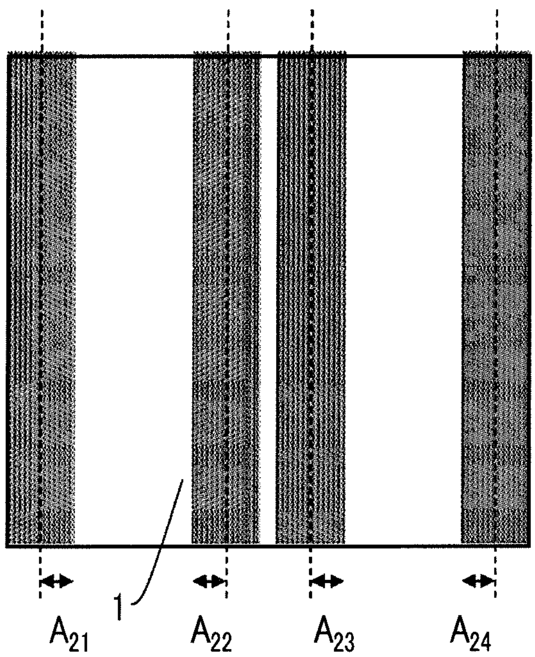


FIG. 8

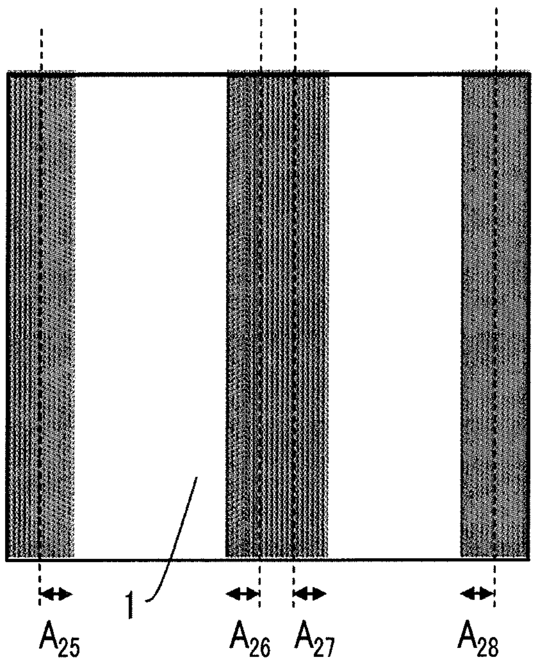

FIG. 9

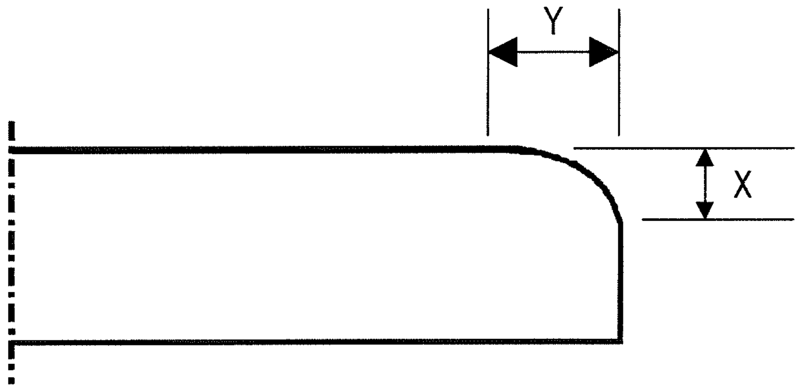


FIG. 10

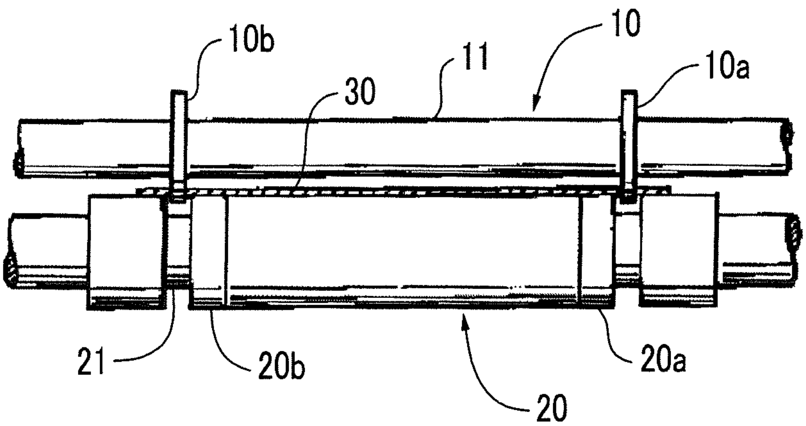

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 2011177983 A
- JP 2009522609 A
- JP 2001253181 A
- JP 2001322365 A
- US 2714066 A
- US 3181461 A
- US 3280734 A
- US 3902734 A
- US 3276868 A
- US 4153461 A
- US 4689272 A
- JP 5045885 A
- JP H0545885 A
- JP 6035174 A
- JP H0635174 A
- JP 10282679 A
- JP H10282679 A
- JP 2304441 A
- JP H02304441 A
- JP 2005238816 A
- JP 2005125749 A
- JP 2006239867 A
- JP 2006215263 A
- JP 2006188038 A
- JP 2001133969 A
- JP 2002023360 A
- JP 2002040638 A
- JP 2002278057 A
- JP 2008195018 A
- JP 2007090850 A
- JP 5005005 A
- JP H055005 A
- JP 2001222101 A
- GE 1101394
- JP 2006508380 A
- JP 2002287344 A
- JP 2008256850 A
- JP 2001342222 A
- JP 9179296 A
- JP H09179296 A
- JP 9179297 A
- JP H09179297 A
- JP 9179298 A
- JP H09179298 A
- JP 2004294935 A
- JP 2006243493 A
- JP 2002275129 A
- JP 2003064130 A
- JP 2003280187 A
- JP 10333321 A
- JP H10333321 A
- JP 2007276454 A
- JP 2009154525 A
- JP 2006297907 A
- JP 2007050660 A
- JP 2008284858 A
- JP 2009090645 A
- JP 2009208458 A
- JP 2008284817 A
- JP 2006091479 A
- US 20080311520 A
- US 3458311 A
- JP 55049729 B
- JP S5549729 B
- JP 2005250216 A
- JP 2006259137 A
- JP 2005119273 A
- JP 2013057747 A
- JP 2012194535 A
- JP 2011221494 A
- JP 8058257 A
- JP H0858257 A
- JP 9211843 A
- JP H09211843 A
- JP 10100556 A
- JP H10100556 A
- JP 11052579 A
- JP H1152579 A
- JP 2007538279 A

### Non-patent literature cited in the description

- Dye Handbook. 1970
- Houben-Weyl, Methoden der organischen Chemie (method in organic chemistry). 1963, vol. 14/2, 69